# EUROPEAN PATENT APPLICATION

(11) **EP 2 006 824 A2**
(43) Date of publication of application: **24.12.2008**
(21) Application number: 07741359.9
(22) Date of filing: 10.04.2007
(51) Int. Cl.: G09F 9/30, H01L 21/336, H01L 27/32, H01L 29/786, H01L 51/50, H05B 33/14

(54) **ELECTRO-OPTIC DEVICE, AND TFT SUBSTRATE FOR CURRENT CONTROL AND METHOD FOR MANUFACTURING THE SAME**

(30) Priority: 13.04.2006 JP 2006110543
(71) Applicant: Idemitsu Kosan Co., Ltd., Chiyoda-ku Tokyo 100-8321 (JP)
(72) Inventor: INOUE, Kazuyoshi, Sodegaura-shi, Chiba 299-0293 (JP); YANO, Koki, Sodegaura-shi, Chiba 299-0293 (JP); TANAKA, Nobuo, Sodegaura-shi, Chiba 299-0293 (JP)
(74) Representative: Gille, Christian
(86) International application number: PCT/JP2007/057923
(87) International publication number: WO 2007/119727

(57) **Abstract**

To provide an electro-optic apparatus which can directly control alternating current, output significantly high-frequency alternating current, stably output a large amount of power, and reduce manufacturing cost, as well as a TFT substrate for current control and the method for producing the same.

A dispersion-type inorganic EL display apparatus 1c as an electro-optic apparatus is provided with a data line-driving circuit 11, a scanning line-driving circuit 12, a power supply line-controlling circuit 13a, a current-measuring circuit 15 and a TFT substrate 100c.

## Description

### TECHNICAL FIELD

The invention relates to an electro-optic apparatus, a TFT substrate for current control and a method for producing the same. In particular, according to the electro-optic apparatus, the TFT substrate for current control and the method for producing the same of the invention, alternating current can be directly controlled, significantly high-frequency alternating current can be output, a large amount of current can be output stably, and manufacturing cost can be reduced.

### BACKGROUND

An organic EL display apparatus has attracted attention as a next-generation display or solid illumination replacing an LCD (Liquid Crystal Display). The reason therefor is as follows. Since an organic EL (Electronic Luminescence) device is a self-emitting device, it has less dependency on viewing angle. In addition, an organic EL display device has excellent properties such as lower power consumption since no backlight or reflected light is needed.
As the method for driving an organic EL display apparatus, simple matrix driving and active matrix driving can be given. The active matrix driving method is superior to the simple matrix driving method in image quality and response speed. An active-matrix-driven organic EL display apparatus has a TFT (Thin Film Transistor) substrate in which a switching transistor, a driving transistor or the like is formed in each pixel (generally called a TFT substrate for current control). This organic EL display apparatus controls the amount of current flowing in each organic EL device by the above-mentioned TFT substrate.

In the meantime, the above-mentioned active-matrix-driven organic EL display apparatus has excellent properties. However, variations in the properties of the driving transistor results in a change in the amount of current flown in an organic EL display device for each pixel. In such a case, unevenness in luminance occurs. Furthermore, an organic EL device is a current-flown emitting device, and hence, luminance can be changed depending on the amount of current. However, luminance decreases with the lapse of time when emission is performed continuously.
In order to overcome the above-mentioned problems, organic EL display apparatuses having various driving circuits have been proposed.

### (Conventional Example)

For example, Patent Document 1 discloses a technology of an addressable image display pixel. In this addressable image display pixel, a photo-sensor and a feedback readout circuit are formed on a substrate. The photo-sensor is optically coupled to a light emitter formed on the substrate to detect light emitted by the light emitter to generate a feedback voltage signal in response to light emitted by the light emitter. The feedback readout circuit is provided with resetting means and a select switch. This resetting means outputs a feedback signal representing the light output of the light emitter in response to the feedback voltage signal. The resetting means resets a transistor amplifier or a readout circuit.

Patent Document 2 discloses a technology of an electro-optic apparatus in which unevenness in luminance due to variations in TFT characteristics is corrected. In this electro-optic apparatus, current flowing in organic EL devices is measured without providing a current-measuring element for each pixel in an active matrix constitution. In this electro-optic apparatus, active elements and organic EL devices are arranged in a matrix form, a plurality of current-supplying lines is arranged to supply currents to the organic EL devices and a current-measuring element is provided for each current-supplying line. In this electro-optic,apparatus, a scanning voltage is given to a single scanning line, prescribed data voltages are supplied to data lines in synchronism with the scanning voltage, and the values of current flowing in the organic EL devices are measured by the current-measuring elements. In this electro-optic apparatus, then, the scanning voltage is applied to the same scanning line, and data signals, which make electro-optic elements in a zero gradation, are supplied to the data lines in synchronism with the scanning voltage. The above-mentioned driving operations are conducted for each scanning line, and the data voltage to be given to each active element is corrected based on the obtained current measurement values.

Patent Document 3 discloses a technology of an electro-optic apparatus in which a compensation transistor for compensating variations of a driving transistor is provided in each pixel. This electro-optic apparatus is provided with a current-mirror circuit which is composed of a driving transistor and a compensation transistor in each pixel. In this electro-optic apparatus, the gain coefficient of a driving transistor for each pixel and the gain coefficient of a compensation transistor are adjusted to be the same. As a result, even if variations generate in the characteristics of a driving transistor provided in each pixel, the same amount of current can be supplied to a driven element in each pixel. Accordingly, deviation in luminance caused by variations in the characteristics of a driving transistor can be suppressed.
Patent Document 1: JP-A-2003-271098
Patent Document 2: JP-A-2002-278513
Patent Document 3: JP-A-2006-39574

### DISCLOSURE OF THE INVENTION

### Problem to be Solved by the Invention

However, in the technologies disclosed in the above-mentioned Patent Documents 1 and 3, the number of elements constituting each pixel is increased, causing the structure to be complicated. Accordingly, these technologies suffer from problems in which yield is decreased or manufacturing cost cannot be decreased.
In addition, in the technology disclosed in Patent Document 3, the gain coefficient of the driving transistor and the gain coefficient of the compensation transistor in each pixel are adjusted to be the same. As a result, unevenness in luminance due to deviation in the characteristics of the driving transistor can be suppressed. However, if used for a long time, a period of time during which electric current is passed through becomes different between the driving transistor and the compensation transistor in each pixel. As a result, difference in performance between the driving transistor and the compensation transistor is increased due to deterioration, causing luminance to be deviated.
Furthermore, in the technology described in Patent Document 2, a current-measuring element is connected to a single current-supplying line which supplies electric current to a plurality of (n pieces) organic EL devices. Due to such a configuration, for pixels in the same row, it is possible to measure current flowing in an organic EL device in a single pixel. However, during the measurement, it is required not to allow electric current to be flown in other pixels in the same row (the reason therefor is as follows. If electric current is flown in many pixels in the same row, a variation in electric current flowing in an organic EL device in a single pixel cannot be measured). That is, it is necessary to conduct measurement without allowing current to be flown in other pixels in the same row, which results in restrictions on the measurement conditions.

A common organic EL display apparatus is provided with a TFT substrate for current control on which thin film transistors using a plurality of silicon semiconductors are arranged. If a large amount of electric current is flown, the silicon semiconductors are deteriorated, and as a result, the silicon semiconductors cannot control the voltage or current applied to an organic EL device. In addition, flow of a large amount of direct current may shorten the life of an organic EL apparatus.
Furthermore, an electro-optic apparatus using an inorganic EL device as an electro-optic device is driven by using an AC power source. In this electro-optic apparatus, AC driving cannot be performed during a single driving, and hence, in the next driving, the inorganic EL device is driven after reversing the polarity of the voltage. That is, even if the inorganic EL device appears to be driven by AC power, it is actually driven by DC power during a single scan. Therefore, in order to increase the frequency of the AC driving, it is necessary to increase the frequency of scanning. As a result, it is difficult to increase the frequency of the AC driving.

The invention has been made in view of the above-mentioned problems, and an object thereof is to provide an electro-optic apparatus which is capable of directly controlling AC current, outputting high-frequency AC current, stably outputting a large amount of electric power, and reducing manufacturing cost, as well as a TFT substrate for current control and a method for producing thereof.

### Means for Solving the Problem

In order to achieve the object, the TFT substrate for current control according to the invention is a TFT substrate for current control on which a driving transistor which supplies electric current to an electro-optic device and a switching transistor which controls the driving transistor are formed, in which an active layer of the driving transistor is composed of an oxide semiconductor layer.
Due to such a configuration, the TFT substrate for current control of the invention suffers from only a small degree of deterioration even though a large amount of AC current is flown or a large amount of power is input as compared with a TFT substrate for current control in which amorphous Si or a polysilicon semiconductor is used in an active layer of the driving transistor. Therefore, excellent stability is achieved and durability is improved. In addition, if used in an emitting apparatus having an organic EL device, the life of the emitting apparatus can be significantly prolonged.

Furthermore, it is preferred that the active layer of the switching transistor be composed of an oxide semiconductor layer.
Due to such a configuration, durability can be improved as compared with a TFT substrate for current control in which amorphous Si or a polysilicon semiconductor is used for an active layer of the switching transistor.

Furthermore, it is preferred that the driving transistor be provided with at least one of a source line, a drain line, a source electrode or a drain electrode, and at least one of the source line, the drain line, the source electrode and the drain electrode be composed of an oxide conductor layer, and the oxide conductor layer function as a pixel electrode of the electro-optic device.
Due to such a configuration, the number of masks used during the production can be decreased, and the production steps can be reduced. As a result, production efficiency can be improved and manufacturing cost can be reduced. Furthermore, normally, the oxide conductor layer functions as the source line, the drain line, the source electrode, the drain electrode and the pixel electrode. As a result, the source line, the drain line, the source electrode, the drain electrode and the pixel electrode can be produced efficiently.

In addition, it is preferred that the switching transistor comprise at least one of a source line, a drain line, a source electrode and a drain electrode, and at least one of the source line, the drain line, the source electrode and the drain electrode be composed of the oxide conductor layer.

Furthermore, it is preferred that the TFT substrate for current control comprise at least one of a gate line, a source line, a drain line, a gate electrode, a source electrode, a drain electrode and a pixel electrode, and an auxiliary conductor layer be formed above at least one of the gate line, the source line, the drain line, the gate electrode, the source electrode, the drain electrode and the pixel electrode.
By doing this, the electric resistance of each line and each electrode can be reduced. As a result, reliability can be improved and a decrease in energy efficiency can be suppressed.

In addition, in order to achieve the object of the invention, the electro-optic apparatus of the invention comprises an electro-optic device driven by electric current and a TFT substrate for current control on which at least a driving transistor which supplies electric current to the electro-optic device and a switching transistor which controls the driving transistor are formed, wherein the TFT substrate for current control is the TFT substrate for current control according to any one of claims 1 to 5.
Due to such a configuration, the TFT substrate for current control according to the invention suffers from only a small degree of deterioration even though a large amount of AC current is flown or a large amount of power is input as compared with a TFT substrate for current control in which amorphous Si or a polysilicon semiconductor is used in an active layer of the driving transistor. Therefore, stability is improved and the durability of the TFT substrate for current control of the invention is improved. As a result, the life of the electro-optic apparatus can be prolonged significantly.

Furthermore, the electro-optic apparatus of the invention comprises an electro-optic device driven by electric current, a driving transistor for supplying electric current to the electro-optic device, a switching transistor which controls the driving transistor, a capacitor for applying a capacitor voltage to a gate electrode of the driving transistor, and a measuring transistor for measuring electric current supplied to the electro-optic device, wherein
a gate line of the switching transistor is connected with a scanning line for controlling the switching transistor, a source line of the switching transistor is connected with a data line for controlling electric current supplied to the electro-optic device, and a drain line of the switching transistor is connected in parallel with a gate line of the driving transistor and a first electrode of the capacitor,
a source line of the driving transistor is connected with a driving line for supplying electric current to the electro-optic device, a drain line of the driving transistor is connected in parallel with the electro-optic device, a second electrode of the capacitor and a source line of the measuring transistor, and
a gate line of the measuring transistor is connected with the scanning line, and a drain line of the measuring transistor is connected with a measuring line for measuring electric current supplied to the electro-optic device.

Due to such a configuration, when a direct voltage is applied to the scanning line, the switching transistor and the measuring transistor turn to the ON-state. By the direct voltage and the direct current supplied from the data line, the ON-state of the driving transistor is controlled through the switching transistor. In addition, direct current flowing from the driving line to the measuring line through the driving transistor and the measuring transistor can be measured. Therefore, through the measuring line, the voltage and the current of the data line can be controlled until the direct current supplied to the electro-optic device reaches a prescribed current value. As a result, luminance of the electro-optic device can be finely adjusted.
The first electrode of the capacitor is connected in parallel with the drain line of the switching transistor and the gate line of the driving transistor. Furthermore, the second electrode of the capacitor is connected in parallel with the drain line, the electro-optic device and the source line of the measuring transistor. Due to such a configuration, the ON-state of the driving transistor can be maintained by the voltage stored in the capacitor even if the voltage application to the scanning line is stopped to make the switching transistor and the measuring transistor the OFF-state when the direct current supplied to the electro-optic device reaches a prescribed current value. That is, the direct current measured by the measuring transistor is supplied to the electro-optic device from the driving line through the driving transistor, enabling stable emission of the DC-driven electro-optic device.

Furthermore, the electro-optic device may preferably be a DC-driven electro-optic device.
By doing this, stable emission of a Doc-driven electro-optic device can be realized.

Furthermore, the DC-driven electro-optic device may preferably be an organic EL device and/or a DC-driven inorganic EL device.
By doing this, stable emission of an organic EL device and/or a DC-driven inorganic EL device can be realized.

Furthermore, the electro-optic apparatus of the invention comprises an electro-optic device driven by electric current, a driving transistor which supplies electric current to the electro-optic device, a switching transistor which controls the driving transistor, a capacitor for applying a capacitor voltage to a gate electrode of the driving transistor, and a measuring transistor which measures electric current supplied to the electro-optic device, wherein
a gate line of the switching transistor is connected with a scanning line for controlling the switching transistor, a source line of the switching transistor is connected with a data line for controlling electric current supplied to the electro-optic device, and a drain line of the switching transistor is connected in parallel with a gate line of the driving transistor and a first electrode of the capacitor,
a source line of the driving transistor is connected with a driving line for supplying electric current to the electro-optic device, a drain line of the driving transistor is connected in parallel with the electro-optic device and a source line of the measuring transistor, and
a second electrode of the capacitor is connected with a capacitor line for releasing stored carriers, and
a gate line of the measuring transistor is connected with the scanning line and a drain line of the measuring transistor is connected with a measuring line for measuring electric current supplied to the electro-optic device.

Due to such a configuration, when a direct voltage is applied to the scanning line, the switching transistor and the measuring transistor turn to the ON-state. By the direct voltage and the direct current supplied by the data line, the ON-state of the driving transistor is controlled through the switching transistor. In addition, direct current or alternating current flowing from the driving line to the measuring line through the driving transistor and the measuring transistor can be measured. Therefore, the direct voltage and the direct current of the data line can be controlled until the direct current or the alternating current supplied to the electro-optic device through the measuring line reaches a prescribed current value. As a result, luminance of the electro-optic device can be finely adjusted.
The first electrode of the capacitor is connected in parallel with the drain line of the switching transistor and the gate line of the driving transistor. Furthermore, the second electrode of the capacitor is connected with the capacitor line grounded to the cathode. Due to such a configuration, the ON-state of the driving transistor can be maintained by the voltage stored in the capacitor even if the voltage application to the scanning line is stopped to make the switching transistor and the measuring transistor the OFF-state when the direct current and the alternating current supplied to the electro-optic device reaches a prescribed current value. That is, the direct current or the alternating current measured by the measuring transistor is supplied to the electro-optic device from the driving line through the driving transistor, enabling stable emission of the DC-driven electro-optic device or the AC-driven electro-optic device.

Furthermore, the electro-optic device may preferably be a DC-driven electro-optic device and/or an AC-driven electro-optic device.
By doing this, stable emission of the DC-driven electro-optic device and/or the AC-driven electro-optic device can be realized.

In addition, the DC-driven electro-optic device and/or the AC-driven electro-optic device may preferably be a DC-driven inorganic EL device, an organic EL device and/or an AC-driven inorganic EL device.
By doing this, stable emission of the DC-driven inorganic EL device, the organic EL device and/or the AC-driven inorganic EL device can be realized.

Furthermore, it is preferred that a pixel composed of the electro-optic device, the driving transistor, the switching transistor, the capacitor and the measuring transistor is arranged on a TFT substrate for current control.
By doing this, it is possible to use TFT (thin film transistor) technology in the electro-optic apparatus.

In addition, the TFT substrate for current control may be the TFT substrate for current control according to any one of claims 1 to 5.
By doing this, the TFT substrate for current control according to the invention suffers from only a small degree of deterioration even though a large amount of AC current is flown or a large amount of power is input as compared with a TFT substrate for current control in which amorphous Si or a polysilicon semiconductor is used in an active layer of the driving transistor. Therefore, stability is improved and the durability of the TFT substrate for current control is improved. As a result, the life of the electro-optic apparatus can be prolonged significantly.

Furthermore, the electro-optic apparatus may comprise a scanning line-driving circuit, a data line-driving circuit, a power supply line-controlling circuit and a current-measuring circuit for activating a TFT substrate for current control, wherein the current-measuring circuit measures electric current supplied to the electro-optic device, and at least one of the data line-driving circuit, the scanning line-driving circuit and the power supply line-controlling circuit is controlled based on the measured electric current value.
Due to such a configuration, it is possible to measure the electric current supplied to the electro-optic device. In addition, at least one of the data line-driving circuit, the scanning line-driving circuit and the power supply line-controlling circuit may be controlled. Therefore, supply of the preset electric current to the electro-optic device is ensured.

Furthermore, to achieve the above-mentioned object, the method for producing a TFT substrate for current control of the invention comprises the steps of:
stacking, above a substrate, a conductor layer and a first resist and forming a scanning line, a gate electrode and a gate line of a switching transistor by using a first mask;
stacking a gate insulating film for the switching resistor;
stacking an active layer containing amorphous Si (silicon) or polycrystalline Si, or an oxide semiconductor layer, a conductor layer and a second resist, and forming a data line, a source line, a source electrode, a channel part, a drain electrode and a drain line of the switching transistor, as well as a gate line and a gate electrode of a driving transistor by using a second half-tone mask;
stacking a gate insulating film for the driving transistor;
stacking an oxide semiconductor layer and a third resist, and forming an active layer of the driving transistor by using a third mask;
stacking an oxide conductor layer and a fourth resist, and forming an EL-driving line, a source line, a source electrode, a channel part, a drain electrode and a drain line of the driving transistor, as well as a pixel electrode by using a fourth mask or a fourth half-tone mask; and
stacking a protective insulating film and a fifth resist, and exposing a pad for a scanning line, a pad for a data line, a pad for an EL-driving line and the pixel electrode by using a fifth mask.

As is apparent from the above, the invention is advantageous also as the method for producing a TFT substrate. That is, the active layer of the driving transistor is composed of an n-type oxide semiconductor layer. Therefore, the driving transistor suffers from only a small degree of deterioration even though a large amount of current or a large amount of power is input to the driving transistor. Therefore, stability is improved and the durability of the TFT substrate is improved. In addition, the EL-driving line, the source line, the source electrode, the channel part, the drain electrode and the drain line of the driving transistor, as well as the pixel electrode can be formed by using the fourth half-tone mask. Therefore, the number of masks used can be reduced and production steps can be decreased. Therefore, production efficiency is improved and manufacturing cost can be reduced. In addition, the protective insulating film is formed. Accordingly, an organic EL display apparatus can be obtained easily by providing organic EL materials, electrodes and protective films on a TFT substrate.

Furthermore, the method for producing a TFT substrate for current control comprises the steps of:
stacking, above a substrate, a conductor layer and a first resist, and forming a scanning line, a gate electrode and a gate line of a switching transistor, as well as a gate electrode and a gate line of a measuring transistor by using a first mask;
stacking a gate insulating film for the switching transistor;
stacking an active layer containing amorphous Si (silicon) or polycrystalline Si, or an oxide semiconductor layer, a conductor layer and a second resist, and forming a data line, a first electrode of a capacitor, a measuring line, a source line, a source electrode, a channel part, a drain electrode and a drain line of the switching transistor, as well as a gate line and a gate electrode of a driving transistor by using a second half-tone mask;
stacking a gate insulating film for the driving transistor, the measuring transistor and the capacitor;
stacking an oxide semiconductor layer and a third resist, and forming active layers of the driving transistor and the measuring transistor, as well as a contact hole of the measuring line by using a third half-tone mask;
stacking an oxide semiconductor layer and a fourth resist, and forming an EL-driving line, a second electrode of the capacitor, a pixel electrode, a source line, a source electrode, a channel part, a drain electrode and a drain line of the driving transistor, as well as a source line, a source electrode, a channel part, a drain electrode and a drain line of the measuring transistor by using a fourth mask or a fourth half-tone mask; and
stacking a protective insulating film and a fifth resist, and exposing a pad for a scanning line, a pad for a data line, a pad for an EL-driving line, a pad for a measuring line and the pixel electrode by using a fifth mask.
By doing this, it is possible to supply to an electro-optic device driven by direct current driving current having almost the same value as a predetermined value measured by the current-measuring circuit. As a result, it is possible to provide an image with improved quality. In addition, the active layers of the driving transistor and the measuring transistor are composed of an n-type oxide semiconductor layer. As a result, the driving transistor and the measuring transistor suffer only a small degree of deterioration in performance even though a large amount of current is flown or a large amount of power is input to the driving transistor and the measuring transistor. Therefore, stability is improved and the durability of the TFT substrate is improved. Furthermore, the number of masks used can be reduced and production steps can be decreased. Therefore, production efficiency is improved and manufacturing cost can be reduced.

Furthermore, the method for producing a TFT substrate for current control comprises the steps of:
stacking, above a substrate, a conductor layer and a first resist, and forming a scanning line, a gate electrode and a gate line of a switching transistor, as well as a gate electrode and a gate line of a measuring transistor by using a first mask;
stacking a gate insulating film for the switching transistor;
stacking an active layer containing amorphous Si (silicon) or polycrystalline Si, or an oxide semiconductor layer, a conductor layer and a second resist, and forming a data line, a first electrode of a capacitor, a measuring line, a source line, a source electrode, a channel part, a drain electrode and a drain line of the switching transistor, as well as a gate line and a gate electrode of the driving transistor by using a second half-tone mask;
stacking a gate insulating film for the driving transistor, the measuring transistor and the capacitor;
stacking an oxide semiconductor layer and a third resist, and forming active layers of the driving transistor and the measuring transistor, as well as a contact hole of the measuring line, an opening of a pad for a data line, an opening of a pad for a scanning line and an opening of a pad for a measuring line by using a third half-tone mask;
stacking an oxide conductor layer and a fourth resist, and forming an EL-driving line, a second electrode of the capacitor, a pixel electrode, a pad for a data line , a pad for a scanning line, a pad for a measuring line, a source line, a source electrode, a channel part, a drain electrode and a drain line of the driving transistor, as well as a source line, a source electrode, a channel part, a drain electrode and a drain line of the measuring transistor by using a fourth mask or a fourth half-tone mask; and
stacking a protective insulating film and a fifth resist, and exposing the pad for a scanning line, the pad for a data line, a pad for an EL-driving line, the pad for a measuring line and the pixel electrode by using a fifth mask.
By doing this, the pad for a data line, the pad for a scanning line, the pad for a measuring line and the pad for an EL-driving line are formed immediately below the protective insulting film. As a result, connectability to the pad for a data line, the pad for a scanning line, the pad for a measuring line and the pad for an EL-driving line can be improved.

Furthermore, the method for producing a TFT substrate for current control comprises the steps of:
stacking, above a substrate, a conductor layer and a first resist, and forming a scanning line, a capacitor line, a second electrode of a capacitor, a gate electrode and a gate line of a switching transistor, as well as a gate electrode and a gate line of a measuring transistor by using a first mask;
stacking a gate insulating film for the switching transistor and the capacitor;
stacking an active layer containing amorphous Si (silicon) or polycrystalline Si, or an oxide semiconductor layer, a conductor layer and a second resist, and forming a data line, a first electrode of the capacitor, a measuring line, a source line, a source electrode, a channel part, a drain electrode and a drain line of the switching transistor, as well as a gate line and a gate electrode of the driving transistor by using a second half-tone mask;
stacking a gate insulating film for the driving transistor and the measuring transistor;
stacking an oxide semiconductor layer and a third resist, and forming active layers of the driving transistor and the measuring transistor, as well as a contact hole of the measuring line by using a third half-tone mask;
stacking an oxide conductor layer and a fourth resist, and forming an EL-driving line, a pixel electrode, a source line, a source electrode, a channel part, a drain electrode and a drain line of the driving transistor, as well as a source line, a source electrode, a channel part and a drain electrode and a drain line of the measuring transistor by using a fourth mask or a fourth half-tone mask; and
stacking a protective insulating film and a fifth resist, and exposing a pad for a scanning line, a pad for a data line, a pad for an EL-driving line, a pad for a measuring line, a pad for a capacitor line and the pixel electrode by using a fifth mask.
By doing this, it is possible to supply driving current having almost the same value as a predetermined value measured by the current-measuring circuit to an electro-optic device driven by alternating current or direct current. As a result, it is possible to provide an image of improved quality. In addition, the active layers of the driving transistor and the measuring transistor are composed of an n-type oxide semiconductor layer. As a result, the driving transistor and the measuring transistor suffer only a small degree of deterioration in performance even though a large amount of current is flown or a large amount of power is input to the driving transistor and the measuring transistor. Therefore, stability is improved and the durability of the TFT substrate is improved. Furthermore, the number of masks used can be reduced and production steps can be decreased. Therefore, production efficiency is improved and manufacturing cost can be reduced.

Furthermore, the method for producing a TFT substrate for current control comprises the steps of:
stacking, above a substrate, a conductor layer and a first resist, and forming a scanning line, a capacitor line, a second electrode of a capacitor, a gate electrode and a gate line of a switching transistor, as well as a gate electrode and a gate line of a measuring transistor by using a first mask;
stacking a gate insulating film for the switching transistor and the capacitor;
stacking an active layer containing amorphous Si (silicon) or polycrystalline Si, or an oxide semiconductor layer, a conductor layer and a second resist, and forming a data line, a first electrode of the capacitor, a measuring line, a source line, a source electrode, a channel part, a drain electrode and a drain line of the switching transistor, as well as a gate line and a gate electrode of a driving transistor by using a second half-tone mask;
stacking a gate insulating film for the driving transistor and the measuring transistor;
stacking an oxide semiconductor layer and a third resist, and forming active layers for the driving transistor and the measuring transistor, as well as a contact hole of the measuring line, an opening of a pad for a data line, an opening of a pad for a scanning line, an opening of a pad for a measuring line and an opening of a pad for a capacitor line by using a third half-tone mask;
stacking an oxide conductor layer and a fourth resist, and forming an EL-driving line, a pixel electrode, the pad for a data line, the pad for a scanning line, the pad for a measuring line, the pad for a capacitor line, a source line, a source electrode, a channel part, a drain electrode and a drain line of the deriving transistor, as well as a source line, a source electrode, a channel part, a drain electrode and a drain line of the measuring transistor by using a fourth mask or a fourth half-tone mask; and
stacking a protective insulating film and a fifth resist, and exposing the pad for a scanning line, the pad for a data line, a pad for an EL-driving line, the pad for a measuring line, the pad for a capacitor line and the pixel electrode by using a fifth mask.
By doing this, the pad for a data line, the pad for a scanning line, the pad for a measuring line, the pad for a capacitor line and the pad for an EL-driving line are formed immediately below the protective insulting film. As a result, connectability to the pad for a data line, the pad for a scanning line, the pad for a measuring line, the pad for a capacitor line and the pad for an EL-driving line can be improved.

### BRIEF DESCRIPTION OF THE DRAWINGS

FIG. 1 is a schematic block diagram of an organic EL display apparatus according to a first embodiment of the invention;
FIG. 2 is a schematic block diagram for explaining the structure of a pixel of the organic EL display apparatus according to the first embodiment of the invention;
FIG. 3 is a schematic flow chart for explaining a method for producing a TFT substrate to be used in the organic EL display apparatus according to the first embodiment of the invention;
FIG. 4 is a schematic view for explaining a treatment by using a first mask in the method for producing a TFT substrate to be used in the organic EL display apparatus according to the first embodiment of the invention, in which (a) is a cross-sectional view after the formation of a metal layer/after the application of a first resist/after exposure/after development; (b) is a cross-sectional view after first etching/after the peeling off the first resist; and (c) is a plan view of an essential part of the TFT substrate after the peeling off the first resist;

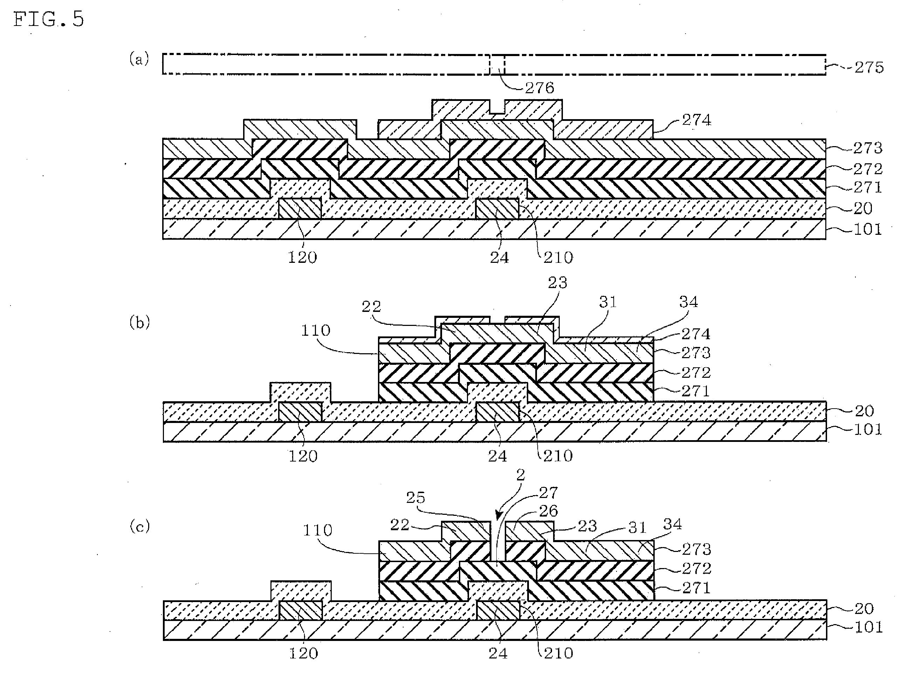

FIG. 5 is a schematic view for explaining a treatment by using a second half-tone mask in the method for producing a TFT substrate to be used in the organic EL display apparatus according to the first embodiment of the invention, in which (a) is a cross-sectional view after the formation of a gate insulating film/after the formation of an α-Si:H(i) film/after the formation of an α-Si:H(n) film/after the formation of the metal layer/after the application of a second resist/after half-tone exposure/after development; (b) is a cross-sectional view after the second etching/after the reformation of the second resist; and (c) is a cross-sectional view after the third etching/after the peeling off the second resist;
FIG. 6 is a schematic plan view of an essential part of a TFT substrate on which a switching transistor is formed in the method for producing a TFT substrate to be used in the organic EL display apparatus according to the first embodiment of the invention;
FIG. 7 is a schematic view for explaining a treatment by using a third mask in the method for producing a TFT substrate to be used in the organic EL display apparatus according to the first embodiment of the invention, in which (a) is a cross-sectional view after the formation of a gate insulating film/after the formation of an n-type oxide semiconductor layer/after the application of a third resist/after exposure/after development; and (b) is a cross-sectional view after the fourth etching/after the peeling off the third resist;
FIG. 8 is a schematic plan view of an essential part of a TFT substrate after the peeling off the third resist in the method for producing a TFT substrate to be used in the organic EL display apparatus according to the first embodiment of the invention;
FIG. 9 is a schematic view for explaining a treatment by using a fourth half-tone mask in the method for producing a TFT substrate to be used in the organic EL display apparatus according to the first embodiment of the invention, in which (a) is a cross-sectional view after the formation of an oxide transparent conductor layer/after the formation of the metal layer/after the application of a fourth resist/after half-tone exposure/after development; and (b) is a cross-sectional view after fifth etching/after the reformation of the fourth resist;
FIG. 10 is a schematic view for explaining a treatment by using a fourth half-tone mask in the method for producing a TFT substrate to be used in the organic EL display apparatus according to the first embodiment of the invention, showing a cross-sectional view after the sixth etching/after the peeling off the fourth resist;
FIG. 11 is a schematic plan view of an essential part of a TFT substrate after the peeling off the fourth resist in the method for producing a TFT substrate to be used in the organic EL display apparatus according to the first embodiment of the invention;
FIG. 12 is a schematic view for explaining a treatment by using a fifth mask in the method for producing a TFT substrate to be used in the organic EL display apparatus according to the first embodiment of the invention, in which (a) is a cross-sectional view after the formation of a protective insulating film/after the application of a fifth resist/after exposure/after development, and (b) is a cross-sectional view after the seventh etching/after the peeling off the fifth resist;
FIG. 13 is a schematic plan view of an essential part of a TFT substrate after the peeling off the fifth resist in the method for producing a TFT substrate to be used in the organic EL display apparatus according to the first embodiment of the invention;
FIG. 14 is a schematic flow chart for explaining the method for producing a TFT substrate to be used in an organic EL display apparatus according to an application example of the first embodiment of the invention;

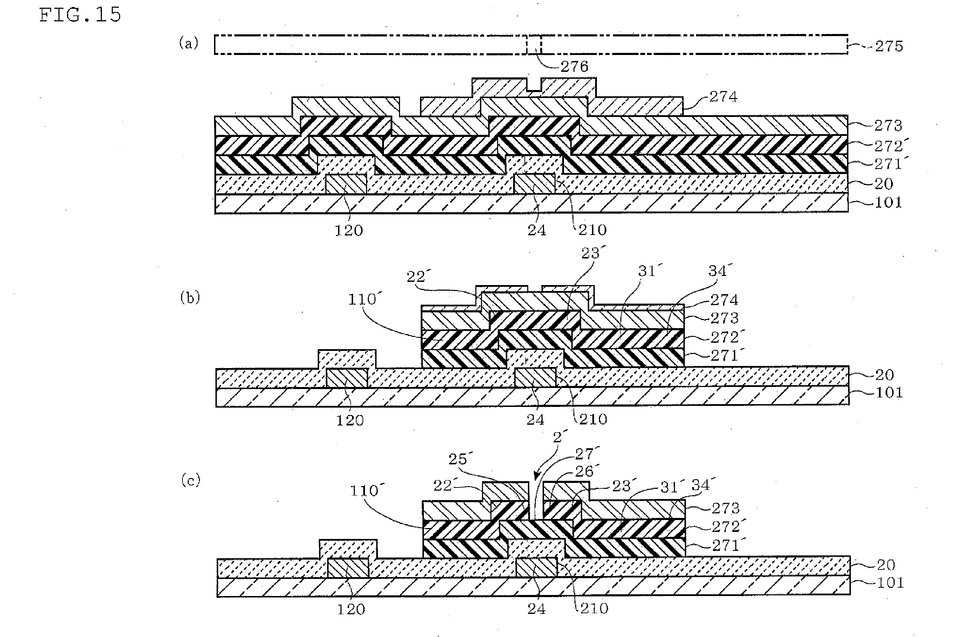

FIG. 15 is a schematic view for explaining a treatment by using the second half-tone mask in the method for producing a TFT substrate to be used in the organic EL display apparatus according to the application example of the first embodiment of the invention, in which (a) is a cross-sectional view after the formation of the gate insulating film/after the formation of the n-type oxide semiconductor layer/after the formation of the oxide transparent conductor layer/after the formation of the metal layer/after the application of the second resist/after half-tone exposure/after development; (b) is a cross-sectional view after the second etching/after the reformation of the second resist; and (c) is a cross-sectional view after the third etching/after the peeling off the second resist;
FIG. 16 is a schematic plan view of an essential part of a TFT substrate on which a switching transistor is formed in the method for producing a TFT substrate to be used in the organic EL display apparatus according to the application example of the first embodiment of the invention;
FIG. 17 is a schematic block diagram of an organic EL display apparatus according to a second embodiment of the invention;
FIG. 18 is a schematic block diagram for explaining the structure of a pixel of the organic EL display apparatus according to the second embodiment of the invention;
FIG. 19 is a schematic flow chart for explaining the method for producing a TFT substrate to be used in the organic EL display apparatus according to the second embodiment of the invention;
FIG. 20 is a schematic view for explaining a treatment by using the first mask in the method for producing a TFT substrate to be used in the organic EL display apparatus according to the second embodiment of the invention, in which (a) is a cross-sectional view after the formation of the metal layer/after the application of the first resist/after exposure/after development; (b) is a cross-sectional view after the first etching/after the peeling off the first resist; and (c) is a plan view of an essential part of the TFT substrate after the peeling off the first resist;

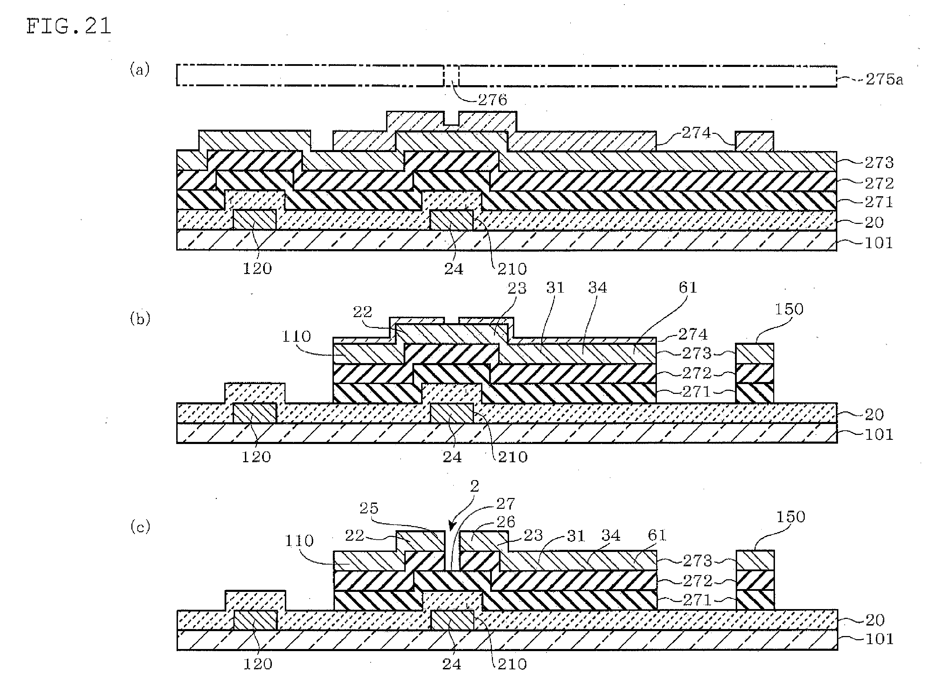

FIG. 21 is a schematic view for explaining a treatment by using the second half-tone mask in the method for producing a TFT substrate to be used in the organic EL display apparatus according to the second embodiment of the invention, in which (a) is a cross-sectional view after the formation of the gate insulating film/after the formation of the α-Si:H(i) film/after the formation of the α-Si:H(n) film/after the formation of the metal layer/after the application of the second resist/after halt-tone exposure/after development; (b) is a cross-sectional view after the second etching/after the reformation of the second resist; and (c) is a cross-sectional view after the third etching/after the peeling off the second resist;
FIG. 22 is a schematic plan view of an essential part of a TFT substrate on which a switching transistor is formed in the method for producing a TFT substrate to be used in the organic EL display apparatus according to the second embodiment of the invention;
FIG. 23 is a schematic view for explaining a treatment by using the third half-tone mask in the method for producing a TFT substrate to be used in the organic EL display apparatus according to the second embodiment of the invention, in which (a) is a cross-sectional view after the formation of the gate insulating film/after the formation of the n-type oxide semiconductor layer/after the application of the third resist/after half-tone exposure/after development; and (b) is a cross-sectional view after the fourth etching/after the reformation of the third resist;
FIG. 24 is a schematic view for explaining a treatment by using the third half-tone mask in the method for producing a TFT substrate to be used in the organic EL display apparatus according to the second embodiment of the invention, showing a cross-sectional view after the fifth etching/after the peeling off the third resist;
FIG. 25 is a schematic plan view of an essential part of a TFT substrate after the peeling off the third resist in the method for producing a TFT substrate to be used in the organic EL display apparatus according to the second embodiment of the invention;
FIG. 26 is a schematic view for explaining a treatment by using the fourth half-tone mask in the method for producing a TFT substrate to be used in the organic EL display apparatus according to the second embodiment of the invention, in which (a) is a cross-sectional view after the formation of the oxide transparent conductor layer/after the formation of the metal layer/after the application of the fourth resist/after half-tone exposure/after development; and (b) is a cross-sectional view after the sixth etching/after the reformation of the fourth resist;
FIG. 27 is a schematic view for explaining a treatment by using the fourth half-tone mask in the method for producing a TFT substrate to be used in the organic EL display apparatus according to the second embodiment of the invention, showing a cross-sectional view after the seventh etching/after the peeling off the fourth resist;
FIG. 28 is a schematic plan view of an essential part of a TFT substrate after the peeling off the fourth resist in the method for producing a TFT substrate to be used in the organic EL display apparatus according to the second embodiment of the invention;
FIG. 29 is a schematic view for explaining a treatment by using the fifth mask in the method for producing a TFT substrate to be used in the organic EL display apparatus according to the second embodiment of the invention, in which (a) is a cross-sectional view after the formation of the protective insulating film/after the application of the fifth resist/after exposure/after development; and (b) is a cross-sectional view after the seventh etching/after the peeling off the fifth resist;
FIG. 30 is a schematic plan view of an essential part of a TFT substrate after the peeling off the fifth resist in the method for producing a TFT substrate to be used in the organic EL display apparatus according to the second embodiment of the invention;
FIG. 31 is a schematic flow chart for explaining the method for producing a TFT substrate to be used in an organic EL display apparatus according to an application example of the second embodiment of the invention;
FIG. 32 is a schematic view for explaining a treatment by using the third half-tone mask in the method for producing a TFT substrate to be used in the organic EL display apparatus according to the application example of the second embodiment of the invention, in which (a) is a cross-sectional view after the formation of the gate insulating film/after the formation of the n-type oxide semiconductor layer/after the application of the third resist/after half-tone exposure/after development; and (b) is a cross-sectional view after the fourth etching/after the reformation of the third resist;
FIG. 33 is a schematic view for explaining a treatment by using the third half-tone mask in the method for producing a TFT substrate to be used in the organic EL display apparatus according to the application example of the second embodiment of the invention, showing a cross-sectional view after the fifth etching/after the peeling off the third resist;
FIG. 34 is a schematic plan view of an essential part of a TFT substrate after the peeling off the third resist in the method for producing a TFT substrate to be used in an organic EL display apparatus according to the application example of the second embodiment of the invention;

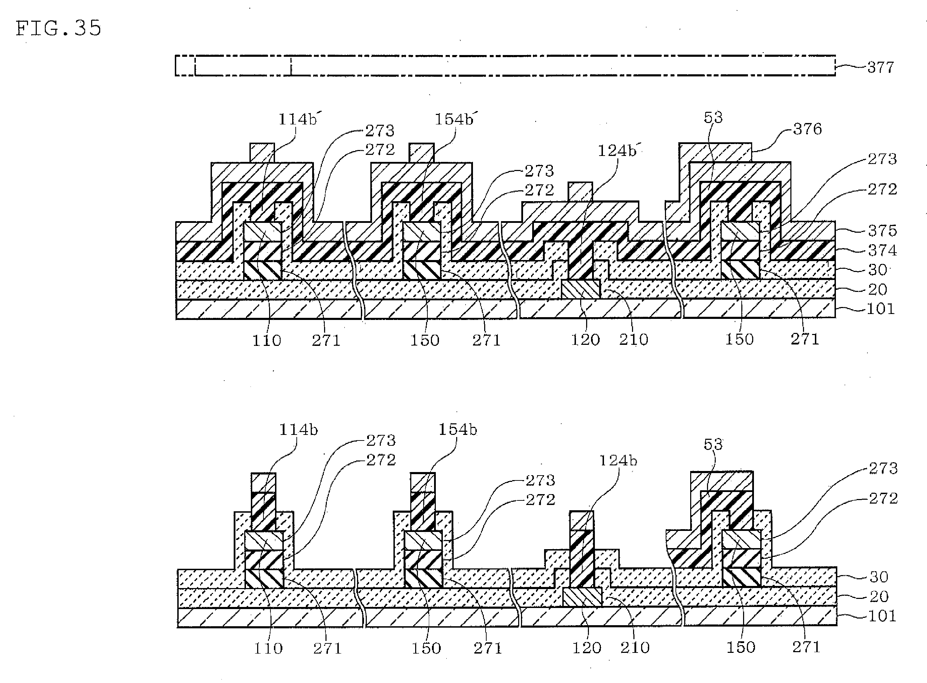

FIG. 35 is a schematic view for explaining a treatment by using the fourth half-tone mask in the method for producing a TFT substrate to be used in an organic EL display apparatus according to the application example of the second embodiment of the invention, in which (a) is a cross-sectional view after the formation of the oxide transparent conductor layer/after the formation of the metal layer/after the application of the fourth resist/after half-tone exposure/after development; and (b) is a cross-sectional view after the sixth etching/after the reformation of the fourth resist/after the seventh etching/after the peeling off the fourth resist;
FIG. 36 is a schematic plan view of an essential part of a TFT substrate after the peeling off the fourth resist in the method for producing a TFT substrate to be used in an organic EL display apparatus according to the application example of the second embodiment of the invention;
FIG. 37 is a schematic view for explaining a treatment by using the fifth mask in the method for producing a TFT substrate to be used in an organic EL display apparatus according to the application example of the second embodiment of the invention, in which (a) is a cross-sectional view after the formation of the protective insulating film/after the application of the fifth resist/after exposure/after development; and (b) is a cross-sectional view after the eighth etching/after the peeling off the fifth resist;
FIG. 38 is a schematic plan view of an essential part of a TFT substrate after the peeling off the fifth resist in the method for producing a TFT substrate to be used in the organic EL display apparatus according to the application example of the second embodiment of the invention;
FIG. 39 is a schematic block diagram of a dispersion-type inorganic EL display apparatus according to a third embodiment of the invention;
FIG. 40 is a schematic block diagram for explaining the structure of a pixel of the dispersion-type inorganic EL display apparatus according to the third embodiment of the invention;
FIG. 41 is a schematic flow chart for explaining the method for producing a TFT substrate to be used in the dispersion-type inorganic EL display apparatus according to the third embodiment of the invention;
FIG. 42 is a schematic view for explaining a treatment by using the first mask in the method for producing a TFT substrate to be used in the dispersion-type inorganic EL display apparatus according to the third embodiment of the invention, in which (a) is a cross-sectional view after the formation of the metal layer/after the application of the first resist/after exposure/after development; (b) is a cross-sectional view after the first etching/after the peeling off the first resist; and (c) is a plan view of an essential part of the TFT substrate after the peeling off the first resist;

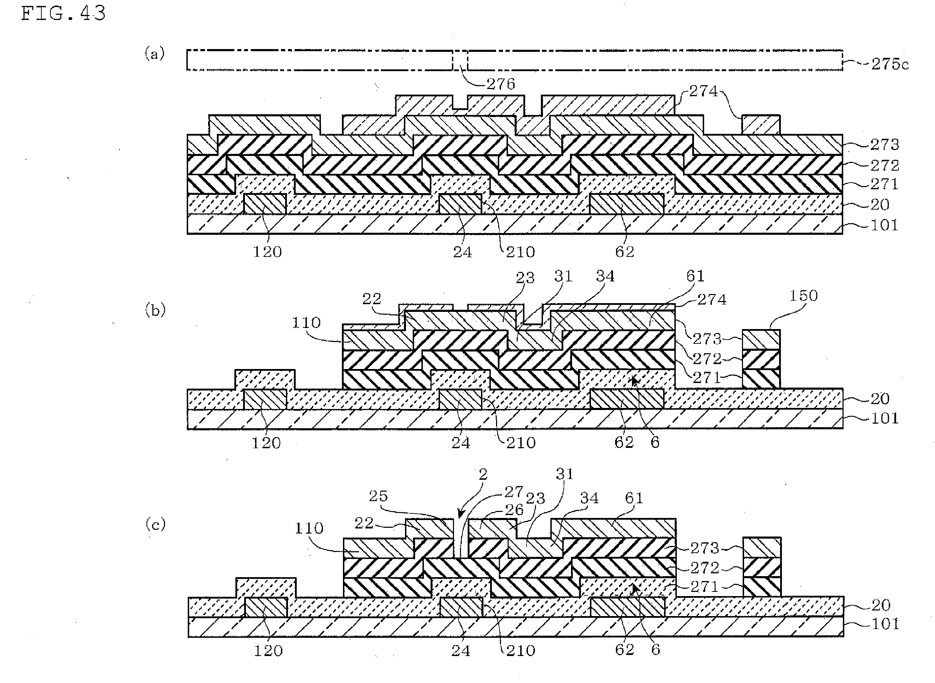

FIG. 43 is a schematic view for explaining a treatment by using the second half-tone mask in the method for producing a TFT substrate to be used in the dispersion-type inorganic EL display apparatus according to the third embodiment of the invention, in which (a) is a cross-sectional view after the formation of the gate insulating film/after the formation of the α-Si:H(i) film/after the formation of the α-Si:H(n) film/after the formation of the metal layer/after the application of the second resist/after half-tone exposure/after development; (b) is a cross-sectional view after the second etching/after the reformation of the second resist; and (c) is a cross-sectional view after the third etching/after the peeling off the second resist;
FIG. 44 is a schematic plan view of an essential part of a TFT substrate on which the switching transistor is formed in the method for producing a TFT substrate to be used in the dispersion-type inorganic EL display apparatus according to the third embodiment of the invention;
FIG. 45 is a schematic view for explaining a treatment by using the third half-tone mask in the method for producing a TFT substrate to be used in the dispersion-type inorganic EL display apparatus according to the third embodiment of the invention, in which (a) is a cross-sectional view after the formation of the gate insulating film/after the formation of the n-type oxide semiconductor layer/after the application of the third resist/after half-tone exposure/after development; and (b) is a cross-sectional view after the fourth etching/after the reformation of the third resist;
FIG. 46 is a schematic view for explaining a treatment by using the third half-tone mask in the method for producing a TFT substrate to be used in the dispersion-type inorganic EL display apparatus according to the third embodiment of the invention, showing a cross-sectional view after the fifth etching/after the peeling off the third resist;
FIG.47 is a schematic plan view of an essential part of a TFT substrate after the peeling off the third resist in the method for producing a TFT substrate to be used in the dispersion-type inorganic EL display apparatus according to the third embodiment of the invention.
FIG. 48 is a schematic view for explaining a treatment by using the fourth half-tone mask in the method for producing a TFT substrate to be used in the dispersion-type inorganic EL display apparatus according to the third embodiment of the invention, in which (a) is a cross-sectional view after the formation of the oxide transparent conductor layer/after the formation of the metal layer/after the application of the fourth resist/after half-tone exposure/after development; and (b) is a cross-sectional view after the sixth etching/after the reformation of the fourth resist;
FIG. 49 is a schematic view for explaining a treatment by using the fourth half-tone mask in the method for producing a TFT substrate to be used in the dispersion-type inorganic EL display apparatus according to the third embodiment of the invention, showing a cross-sectional view after the seventh etching/after the peeling off the fourth resist;
FIG. 50 is a schematic plan view of an essential part of a TFT substrate after the peeling off the fourth resist in the method for producing a TFT substrate to be used in the dispersion-type inorganic EL display apparatus according to the third embodiment of the invention;
FIG. 51 is a schematic view for explaining a treatment by using the fifth mask in the method for producing a TFT substrate to be used in the dispersion-type inorganic EL display apparatus according to the third embodiment of the invention, in which (a) is a cross-sectional view after the formation of the protective insulating film/after the application of the fifth resist/after exposure/after development; and (b) is a cross-sectional view after the eighth etching/after the peeling off the fifth resist;
FIG. 52 is a schematic plan view of an essential part of a TFT substrate after the peeling off the fifth resist in the method for producing a TFT substrate to be used in the dispersion-type inorganic EL display apparatus according to the third embodiment of the invention;
FIG. 53 is a schematic flow chart for explaining the method for producing a TFT substrate to be used in the dispersion-type inorganic EL display apparatus according to an application example of the third embodiment of the invention;

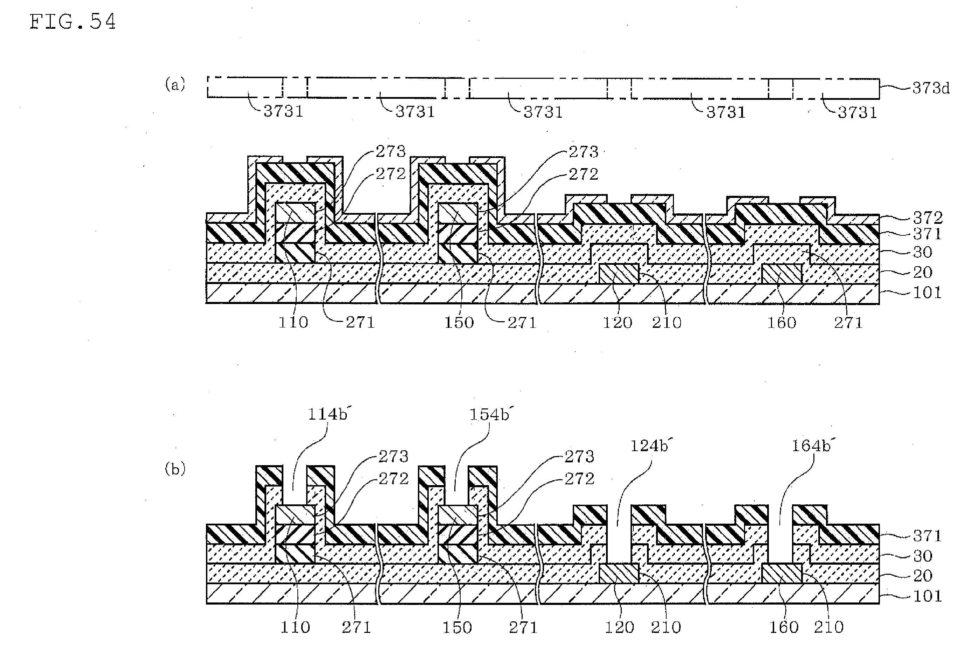

FIG. 54 is a schematic view for explaining a treatment by using the third half-tone mask in the method for producing a TFT substrate to be used in the dispersion-type inorganic EL display apparatus according to the application example of the third embodiment of the invention, in which (a) is a cross-sectional view after the formation of the gate insulating film/after the formation of the n-type oxide semiconductor layer/after the application of the third resist/after half-tone exposure/after development; and (b) is a cross-sectional view after the fourth etching/after the reformation of the third resist;
FIG. 55 is a schematic view for explaining a treatment by using the third half-tone mask in the method for producing a TFT substrate to be used in the dispersion-type inorganic EL display apparatus according to the application example of the third embodiment of the invention, showing a cross-sectional view after the fifth etching/after the peeling off the third resist;
FIG.56 is a schematic plan view of an essential part of a TFT substrate after the peeling off the third resist in the method for producing a TFT substrate to be used in the dispersion-type inorganic EL display apparatus according to the application example of the third embodiment of the invention;

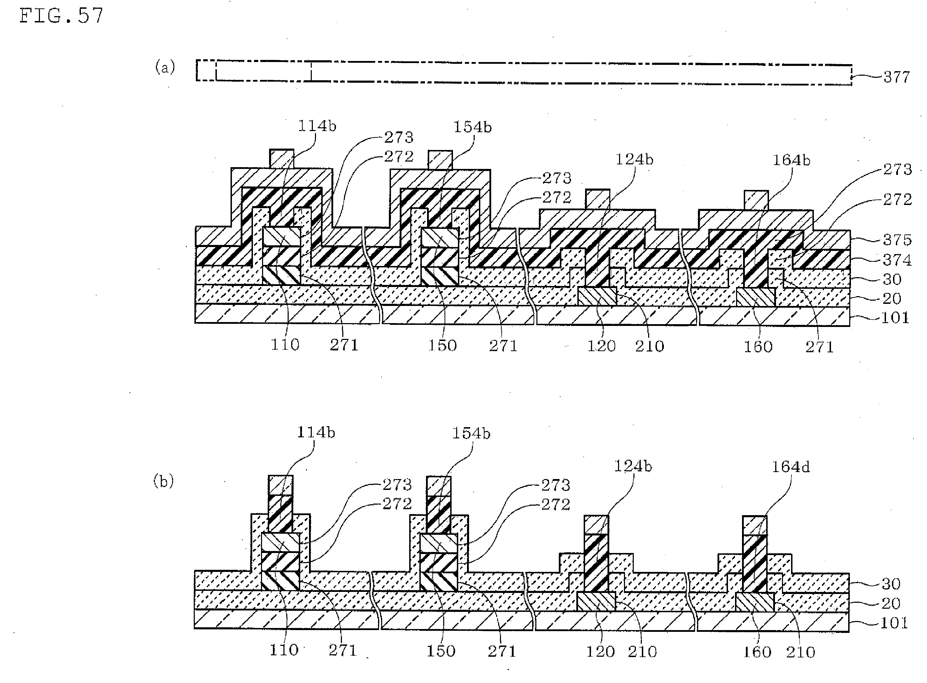

FIG. 57 is a schematic view for explaining a treatment by using the fourth half-tone mask in the method for producing a TFT substrate to be used in the dispersion-type inorganic EL display apparatus according to the application example of the third embodiment of the invention, in which (a) is a cross-sectional view after the formation of the oxide transparent conductor layer/after the formation of the metal layer/after the application of the fourth resist/after half-tone exposure/after development; and (b) is a cross-sectional view after the sixth etching/after the reformation of the fourth resist/after the seventh etching/after the peeling off the fourth resist;
FIG. 58 is a schematic plan view of an essential part of a TFT substrate after the peeling off the fourth resist in the method for producing a TFT substrate to be used in the dispersion-type inorganic EL display apparatus according to the application example of the third embodiment of the invention;
FIG. 59 is a schematic view for explaining a treatment by using the fifth mask in the method for producing a TFT substrate to be used in the dispersion-type inorganic EL display apparatus according to the application example of the third embodiment of the invention, in which (a) is a cross-sectional view after the formation of the protective insulating film/after the application of the fifth resist/after exposure/after development; and (b) is a cross-sectional view after the eighth etching/after the peeling off the fifth resist; and
Fig. 60 is a schematic plan view of an essential part of a TFT substrate after the peeling off the fifth resist in the method for producing a TFT substrate to be used in the dispersion-type inorganic EL display apparatus according to the application example of the third embodiment of the invention.

### BEST MODE FOR CARRYING OUT THE INVENTEION

### [First embodiment of an organic EL display apparatus]

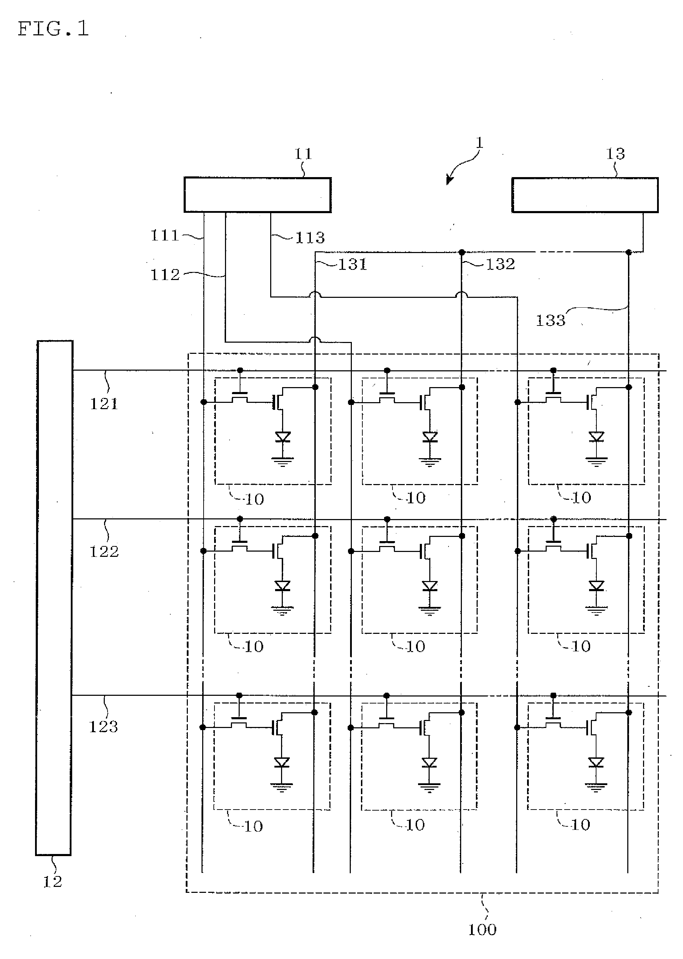

FIG. 1 is a schematic block diagram of an organic EL display apparatus according to a first embodiment of the invention.
In FIG. 1, an organic EL display apparatus 1 as an electro-optic apparatus comprises a data line-driving circuit 11, a scanning line-driving circuit 12, a power supply line-controlling circuit 13 and a TFT substrate for current control 100 (hereinafter occasionally abbreviated as "TFT substrate 100"). On the TFT substrate 100, m (row; m is a natural number) × n (line; n is a natural number) pixels 10 are arranged in a matrix.

The data line-driving circuit 11 is connected with each pixel 10 through a first data line 111, a second data line 112,... and the mth data line 113. For example, the data line-driving circuit 11 is connected in parallel with n pieces of pixel 10 arranged in the mth row through the mth data line 113. This data line-driving circuit 11 outputs a data signal to each pixel 10.

The scanning line-driving circuit 12 is connected with each pixel 10 through a first scanning line 121, a second scanning line 122,... and the mth scanning line 123. For example, the scanning line-driving circuit 12 is connected in parallel with m pieces of pixel 10 arranged in the nth line through the nth scanning line 123. This scanning line-driving circuit 12 outputs a scanning signal to each pixel 10.

Furthermore, the power supply line-controlling circuit 13 is connected with each pixel 10 through a first EL-driving line 131, a second EL driving line 132,...and the mth EL driving line 133. For example, the power supply line-controlling circuit 13 is connected in parallel with n pieces of pixel 10 arranged in the mth row through the mth EL-driving line 133. This power supply line-controlling circuit 13 supplies driving current to each pixel 10.

Next, the structure of the pixel 10 is explained with reference to the drawing.

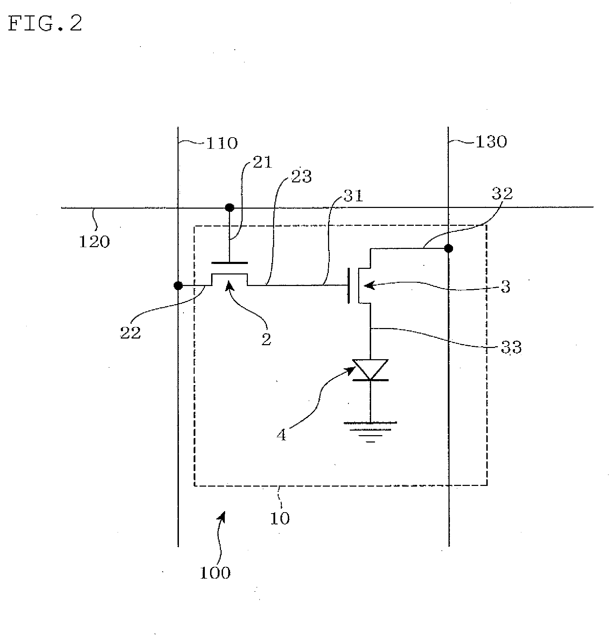

FIG. 2 is a schematic block diagram for explaining the structure of a pixel of the organic EL display apparatus according to the first embodiment of the invention.
In FIG. 2, the pixel 10 has a switching transistor 2, a driving transistor 3 and an organic EL device 4. The switching transistor 2 and the driving transistor 3 are formed on a TFT substrate 100 as a thin film transistor.
The switching transistor 2 is connected with a scanning line 120 through a gate line 21. In addition, the switching transistor 2 is connected with a data line 110 through a source line 22. A drain line 23 of the switching transistor 2 is connected with a gate line 31 of the driving transistor 3. The driving transistor 3 is connected with an EL-driving line 130 through a source line 32. The driving transistor 3 is connected with the organic EL device 4 through a drain line 33.

In the TFT substrate 100 having the above-mentioned structure, when a gate signal (a scanning signal) of the switching transistor 2 is input from the scanning line 120, the switching transistor 2 turns to the ON-state. Subsequently, when a data signal (a gate voltage of the driving transistor 3) is applied to a gate electrode 34 of the driving transistor 3 from the data line 110, the driving transistor 3 turns to ON-state. A source-drain resistance value of the driving transistor 3 is determined according to this gate voltage, and driving current is supplied from the EL-driving line 130 to the organic driving device 4 according to the data signal. The organic EL device 4 emits light having a luminance according to this driving current.
The active matrix configuration in this embodiment is a basic configuration, but the invention is not limited thereto. For example, a capacitor or other devices may be provided to keep the ON-state of the driving transistor 3.

In addition, in the organic EL display apparatus 1 of the invention, the active layer of the driving transistor 3 is an n-type oxide semiconductor layer 371 as an oxide semiconductor layer. By doing this, as compared with a TFT substrate in which amorphous Si or a polysilicon semiconductor is used in an active layer of the driving transistor 3, the driving transistor 3 suffers only a small degree of deterioration in performance even though a large amount of current is flown or a large amount of power is input to the driving transistor 3. As a result, the organic EL display apparatus 1 is improved in stability and the durability of the TFT substrate 100 is improved, resulting in a significantly prolonged life of the organic EL display apparatus 1.
Next, the production method and configuration of the TFT substrate 100 are explained with reference to the drawing. First, the production method of the TFT substrate 100 is explained.

### [First embodiment of the method for producing a TFT substrate for current control]

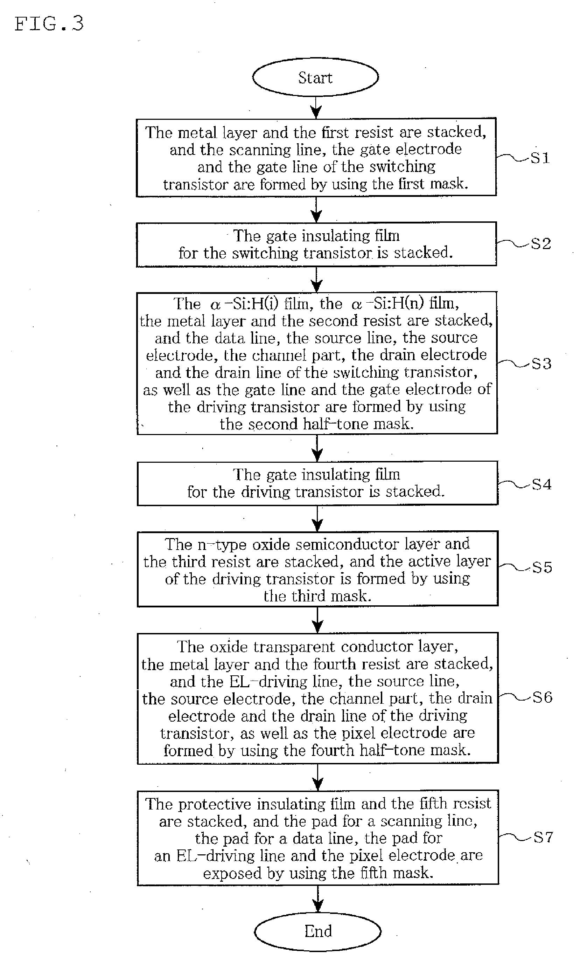

FIG. 3 is a schematic flow chart for explaining a method for producing a TFT substrate to be used in the organic EL display apparatus according to the first embodiment of the invention. In the meantime, the production method of this embodiment corresponds to claim 16.
In FIG. 3, a metal layer 210 and a first resist 211 are stacked in this order on a substrate, and the scanning line 120 and a gate electrode 24 and a gate line 21 of the switching transistor 2 are formed by using a first mask 212 (Step S1).
Next, a treatment by using the first mask 212 is explained with reference to the drawing.

### (Treatment by using a first mask)

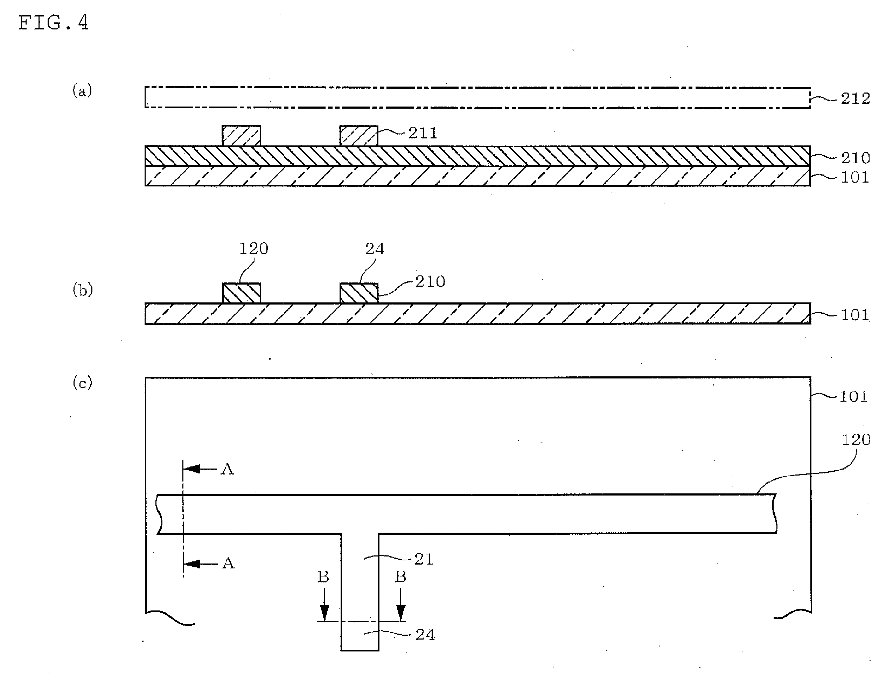

FIG. 4 is a schematic view for explaining a treatment by using the first mask in the method for producing a TFT substrate to be used in the organic EL display apparatus according to the first embodiment of the invention, in which (a) is a cross-sectional view after the formation of a metal layer/after the application of a first resist/after exposure/after development; (b) is a cross-sectional view after first etching/after the peeling off the first resist; and (c) is a plan view of an essential part of the TFT substrate after the peeling off the first resist.
In FIG. 4 (a), first, a light-transmissive glass substrate 101 is provided.
A plate-like element to be used as the TFT substrate 100 is not limited to the above-mentioned glass substrate 101. For example, a plate- or sheet-like element made of a resin may be used. Usable resins include polyacrylic resins, polystyrene resins, polycarbonate resins and polyarylate resins. Heat-resistant resins such as polycarbonate resins and polyarylate resins are preferable. The substrate is not limited to a light-transmissive substrate. For example, a light-shielding or semitransparent substrate may be used.

First, the metal layer 210 as a conductor layer for forming the scanning line 120, the gate electrode 24 and the gate line 21 is formed on the glass substrate 101. First, by using the high-frequency sputtering method, Al (aluminum) is stacked in a film thickness of about 250 nm. Subsequently, Mo (molybdenum) is stacked in a film thickness of about 50 nm. As a metal other than Mo, Ti (titanium), Cr (chromium) or other metals can be used.
As the gate line 21, a thin film of a metal such as Ag (silver) and Cu (copper) or a thin film of an alloy may be used. However, Al-based film is preferable. Although Al may be pure Al, Al to which a metal such as Nd (neodymium), Ce (cerium), Mo, W (tungsten) and Nb (niobium) is added may be used. Ce, W, Nb or the like are preferable to suppress a cell reaction with a transparent conductor layer. Although the amount can be selected appropriately, about 0.1 to 2 wt% is preferable.

Then, on the metal layer 210, the first resist 211 is applied. The first resist 211 is formed into a predetermined shape by photolithography by using the first mask 212.

Then, as shown in FIG. 4(b), the metal layer 210 is subjected to first etching by using an etching solution composed of phosphoric acid, acetic acid, nitric acid and water (volume ratio: about 9:8:1:2. This etching solution is occasionally abbreviated as an acid mixture etching solution), thereby forming the scanning line 120, the gate line 21 and the gate electrode 24 (Step S1).
Next, the first resist 211 is removed through an ashing process. Then, as shown in FIG. 4(c), the scanning line 120, as well as the gate line 21 and the gate electrode 24 connected with the scanning line 120 are exposed on the glass substrate 101. The scanning line 120 shown in FIG. 4(b) is a cross-sectional view taken along line A-A in FIG. 4(c). The gate electrode 24 shown in FIG. 4 (b) is a cross-sectional view taken along line B-B in FIG. 4(c).

Then, as shown in FIG. 3, a gate insulating film 20 is stacked by the glow discharge CVD (Chemical Vapor Deposition) method on the glass substrate 101, the scanning line 120, the gate line 21 and the gate electrode 24 (Step S2). The gate insulating film 20 is a silicon nitride (SiNₓ) film, and has a thickness of about 300 nm. This gate insulating film 20 is formed as a gate insulating film 20 for the switching transistor 2. In this embodiment, an SiH₄-NH₃-N₂-based mixed gas is used as a discharge gas.

Then, as shown in FIG. 3, an α-Si:H(i) film 271, an α-Si:H (n) film 272, a metal layer 273 as a conductor layer and a second resist 274 are stacked, and by using a second half-tone mask 275, the data line 110, a source line 22, a source electrode 25, a channel part 27, a drain electrode 26 and a drain line 23 of the switching transistor 2, as well as a gate line 31 and a gate electrode 34 of the driving transistor 3 are formed (Step S3).
Next, a treatment by using the second half-tone mask 275 is explained with reference to the drawing.

### (Treatment by using a second half-tone mask)

FIG. 5 is a schematic view for explaining a treatment by using a second half-tone mask in the method for producing a TFT substrate to be used in the organic EL display apparatus according to the first embodiment of the invention, in which (a) is a cross-sectional view after the formation of a gate insulating film/after the formation of an α-Si:H(i) film/after the formation of an α-Si:H(n) film/after the formation of the metal layer/after the application of a second resist/after half-tone exposure/after development; (b) is a cross-sectional view after the second etching/after the reformation of the second resist; and (c) is a cross-sectional view after third etching/after the peeling off the second resist.
In FIG. 5(a), first, an α-Si:H(i) film 271 is stacked on the gate insulating film 20. The α-Si:H(i) film 271 is an insulating layer of amorphous Si (silicon) and has a thickness of about 350 nm. An SiH₄-N₂-based mixed gas is used as a discharge gas at this time.
Subsequently, by using a mixed gas based on SiH₄-H₂-PH₃, an α-Si:H(n) film 272 is stacked. The α-Si:H(n) film 272 is an n-type semiconductor layer of amorphous Si, and has a thickness of about 300 nm.
Then, a metal layer 273 composed of an Mo layer/an Al layer/an Mo layer is formed. Specifically, Mo, Al and Mo are stacked in this order by using the high-frequency sputtering method in a thickness of about 50 nm, about 250 nm and about 50 nm, respectively. In the meantime, the Mo layer of the metal layer 273 functions as a barrier metal layer to protect the Al layer. In this embodiment, amorphous Si is used as an active layer of the switching transistor 2. The material of the active layer of the switching transistor 2 is, however, not limited to amorphous Si. Polycrystalline Si may be used, for example.

Then, a second resist 274 is applied on the metal layer 273. The second resist 274 is formed into a predetermined shape by half-tone exposure by using the second half-tone mask 275. That is, the second resist 274 is formed into such a shape that it covers the data line 110, the source line 22, the source electrode 25, the gate electrode 24, the drain electrode 26 and the drain line 23 of the switching transistor 2, and the gate line 31 and the gate electrode 34 of the driving transistor 3. In addition, by using a half-tone mask part 276, the second resist 274 is formed into such a shape that the part thereof covering the channel part 27 is thinner than other parts.

Subsequently, as shown in FIG. 5(b), as the the second etching, the metal layer 273 is patterned with an etching method by using the second resist 274 and an acid mixture etching solution. Then, the α-Si:H (n) film 272 and the α-Si:H(i) film 271 are patterned with a dry etching method using a CHF gas and a wet etching method using an aqueous hydrazine solution (NH₂NH₂·H₂O), whereby the data line 110, the source line 22, the drain line 23, the gate line 31 and the gate electrode 34 are formed.

Subsequently, the second resist 274 is removed through an ashing process, whereby the second resist 274 is reformed. When the second resist 274 is reformed, the metal layer 273 above the channel part 27 is exposed, and the data line 110, the source line 22, the source electrode 25, the drain electrode 26 and the drain line 23 of the switching transistor 2, and the gate line 31 and the gate electrode 34 of the driving transistor 3 are covered by the reformed second resist 274.

Subsequently, as shown in FIG. 5(c), as the third etching, the metal layer 273 is patterned with an etching method by using the reformed second resist 274 and the acid mixture etching solution, whereby the source electrode 25 and the drain electrode 26 are formed. Then, the α-Si:H(n) film 272 is patterned with a dry etching method using a CHF gas and a wet etching method using an aqueous hydrazine solution (NH₂NH₂·H₂O). As a result, the channel part 27 composed of the α-Si:H(i) film 271 is formed. That is, the channel part 27 and the source electrode 25 and the drain electrode 26 of the switching transistor 2 are formed (Step S3).

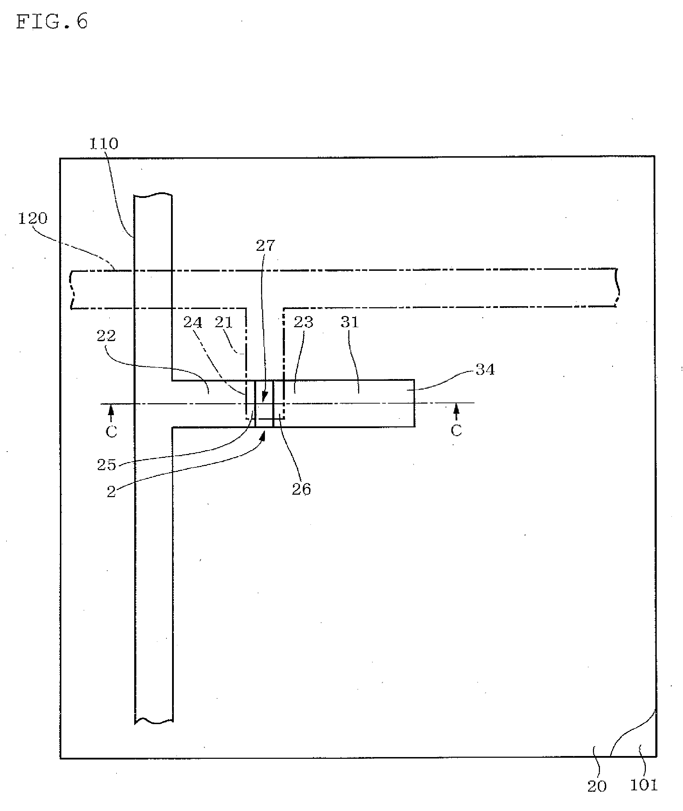

Then, the reformed second resist 274 is removed through an ashing process. As a result, as shown in FIG. 5 (c), the data line 110, the source line 22, the source electrode 25, the channel part 27, the drain electrode 26 and the drain line 23 of the switching transistor 2, and the gate line 31 and the gate electrode 34 of the driving transistor 3 are exposed on the gate insulating film 20. The data line 110, the source line 22, the drain electrode 25, the source electrode 24, the channel part 27, the drain electrode 26 and the drain line 23 of the switching transistor 2, and the gate line 31 and the gate electrode 34 of the driving transistor 3 in FIG. 5(c) are cross-sectional views taken along line C-C in FIG. 6.

Then, as shown in FIG. 3, a gate insulating film 30 is stacked by the glow discharge CVD (Chemical Vapor Deposition) method on the glass substrate 101. The gate insulating film 30 is a silicon nitride (SiNₓ) film, and has a thickness of about 300 nm. This gate insulating film 30 is formed as a gate insulating film 30 for the driving transistor 3. In this embodiment, an SiH₄-NH₃-N₂-based mixed gas is used as a discharge gas.

Then, as shown in FIG. 3, on the gate insulating film 30, an n-type oxide semiconductor layer 371 as an oxide semiconductor layer and a third resist 372 are stacked, and an active layer of the driving transistor 3 is formed by using a third mask 373 (Step S5).
Next, a treatment by using the third mask 373 is explained with reference to the drawing.

### (Treatment by using a third mask)

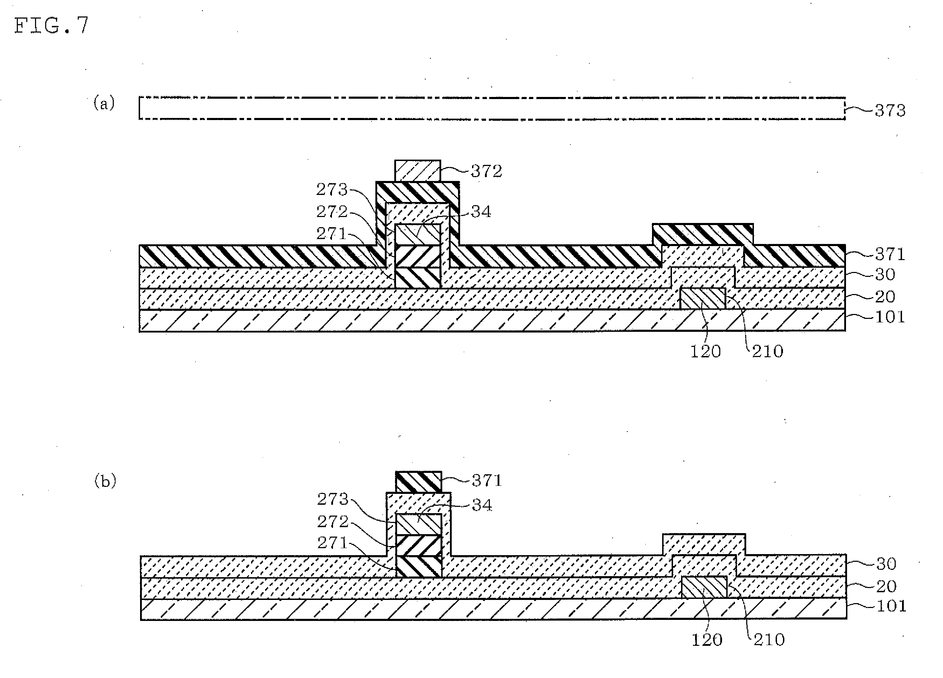

FIG. 7 is a schematic view for explaining a treatment by using a third mask in the method for producing a TFT substrate to be used in the organic EL display apparatus according to the first embodiment of the invention, in which (a) is a cross-sectional view after the formation of a gate insulating film/after the formation of an n-type oxide semiconductor layer/after the application of a third resist/after exposure/after development; and (b) is a cross-sectional view after fourth etching/after the peeling off the third resist.
In FIG. 7, an n-type oxide semiconductor layer 371 with a thickness of about 150 nm is formed on the gate insulating film 30 by using an indium oxide-zinc oxide (In₂O₃:ZnO=about 97:3 wt%) target. This layer formation is conducted under the condition of an oxygen-to-argon ratio of about 10: 90 (vol%) and a substrate temperature of about less than 100°C. Under this condition, the n-type oxide conductor layer 371 is obtained as an amorphous film. Meanwhile, the n-type oxide semiconductor layer 371 is obtained as an amorphous film when formed at a low temperature of about 200°C or lower, and is obtained as a crystallized film when formed at a high temperature exceeding about 200°C. An amorphous film can be crystallized by heat treatment. In this embodiment, the n-type oxide semiconductor layer 371 is used after crystallization.

The n-type oxide semiconductor layer 371 is not limited to an oxide semiconductor layer formed of the above-mentioned indium oxide-zinc oxide, for example, an oxide semiconductor layer based on indium oxide-gallium oxide-zinc oxide or an oxide semiconductor layer formed of indium oxide-samarium oxide, zinc oxide-magnesium oxide or the like may also be used.
In this embodiment, the carrier density of the indium oxide-zinc oxide thin film was about 10⁺¹⁶ cm⁻³ or less, which was in a range allowing the film to function satisfactorily as a semiconductor. Usually, as long as the carrier density is less than about 10⁺¹⁷ cm⁻³, the film functions satisfactorily as a semiconductor. In addition, the hole mobility was about 25 cm²/V·sec, which is approximately 10 times as large as that of amorphous silicon. In view of the above, the indium oxide-zinc oxide thin film according to this embodiment is a satisfactorily effective semiconductor thin film. Generally, it is preferred that an oxide semiconductor have a hole mobility of about 10 cm²/V·sec or more, more preferably about 50 cm²/V·sec or more. By using an oxide semiconductor having a higher mobility than that of amorphous Si, heat generation or a decrease in response speed due to input of a large amount of electric current can be avoided, leading to stable driving.

In addition, since the n-type oxide semiconductor layer 371 is required to be transparent, an oxide, whose energy gap is about 3.0 eV or more, may be used. The energy gap may preferably be about 3.2 eV or more, more preferably about 3.4 eV or more. The energy gap of the above-mentioned n-type oxide semiconductor layer based on indium oxide-zinc oxide, an n-type oxide semiconductor layer based on indium oxide-gallium oxide-zinc oxide or an n-type oxide semiconductor layer formed of indium oxide-samarium oxide, zinc oxide-magnesium oxide or the like is about 3.2 eV or more, and therefore, these n-type oxide semiconductor layers may be used preferably.
Although the n-type oxide semiconductor layer 371 can be dissolved in an aqueous oxalic acid solution or an acid mixture composed of phosphoric acid, acetic acid and nitric acid (occasionally abbreviated as an "acid mixture") when it is amorphous, they become insoluble in and resistant to an aqueous oxalic acid solution or an acid mixture when crystallized by heating. The crystallization temperature can be controlled according to the amount of zinc oxide to be added.

Subsequently, on the n-type oxide semiconductor layer 371, a third resist 372 is applied. By using a third mask 373 and exposure technology, the third resist 372 is formed above the gate electrode 34.

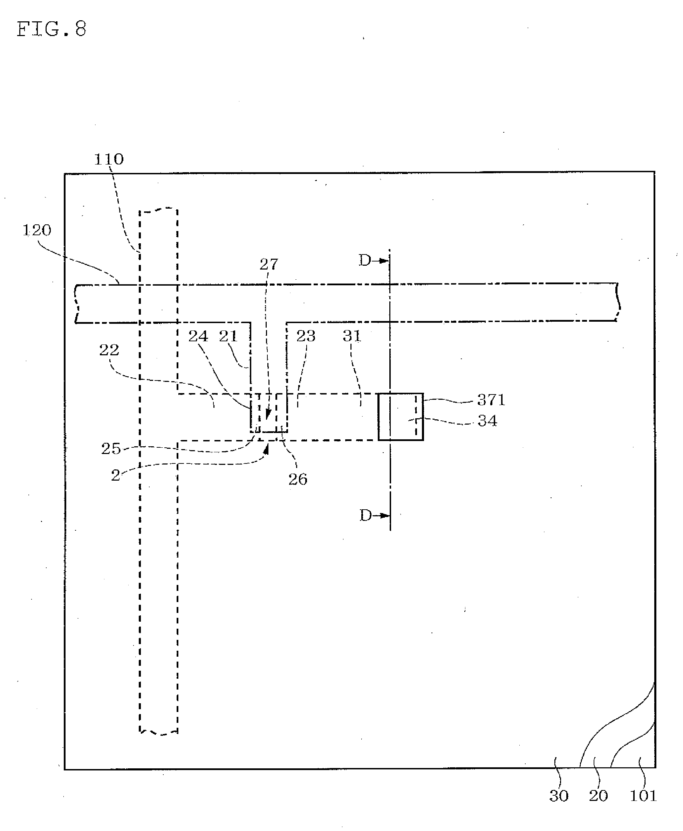

Then, as shown in FIG. 7 (b), as fourth etching, the n-type oxide semiconductor layer 371 is patterned with an etching method by using the third resist 372 and an aqueous oxalic acid solution, whereby an active layer, composed of the n-type semiconductor layer 371, of the driving transistor 3 is formed. Subsequently, the third resist 372 is removed through an ashing process to expose the n-type oxide semiconductor layer 371. The gate electrode 34 and the n-type oxide semiconductor layer 371 shown in FIG. 7(b) are the cross-sectional views taken along line D-D in FIG. 8.
In this embodiment, for convenience of understanding, the drain line 23, the gate line 31 and the gate electrode 34 are connected, and the n-type oxide semiconductor layer 371 is formed above the gate electrode 34. The configuration is, however, not limited thereto. For example, the n-type oxide semiconductor layer 371 may be formed above the drain electrode 26 of the switching transistor 2. In addition, when the n-type oxide semiconductor layer 371 is formed, the TFT substrate 100 is heat-treated at a temperature of about 180°C or higher, whereby the active layer of the n-type oxide semiconductor layer 371 is crystallized. A heat treatment temperature of about 150°C or higher may be satisfactory, but it is preferable to conduct heat treatment at a temperature of about 200°C or higher. The heat treatment temperature is required to be a temperature which does not cause the glass substrate 100 or a resin substrate to be deformed.

Then, as shown in FIG. 3, the oxide transparent conductor layer 374 as an oxide conductor layer, the metal layer 375 as an auxiliary conductor layer (auxiliary metal layer) and the fourth resist 376 are stacked. Then, by using a fourth half-tone mask 377, the EL-driving line 130, the source line 32, the source electrode 35, the channel part 37, the drain electrode 36 and the drain line 33 of the driving transistor 3, as well as the pixel electrode 38 are formed (Step S6).
Next, a treatment by using the fourth half-tone mask 377 is explained with reference to the drawing.

### (Treatment by using a fourth half-tone mask)

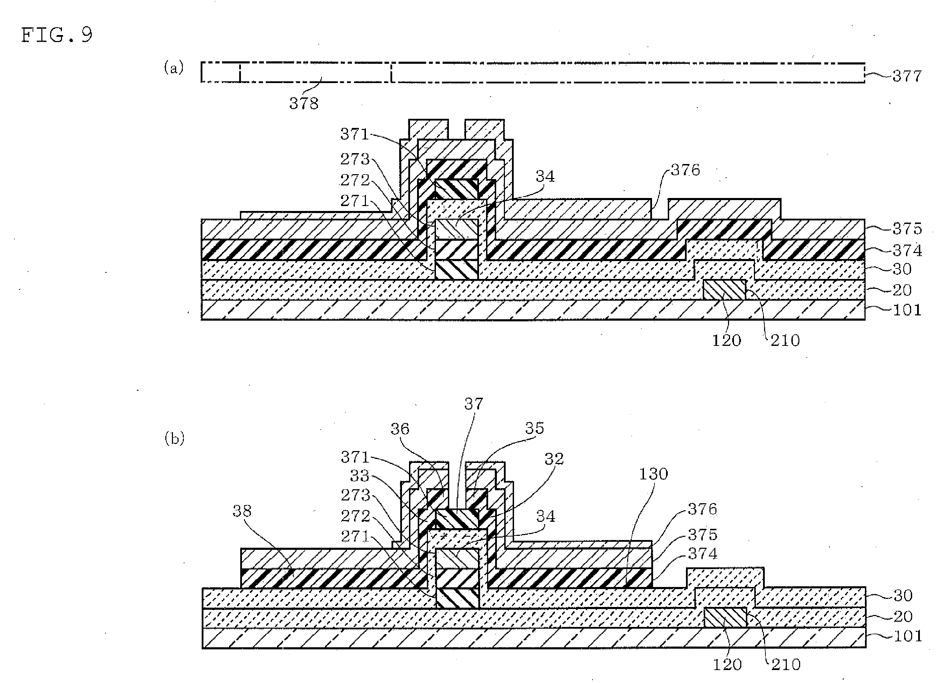

FIG. 9 is a schematic view for explaining a treatment by using a fourth half-tone mask in the method for producing a TFT substrate to be used in the organic EL display apparatus according to the first embodiment of the invention, in which (a) is a cross-sectional view after the formation of an oxide transparent conductor layer/after the formation of the metal layer/after the application of a fourth resist/after half-tone exposure/after development; and (b) is a cross-sectional view after the fifth etching/after the reformation of the fourth resist.
In FIG. 9(a), on the gate insulating film 30 and the n-type oxide semiconductor layer 371, which are exposed, an oxide transparent conductor layer 374 is formed into a film having a thickness of about 120 nm by using an indium oxide-tin oxide-zinc oxide (In₂O₃:SnO₂:ZnO=about 60:20:20 wt%) target by the high-frequency sputtering method. This layer formation is conducted under the condition of an oxygen-to-argon ratio of about 1:99 (vol%) and a substrate temperature which does not cause the oxide transparent conductor layer 374 to be crystallized.

The oxide transparent conductor layer 374 composed of the above-mentioned indium oxide-tin oxide-zinc oxide is dissolved in an aqueous oxalic acid solution but is not dissolved in an acid mixture, though it is amorphous. Therefore, the oxide transparent conductor layer 374 is advantageous. In this case, the oxide transparent conductor layer 374 may contain tin oxide in an amount of about 10 to 40 wt%, zinc oxide in an amount of about 10 to 40 wt% and indium oxide in an amount that makes up the remainder. If each of tin oxide and zinc oxide is contained in an amount of less than about 10 wt%, the oxide transparent conductor layer 374 may lose resistance to an acid mixture, and as a result, it is dissolved in an acid mixture. If the amount of tin oxide exceeds approximately 40 wt%, the oxide transparent conductor layer 374 may not be dissolved in an aqueous oxalic acid solution or may have a high specific resistance. Furthermore, if the amount of zinc oxide exceeds approximately 40 wt%, the oxide transparent conductor layer 374 may lose resistance to an acid mixture. The amount ratio of tin oxide and zinc oxide may be selected appropriately.

Furthermore, the oxide transparent conductor layer 374 is not limited to the indium oxide-tin oxide-zinc oxide-based transparent conductive film used in this embodiment. If the transparent conductive film is etched with an aqueous oxalic acid solution and is not dissolved in an acid mixture, this transparent conductive film can be used as the oxide transparent conductor layer 374.
Here, a transparent conductive film which is dissolved in an aqueous oxalic acid solution or an acid mixture is assumed to be present. The film condition of this transparent conductive film is changed. For example, the transparent conductive film is crystallized by heating. If the transparent conductive film becomes insoluble in an acid mixture by such a change in film condition, this film then becomes usable. Examples of such a transparent conductive film include those obtained by incorporating tin oxide, germanium oxide, zirconium oxide, tungsten oxide, molybdenum oxide or an oxide containing a lanthanoide-based element such as cerium oxide into indium oxide. Of these, combination of indium oxide with tin oxide,combination of indium oxide with tungsten oxide, and combination of indium oxide with an oxide containing a lanthanoide-based element such as cerium oxide may preferably be used. The amount of the metal to be added is about 1 to 20 wt%, preferably about 3 to 15 wt%. If the amount of the metal added is less than about 1 wt%, the transparent conductive film may not be used preferably since it is crystallized during film formation, and as a result, is not dissolved in an aqueous oxalic acid solution or has a large specific resistance. If the amount exceeds about 20 wt%, even though an attempt is made to change the film condition, for example, crystallization by heating, the film condition is not changed, and as a result, the transparent conductive film is dissolved in an acid mixture, leading to difficulty in formation of the pixel electrode 38 or other problems.

Subsequently, the metal layer 375 as an auxiliary conductor layer is formed. This metal layer 375 is composed of an Mo layer/an Al layer/an Mo layer. Specifically, Mo, Al and Mo are stacked in this order by using the high-frequency sputtering method in a thickness of about 50 nm, about 250 nm and about 50 nm, respectively.
Subsequently, a fourth resist 376 is applied on the metal layer 375. The fourth resist 376 is formed into a predetermined shape by half-tone exposure by using a fourth half-tone mask 377. That is, the fourth resist 376 is formed into such a shape that covers the EL-driving line 130, the source line 32, the source electrode 35, the drain electrode 36 and the drain line 33 of the driving transistor 3 and the pixel electrode 38. In addition, by a half-tone mask part 378, the fourth resist 376 is formed into such a shape that the part thereof covering the pixel electrode 38 is thinner than other parts.

Then, as shown in FIG. 9(b), as the fifth etching, the metal layer 375 is patterned with an etching method by using the fourth resist 376 and an acid mixture etching solution. Subsequently, by using the fourth resist 376 and an aqueous oxalic acid solution, the oxide transparent conductor layer 374 is patterned with an etching method, whereby the EL-driving line 130, the source line 32, the source electrode 35, the channel part 37, the drain electrode 36 and the source line 32 of the driving transistor 3, as well as the pixel electrode 38 are formed (Step S6).

Subsequently, the above-mentioned fourth resist 376 is removed through an ashing process, and the fourth resist 376 is reformed. When the fourth resist 376 is reformed, the metal layer 375 above the pixel electrode 38 is exposed, and the EL-driving line 130, the source line 32, the source electrode 35, the drain electrode 36 and the drain line 33 of the driving transistor 3 are covered by the reformed fourth resist 376.
In the meantime, the fourth half-tone mask 377 is used since the metal layer 375 is stacked as an auxiliary metal layer. However, if the metal layer 375 is not stacked, a fourth mask can be used.

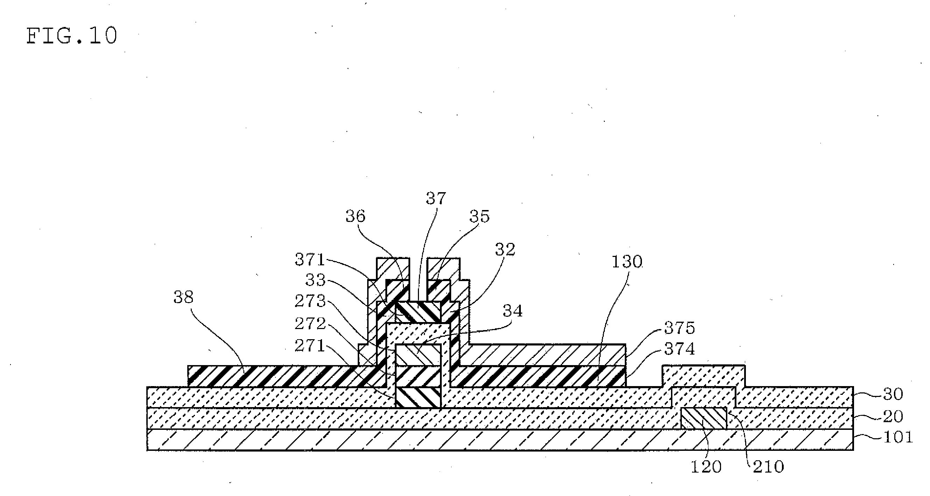

FIG. 10 is a schematic view for explaining a treatment by using a fourth half-tone mask in the method for producing a TFT substrate to be used in the organic EL display apparatus according to the first embodiment of the invention, showing a cross-sectional view after the sixth etching/after the peeling off the fourth resist.
In FIG. 10, the metal layer 375 is patterned with a sixth etching method by using the reformed fourth resist 376 and an acid mixture etching solution to expose the pixel electrode 38. In the meantime, if the organic EL display apparatus 1 has a top-emission structure, the metal layer 375 above the pixel electrode 38 is not necessarily removed. Accordingly, the fourth mask can be used instead of the fourth half-tone mask 377.

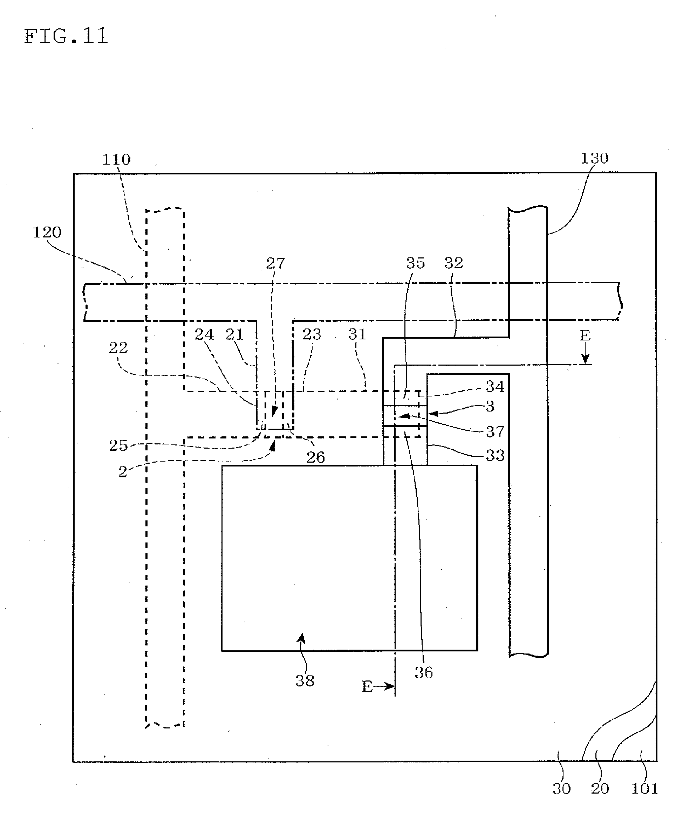

Subsequently, the reformed fourth resist 376 is removed through an ashing process. As a result, as shown in FIG. 10, the EL-driving line 130, the source line 32, the source electrode 35, the gate electrode 34, the channel part 37, the drain electrode 36, the drain line 33 of the driving transistor 3 and the pixel electrode 38 are exposed on the gate insulating film 30. The EL-driving line 130, the source line 32, the source electrode 35, the gate electrode 34, the channel part 37, the drain electrode 36, the drain line 33 of the driving transistor 3 and the pixel electrode 38 in FIG. 10 are cross-sectional views taken along line E-E in FIG. 11.

Then, as shown in FIG. 3, a protective insulating film 40 and a fifth resist 41 are stacked, and a pad for a scanning line 124, a pad for a data line 114, a pad for an EL-driving line 134 and the pixel electrode 38 are exposed by a fifth mask (Step S7).
Next, a treatment by using the fifth mask 42 is explained with reference to the drawing.

### (Treatment by using a fifth mask)

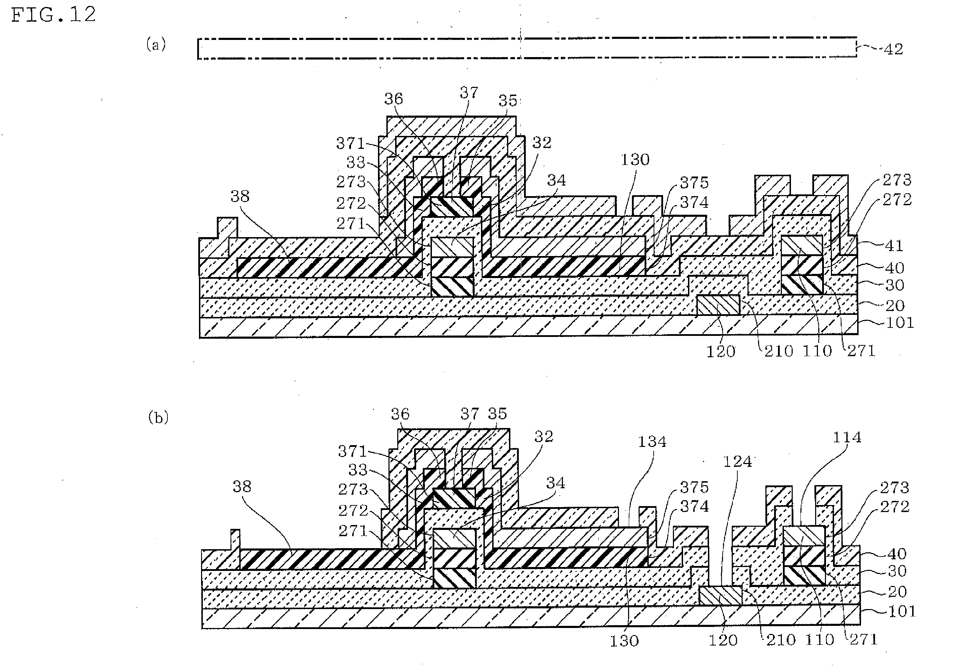

FIG. 12 is a schematic view for explaining a treatment by using a fifth mask in the method for producing a TFT substrate to be used in the organic EL display apparatus according to the first embodiment of the invention, in which (a) is a cross-sectional view after the formation of a protective insulating film/after the application of a fifth resist/after exposure/after development, and (b) is a cross-sectional view after the seventh etching/after the peeling off the fifth resist.
In FIG. 12(a), the protective insulating film 40, which is a silicon nitride (SiNₓ) film, is stacked in a film thickness of about 250 nm by the glow discharge CVD (Chemical Vapor Deposition) method above the glass substrate 101. In this embodiment, an SiH₄-NH₃-N₂-based mixed gas is used as a discharge gas.

Then, a fifth resist 41 is applied on the protective insulating film 40. By using the fifth mask 42 and by exposure technology, the fifth resist 41 having openings above the pixel electrode 38, the pad for a data line 114, the pad for a scanning line 124 and the pad for an EL-driving line 134 is formed.
Subsequently, as the seventh etching, the protective insulating film 40, the gate insulating film 30 and the gate insulating film 20 are patterned with a dry etching method by using an etching gas (CHF (CF₄, CHF₃ gas, or the like)) to expose the pixel electrode 38, the pad for a data line 114, the pad for a scanning line 124 and the pad for an EL-driving line 134 (Step S7).

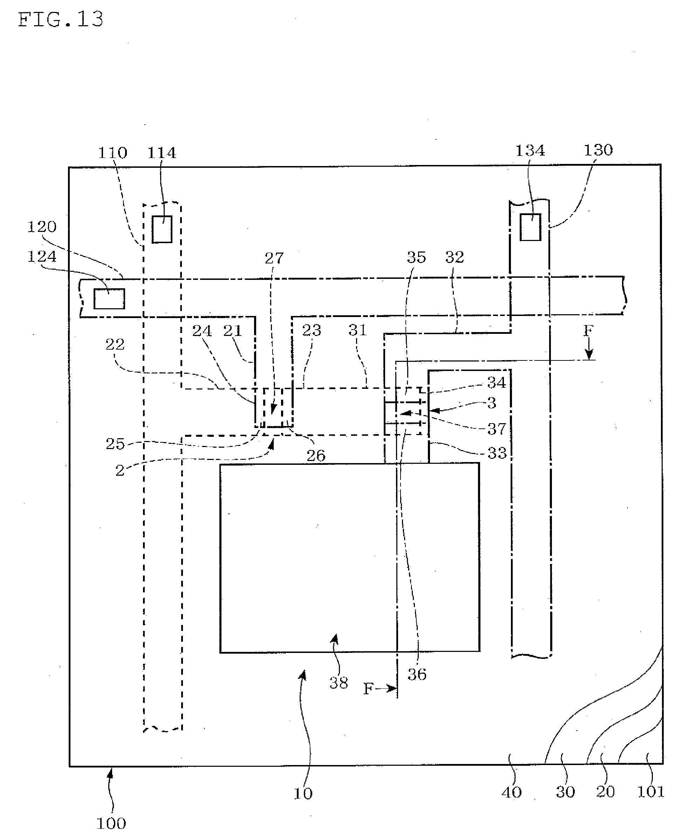

Subsequently, the fifth resist 41 is removed through an ashing process. As a result, as shown in FIG. 12(b), the protective insulating film 40 is exposed. The pixel electrode 38, and the source line 32, the source electrode 35, the gate electrode 34, the channel part 37, the drain electrode 36 and the drain line 33 of the driving transistor 3 shown in FIG. 12(b) are cross-sectional views taken along line F-F in FIG. 13.
In the meantime, in this embodiment, the positions or the shapes of the switching transistor 2, the driving transistor 3 and the pixel electrode 38 are the positions or the shapes which are easy to understand. The positions or the shapes are, however, not limited thereto.

As mentioned above, according to the method for producing a TFT substrate for current control in this embodiment, the active layer of the driving transistor 3 is composed of the n-type oxide semiconductor layer 371. Therefore, if a large amount of current is flown or a large amount of power is input to the driving transistor 3, the driving transistor 3 suffers only a small degree of deterioration, and the TFT substrate 100 is improved in stability. Further, the stability of the TFT substrate 100 can be improved. In addition, the EL-driving line 130, the source line 32, the source electrode 35, the channel part 37, the drain electrode 36 and the drain line 33 of the driving transistor 3 and the pixel electrode 38 can be produced by using the fourth half-tone mask 377. As a result, the number of masks used can be reduced. Therefore, production efficiency can be improved and manufacturing cost can be decreased due to the reduction of production steps. Furthermore, since the protective insulating film 40 is formed, the organic EL display apparatus 1 can be obtained easily by providing organic EL materials, electrodes and protective films on the TFT substrate 100.
Next, the configuration of the above-mentioned TFT substrate 100 is explained with reference to the drawing.

### [First embodiment of a TFT substrate for current control]

As shown in FIG. 1, in the TFT substrate 100 of this embodiment, m (row; m is a natural number) × n (line; n is a natural number) pixels 10 are arranged in a matrix on a glass substrate 101.
Furthermore, in the direction of line (horizontal direction), n pieces of the scanning lines 121, 122,...123 are formed. For example, the nth scanning line 123 is connected in parallel with m pieces of the pixel 10 arranged in the nth line.
In addition, in the direction of row (vertical direction), m pieces of the data lines 111, 112, ...113 are formed. For example, the mth deta line 113 is connected in parallel with n pieces of pixel 10 arranged in the mth row.
Furthermore, in the direction of row (vertical direction), m pieces of the scanning lines 131, 132,...133 are formed. For example, the mth EL-driving line 133 is connected in parallel with n pieces of pixel 10 arranged in the mth row.

As shown in FIG. 13, each pixel 10 has the driving transistor 3 which supplies electric current to the organic EL device 4 as an electro-optic device (see FIG. 2) and the switching transistor 2 which controls the driving transistor 3.

As shown in FIGs. 5 and 6, the switching transistor 2 has the gate electrode 24, the gate insulating film 20, the α-Si:H(i) film 271, the α-Si:H (n) film 272, the source electrode 25 and the drain electrode 26.
The gate electrode 24 is connected with the scanning line 120 through the gate line 21. The gate insulating film 20 is formed on the gate electrode 24. The α-Si:H(i) film 271, and the α-Si:H(n) film 272, which are active layers, are formed on the gate insulating film 20. The source electrode 25 is connected with the data line 110 through the source line 22. The drain electrode 26 is connected with the gate electrode 34 of the driving transistor 3 through the drain line 23 and the gate line 31.

As shown in FIGs. 10 and 11, the driving transistor 3 has the gate electrode 34, the gate insulating film 30, the n-type oxide semiconductor layer 371, the source electrode 35 and the drain electrode 36.
The gate insulating film 30 is formed on the gate electrode 34. The n-type oxide semiconductor layer 371 as an active layer is formed on the gate insulating film 30. The source electrode 35 is connected with the EL-driving line 130 through the source line 32. The drain electrode 36 is connected with the pixel electrode 38 through the drain line 33.

Furthermore, the source line 32, the source electrode 35, the drain electrode 36 and the drain line 33 of the driving transistor 3 are composed of the oxide transparent conductor layer 374. Furthermore, this oxide transparent conductor layer 374 functions as the pixel electrode 38 of the organic EL device 4. Due to such a configuration, the number of masks used in the production can be reduced and production steps can be decreased. As a result, production efficiency can be improved and manufacturing cost can be decreased.

Furthermore, it is preferred that the metal layer 375 as an auxiliary conductor layer be formed above the EL-driving line 130, the source line 32, the source electrode 35, the drain electrode 36 and the drain line 33. By doing this, the electric resistance of each line and each electrode can be decreased. As a result, reliability can be improved and a decrease in energy efficiency can be suppressed.

As mentioned above, in the TFT substrate 100 of this embodiment, the active layer of the driving transistor 3 is composed of the n-type oxide semiconductor layer 371. Therefore, the driving transistor 3 suffers only a small degree of deterioration in performance even though a large amount of current is flown or a large amount of power is input to the driving transistor 3. Therefore, the TFT substrate 100 is improved in stability. Furthermore, the durability of the TFT substrate 100 can be improved.
The first embodiment of the organic EL display apparatus, the first embodiment of the method for producing the TFT substrate for current control and the first embodiment of the TFT substrate for current control have various application examples. For example, although the α-Si:H(i) film 271 is used as an active layer of the switching transistor 2 in each of the above-mentioned embodiments, an oxide semiconductor layer may be used instead of the α-Si:H(i) film 271.
Next, an application example of the method for producing a TFT substrate for current control in which an oxide semiconductor layer is used instead of the α-Si:H(i) film 271 is explained with reference to the drawing.

### [Application example of a TFT substrate for current control]

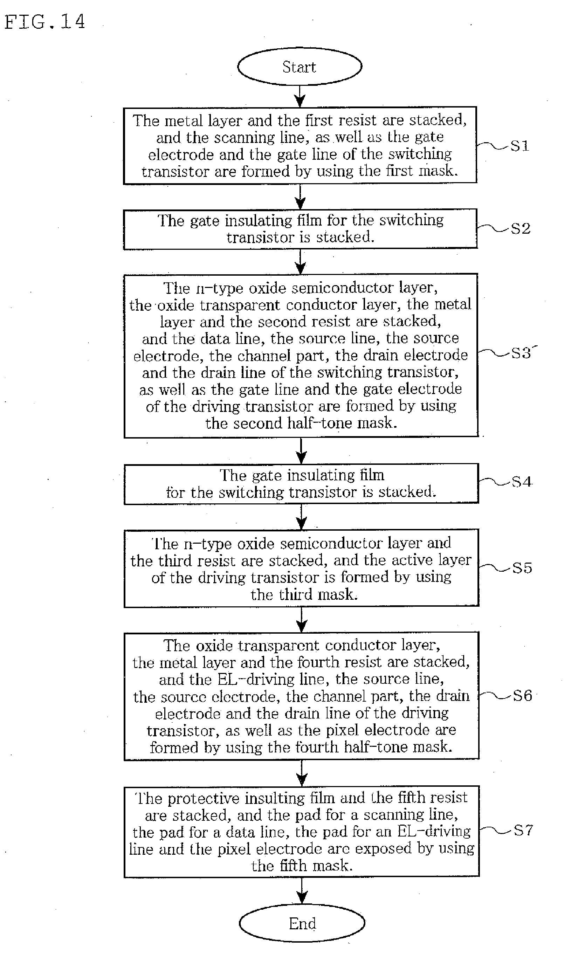

FIG. 14 is a schematic flow chart for explaining the method for producing a TFT substrate to be used in an organic EL display apparatus according to an application example of the first embodiment of the invention. In the meantime, the production method in this application example corresponds to claim 16.
In FIG. 14, the method for producing the TFT substrate according to this application example differs from the above-mentioned method according to the first embodiment in the following points. Specifically, the step S3 (see FIG. 3) is changed as follows. An n-type oxide semiconductor layer 271', an oxide transparent conductor layer 272' , the metal layer 273 and the second resist 274 are stacked in this order, and by using a second half-tone mask 275, a data line 110', a source line 22', a source electrode 25', a channel part 27', a drain electrode 26' and a drain line 23' of a switching transistor 2', as well as a gate line 31' and a gate electrode 34' of the driving transistor 3 are formed (Step S3'). That is, the method shown in FIG. 14 differs from the above-mentioned first embodiment in this point. Other steps are almost the same as those in the first embodiment.
Therefore, in FIG. 14, the same steps are indicated by the same numerals as used in FIG. 3, and detailed explanation is omitted.
Next, a treatment by using the second half-tone mask 275 is explained with reference to the drawing.

### (Treatment by using a second half-tone mask)

FIG. 15 is a schematic view for explaining a treatment by using the second half-tone mask in the method for producing a TFT substrate to be used in the organic EL display apparatus according to the application example of the first embodiment of the invention, in which (a) is a cross-sectional view after the formation of the gate insulating film/after the formation of the n-type oxide semiconductor layer/after the formation of the oxide transparent conductor layer/after the formation of the metal layer/after the application of the second resist/after half-tone exposure/after development; (b) is a cross-sectional view after the second etching/after the reformation of the second resist; and (c) is a cross-sectional view after the third etching/after the peeling off the second resist.
In FIG. 15(a), an n-type oxide semiconductor layer 271' with a thickness of about 150 nm is formed on the gate insulating film 20 by using an indium oxide-zinc oxide (In₂O₃:ZnO=about 97:3 wt%) target. This layer formation is conducted under the condition of an oxygen-to-argon ratio of about 10:90 (vol%) and a substrate temperature of about less than 100°C. Under this condition, the n-type oxide conductor layer 271' is obtained as an amorphous film.

Next, on the n-type oxide semiconductor layer 271', an oxide transparent conductor layer 272' is formed in a thickness of about 120 nm by using an indium oxide-tin oxide-zinc oxide (In₂O₃:SnO₂:ZnO=about 60:20:20 wt%) target by the high-frequency sputtering method. This layer formation is conducted under the condition of an oxygen-to-argon ratio of about 1:99 (vol%) and a substrate temperature which does not cause the oxide transparent conductor layer 272' to be crystallized. Subsequently, the metal layer 273 is formed. The metal layer 273 as the conductor layer is composed of an Mo layer/an Al layer/an Mo layer. Specifically, Mo, Al and Mo are stacked in this order by using the high-frequency sputtering method in a thickness of about 50 nm, about 250 nm and about 50 nm, respectively. In the meantime, the Mo layer of the metal layer 273 functions as a barrier metal layer to protect the Al layer.

Then, the second resist 274 is applied on the metal layer 273. The second resist 274 is formed into a predetermined shape by half-tone exposure by using the second half-tone mask 275. That is, the second resist 274 is formed into such a shape that it covers the data line 110', the source line 22', the source electrode 25', the gate electrode 24', the drain electrode 26' and the drain line 23' of the switching transistor 2', and the gate line 31' and the gate electrode 34' of the driving transistor 3. In addition, by using a half-tone mask part 276, the second resist 274 is formed into such a shape that the part thereof covering the channel part 27' is thinner than other parts.

Subsequently, as shown in FIG. 15(b), as the second etching, the metal layer 273 is patterned with an etching method by using the second resist 274 and an acid mixture etching solution. Then, the oxide transparent conductor layer 272' and the n-type oxide semiconductor layer 271' are patterned with an etching method by using an aqueous oxalic acid solution, whereby the data line 110', the source line 22' , the drain line 23', the gate line 31' and the gate electrode 34' are formed.
Here, the n-type oxide semiconductor layer 271' is crystallized by heating. As a result, the n-type oxide semiconductor layer 271' has resistance to an acid mixture etching solution or an aqueous oxalic acid solution.

Subsequently, the second resist 274 is removed through an ashing process, whereby the second resist 274 is reformed. The reformed second resist 274 is in such shape that the metal layer 273 above the channel part 27' is exposed. The second resist 274 is in a shape that the data line 110', the source line 22' , the source electrode 25' , the drain electrode 26' and the drain line 23' of the switching transistor 2' , and the gate line 31' and the gate electrode 34' of the driving transistor 3 are covered.

Subsequently, as shown in FIG. 15(c), as the third etching, the metal layer 273 and the oxide transparent conductor layer 272' are patterned with an etching method by using the reformed second resist 274 and an acid mixture etching solution, whereby the channel part 27', the source electrode 25' and the drain electrode 26' are formed (Step S3').

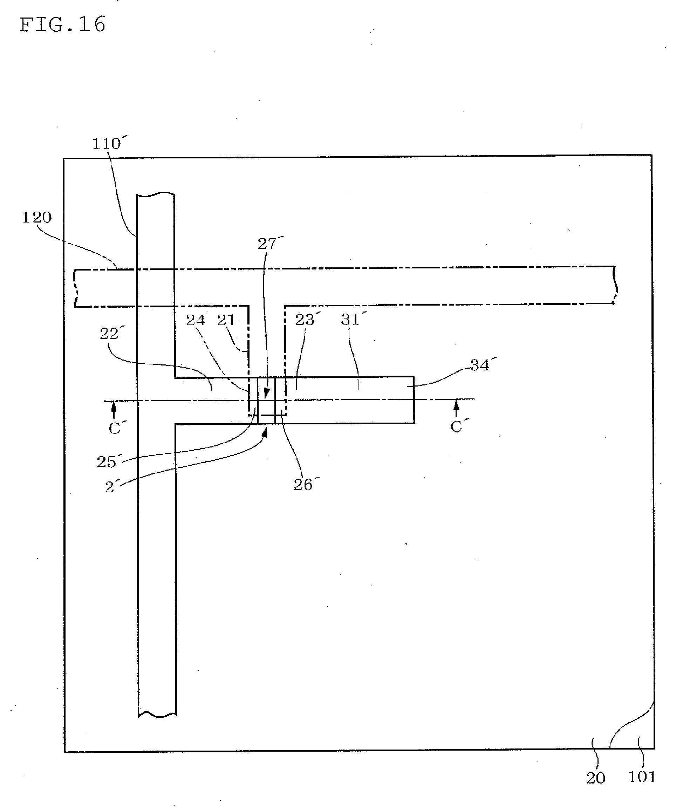

Subsequently, the reformed second resist 274 is removed through an ashing process. As a result, as shown in FIG. 15 (c), the data line 110', the source line 22', the source electrode 25', the gate electrode 24, the channel part 27' , the drain electrode 26' and the drain line 23' of the switching transistor 2', and the gate line 31' and the gate electrode 34' of the driving transistor 3 are exposed on the gate insulating film 20. The data line 110', the source line 22', the source electrode 25', the gate electrode 24, the channel part 27', the drain electrode 26' and the drain line 23' of the switching transistor 2' , and the gate line 31' and the gate electrode 34' of the driving transistor 3 shown in FIG. 15(c) are cross-sectional views taken along line C'-C' in FIG. 16.
Other steps are almost the same as those in the first embodiment.

As mentioned above, according to the method for producing the TFT substrate for current control of this application example, advantageous effects almost similar to those attained in the above-mentioned first embodiment are attained. In addition, since the same material can be used for the n-type oxide semiconductor layer 371 or the oxide transparent conductor layer 374 of the driving transistor 3, manufacturing cost can be reduced.

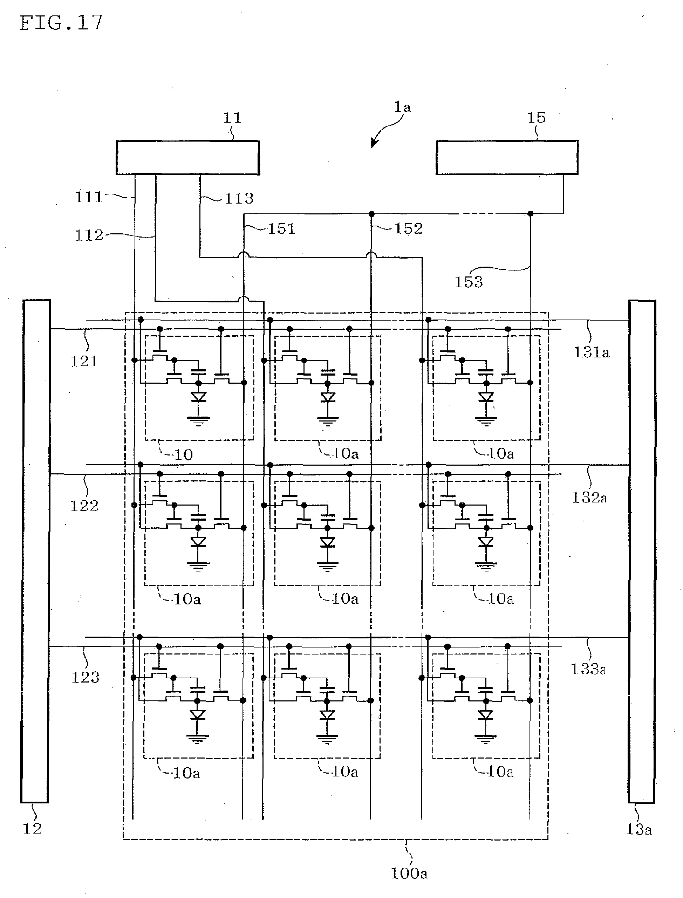

[Second embodiment of an organic EL display apparatus] FIG. 17 is a schematic block diagram of an organic EL display apparatus according to the second embodiment of the invention.
In FIG. 17, an organic EL display apparatus 1a as an electro-optic apparatus comprises a data line-driving circuit 11, a scanning line-driving circuit 12, a power supply line-controlling circuit 13a, a current-measuring circuit 15 and a TFT substrate for current control 100a (hereinafter occasionally abbreviated as "TFT substrate 100a"). On the TFT substrate 100a, m (row; m is a natural number) × n (line; n is a natural number) pixels 10a are arranged in a matrix.

The data line-driving circuit 11 is connected with each pixel 10a through a first data line 111, a second data line 112,... and the mth data line 113. For example, the data line-driving circuit 11 is connected in parallel with n pieces of pixel 10a arranged in the mth row through the mth data line 113. This data line-driving circuit 11 outputs a data signal to each pixel 10a.

The scanning line-driving circuit 12 is connected with each pixel 10a through a first scanning line 121, a second scanning line 122,... and the nth scanning line 123. For example, the scanning line-driving circuit 12 is connected in parallel with m pieces of pixel 10a arranged in the nth line through the nth scanning line 123. This scanning line-driving circuit 12 outputs a scanning signal to each pixel 10a.

Furthermore, the power supply line-controlling circuit 13a is connected with each pixel 10a through a first EL-driving line 131a, a second EL driving line 132a,...and the nth EL driving line 133a. For example, the power supply line-controlling circuit 13a is connected in parallel with m pieces of pixel 10a arranged in the nth line through the nth EL-driving line 133a. This power supply line-controlling circuit 13a supplies direct driving current to each pixel 10a.

Furthermore, the current-measuring circuit 15 is connected with each pixel 10a through a first measuring line 151, a second measuring line 152,...and the mth measuring line 153. For example, the current-measuring circuit 15 is connected in parallel with n pieces of pixel 10a arranged in the mth row through the mth measuring line 153. This current-measuring line 15 measures current supplied to the organic EL device 4 in each pixel 10a.

It is preferred that the current-measuring circuit 15 measure the direct current supplied to the organic EL device 4. It is preferred that, based on this current to be measured value, a control part (not shown) control at least one of the data line-driving circuit 11, the scanning line-driving circuit 12 and the power supply line-controlling circuit 13a. By doing this, direct current supplied to the organic EL device 4 can be measured. Based on this measured value, at least one of the data line-driving circuit 11, the scanning line-driving circuit 12 and the power supply line-controlling circuit 13a is controlled. Therefore, it is possible to supply preferable driving current to the organic EL device 4.
The above-mentioned control part is provided within the current-measuring circuit 15, but the position is not limited thereto. Furthermore, normally, the data line-driving circuit 11 is controlled based on the above-mentioned measured value.

Next, structure of the pixel 10a is explained with reference to the drawing.

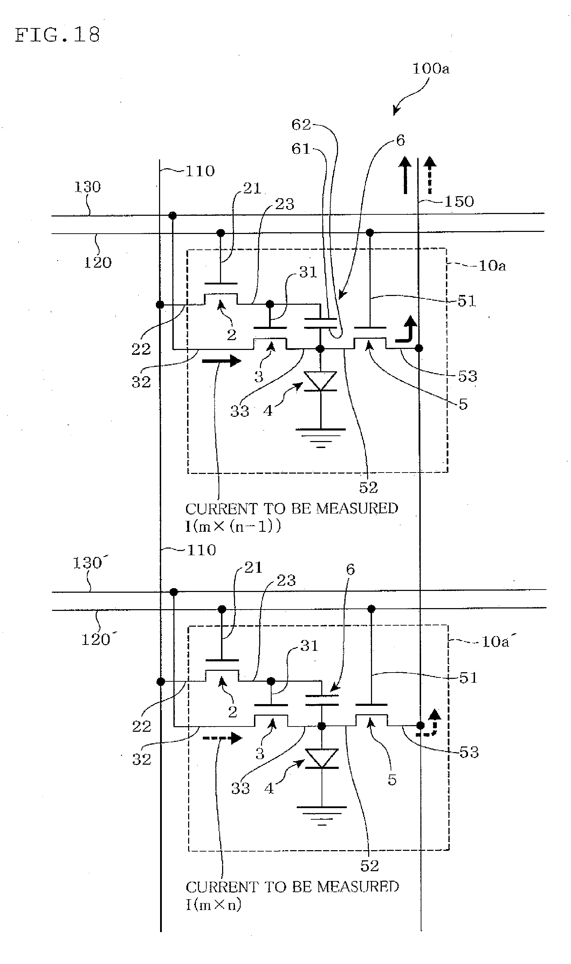

FIG. 18 is a schematic block diagram for explaining the structure of a pixel of the organic EL display apparatus according to the second embodiment of the invention.
In FIG. 18, the pixel 10a comprises the driving transistor 3, the switching transistor 2, the capacitor 6, a measuring transistor 5 and the organic EL device 4.
The driving transistor 3 supplies direct current to the organic EL device 4. The switching transistor 2 controls the driving transistor 3. The capacitor 6 applies a capacitor voltage to the gate electrode 34 of the driving transistor 3. The measuring transistor 5 measures direct current supplied to the organic EL device 4. The organic EL device 4 as an electro-optic device is driven by direct current.
Furthermore, the switching transistor 2, the driving transistor 3 and the measuring transistor 5 are formed on the TFT substrate 100a as thin film transistors. In addition, the capacitor 6 and the pixel electrode 38 of the organic EL device 4 are also formed on the TFT substrate 100a.

The switching transistor 2 is connected with the scanning line 120 through the gate line 21. In addition, the switching transistor 2 is connected with the data line 110 through the source line 22. The drain line 23 of the switching transistor 2 is connected in parallel with the gate line 31 of the driving transistor 3 and a first electrode 61 of the capacitor 6.
Furthermore, the driving transistor 3 is connected with the EL-driving line 130 through the source line 32. The driving transistor 3 is connected in parallel with the organic EL device 4, a second electrode 62 of the capacitor 6 and a source line 52 of the measuring transistor 5 through the drain line 33.
In addition, a gate line 51 of the measuring transistor 5 is connected with the scanning line 120. Furthermore, a drain line 53 of the measuring transistor 5 is connected with a measuring line 150.

The operation of the TFT substrate 100a is explained with reference to FIG. 18.
First, in the TFT substrate 100a having the above-mentioned structure, a scanning signal is input to the scanning line 120. By doing this, a gate signal (scanning signal) is input to the gate electrode 24 of the switching transistor 2, and the switching transistor 2 turns to the ON-state. In addition, when a gate signal (scanning signal) is input to the gate electrode 54 of the measuring transistor 5 from the scanning line 120, the measuring transistor 5 turns to the ON-state.

Subsequently, a data signal (the gate voltage of the driving transistor 3) is applied from the data line 110 to the gate electrode 34 of the driving transistor 3, and the driving transistor 3 turns to the ON-state. Furthermore, the capacitor 6 stores carriers corresponding to the data signal from the data line 110. At this time, a source-drain resistance value of the driving transistor 3 is determined according to the gate voltage applied to the gate electrode 34 of the driving transistor 3. Then, driving current corresponding to the source-drain resistance value is supplied to the drain line 33 from the EL-driving line 130. Here, the measuring transistor 5 is in the ON-state. Therefore, the above-mentioned driving current (current to be measured I (m × (n-1))) flows to the measuring line 150 through the source line 52 and the drain line 53 of the measuring transistor 5 almost without flowing to the organic EL device 4.

Subsequently, the current-measuring circuit 15 measures the above-mentioned current to be measured I (m × (n-1)), and the control part controls the data line-driving circuit 11 based on the measured value I (m × (n-1)). That is, if the measured value is smaller than the prescribed value, the control part increases the voltage of the data signal to be sent to the data line 110. By doing this, the source-drain resistance value of the driving transistor 3 is decreased, and the driving current is increased. In contrast, if the measured value is larger than the prescribed value, the voltage of the data signal to be sent to the data line 110 is decreased. By doing this, the source-drain resistance value of the driving transistor 3 is increased, and the driving current is decreased. If the control part repeats the above-mentioned control operation, the measured value becomes almost equal to the prescribed value.

When the measured value becomes almost equal to the prescribed value, the scanning line-driving circuit 12 stops output of the scanning signal to the scanning line 120. By this stoppage, the switching transistor 2 and the measuring transistor 5 turn to the OFF-state. If the switching transistor 2 turns to the OFF-state, a gate voltage cannot be applied from the data line 110 to the driving transistor 3. However, due to the carriers stored in the capacitor 6, the same voltage as a gate voltage applied from the data line 110 is applied to the gate electrode 34 of the driving transistor 3. That is, during which the switching transistor 2 is in the ON-state, direct voltage is applied from the data line 110 to the first electrode 61 of the capacitor 6. Furthermore, direct voltage is applied to the second electrode 62 of the capacitor 6 from the EL-driving line 130. At this time, since carriers are stored in the capacitor 6, a gate voltage is applied to the gate electrode 34 by the capacitor 6.

Then, the driving transistor 3 is maintained in the ON-state by the capacitor 6, and the measuring capacitor 5 is in the OFF-state. Therefore, the direct current from the EL-driving line 130 is supplied to the organic EL device 4 through the driving transistor 3. Accordingly, the TFT substrate 100a is called as a TFT substrate for DC control.
This direct current is the same as the current to be measured I (m × (n-1)). The driving current, which is almost the same as the prescribed value obtained by the control of the control part, is supplied to the organic EL device 4. The organic EL device 4 emits light with a luminance corresponding to the driving current.
If the above-mentioned driving current is to be changed, a scanning signal is output to the scanning line 120 and a data signal corresponding to a driving current to be changed is output to the data line 110.

Next, in an organic EL display apparatus 1a, the pixels 10a' arranged in the row direction act in a way almost similar to the pixels 10a. Accordingly, even though the properties of the driving transistor 3 are changed (deteriorated), the organic EL display apparatus 1a can supply driving current which is almost the same as the prescribed value to all pixels 10a. Therefore, the organic display apparatus 1a can provide an image of improved quality.
In the organic EL display apparatus 1a of this embodiment, the control part is provided with a storing means which stores a prescribed value of each pixel 10a and a calculating part which calculates a difference between the measured value and the prescribed value. The measured value is controlled to become almost equal to the prescribed value. However, the control method is not limited thereto, and various control methods can be used.

As mentioned above, the organic EL display apparatus 1a of this embodiment can supply driving current which is almost similar to the prescribed value measured by the current-measuring circuit 15 to the organic EL device 4 which is driven by direct current. Therefore, the organic EL display apparatus 1a can provide an image of improved quality. In this embodiment, the organic EL device 4 is used as an electro-optic device. However, usable electro-optic devices are not limited thereto. For example, DC-driven electro-optic devices can be used widely.
In the organic EL display apparatus 1a of this embodiment, the active layer of the driving transistor 3 is composed of the n-type oxide semiconductor layer 371 as an oxide semiconductor layer. By doing this, the driving transistor 3 suffers from only a small degree of deterioration even though a large amount of current is flown or a large amount of power is input to the driving transistor 3 as compared with a TFT substrate in which amorphous Si or a polysilicon semiconductor is used as an active layer of the driving transistor 3. Therefore, stability of the organic EL display apparatus 1a is improved and the durability of the TFT substrate 100a is improved. As a result, the life of the organic EL display apparatus 1a can be prolonged significantly.
Next, the production method and configuration of the above-mentioned TFT substrate 100a are explained with reference to the drawing. First, the production method of the TFT substrate 100a is explained.

### [Second embodiment of a TFT substrate for current control]

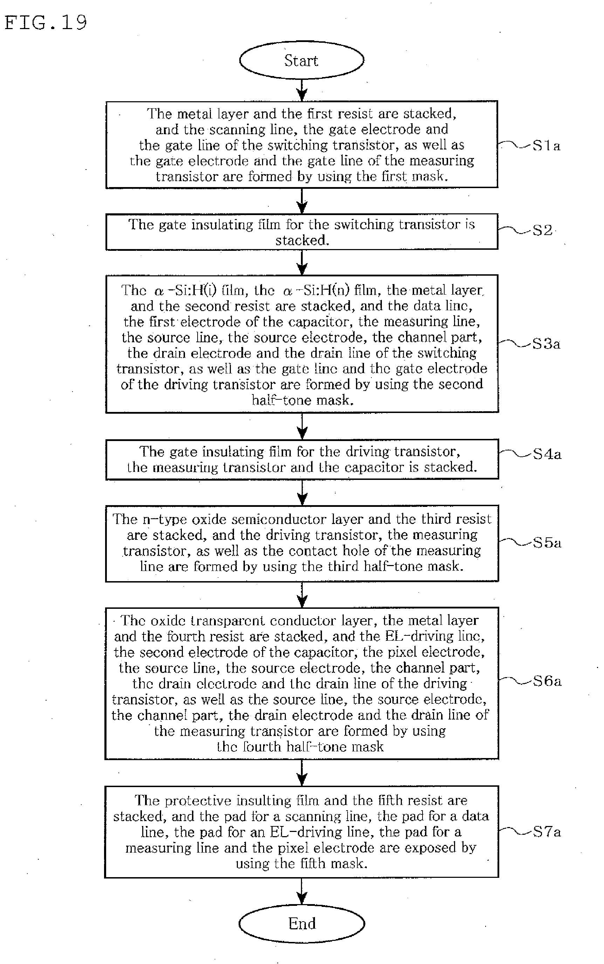

FIG. 19 is a schematic flow chart for explaining the method for producing a TFT substrate to be used in the organic EL display apparatus according to the second embodiment of the invention. The production method of this embodiment corresponds to claim 17.
In FIG. 19, first, on a substrate, a metal layer 210 and a first resist 211 are stacked in this order, and by using the first mask 212, the scanning line 120, the gate electrode 24 and the gate line 21 of the switching transistor 2, as well as the gate electrode 54 and the gate line 51 of the measuring transistor 5 are formed (Step S1a).
Next, a treatment by using a first mask 212 is explained with reference to the drawing.

### (Treatment by using a first mask)

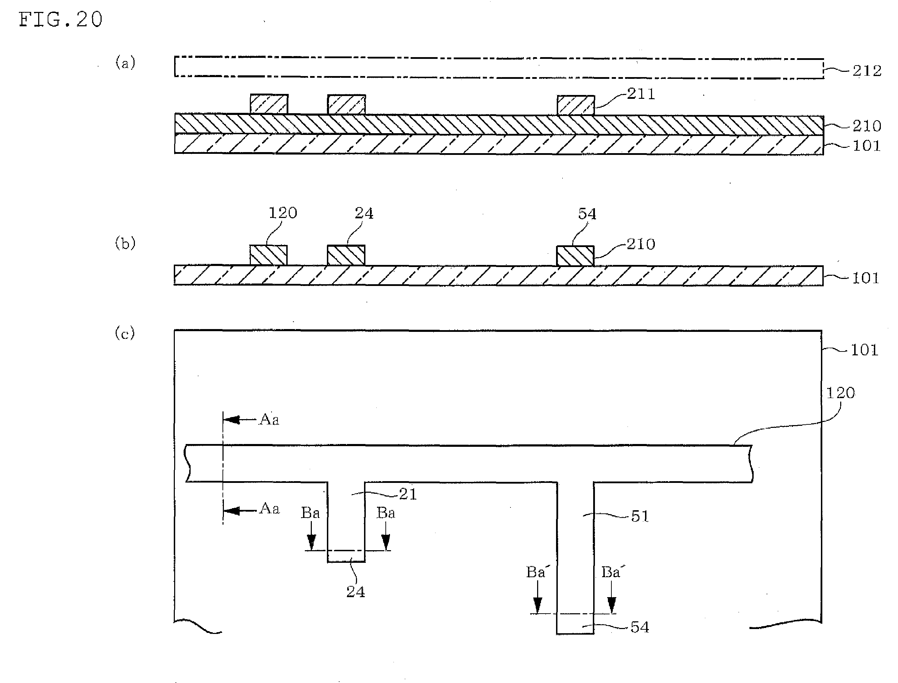

FIG. 20 is a schematic view for explaining a treatment by using the first mask in the method for producing a TFT substrate to be used in the organic EL display apparatus according to the second embodiment of the invention, in which (a) is a cross-sectional view after the formation of the metal layer/after the application of the first resist/after exposure/after development; (b) is a cross-sectional view after the first etching/after the peeling off the first resist; and (c) is a plan view of an essential part of the TFT substrate after the peeling off the first resist.
In FIG. 20(a), first, a light-transmissive glass substrate 101 is provided.

On the glass substrate 101, the metal layer 210 as a conductor layer is formed. Specifically, Al (aluminum) and Mo (molybdenum) are stacked in this order by using the high-frequency sputtering method in a thickness of about 250 nm and about 50 nm, respectively. The scanning line 120, the gate electrodes 24 and 54 and the gate lines 21 and 51 are formed of this metal layer 210.
Subsequently, the first resist 211 is applied on the metal layer 210. Furthermore, by using the first mask 212, the first resist 211 is formed into a predetermined shape by photolithography.

Then, as shown in FIG. 20(b), as the first etching, the metal layer 210 is patterned with an etching method by using an acid mixture etching solution. As a result, the scanning line 120, the gate lines 21 and 51 and the gate electrodes 24 and 54 are formed (Step S1a).
Then, the first resist 211 is removed through an ashing process. As a result, as shown in FIG. 20(c), the scanning line 120, as well as the gate lines 21 and 51 and the gate electrodes 24 and 54 connected with the scanning line 120 are exposed on the glass substrate 101. The scanning line 120 shown in FIG. 20 (b) is a cross-sectional view taken along line Aa-Aa in FIG. 20(c). The gate electrode 24 of the switching transistor 2 shown in FIG. 20 (b) is a cross-sectional view taken along line Ba-Ba in FIG. 20(c). The gate electrode 54 of the measuring transistor 5 is a cross-sectional view taken along line Ba'-Ba' in FIG. 20(c).

Then, as shown in FIG. 19, a gate insulating film 20 is stacked by the glow discharge CVD (Chemical Vapor Deposition) method on the glass substrate 101, the scanning line 120, the gate lines 21 and 51 and the gate electrodes 24 and 54 (Step S2). The gate insulating film 20 is a silicon nitride (SiNₓ) film, and has a thickness of about 300 nm. This gate insulating film 20 is formed as a gate insulating film 20 for the switching transistor 2 and the measuring transistor 5. In this embodiment, an SiH₄-NH₃-N₂-based mixed gas is used as a discharge gas.

Then, as shown in FIG. 19, the α-Si:H(i) film 271, the α-Si:H (n) film 272, the metal layer 273 as a conductor layer and a second resist 274 are stacked, and by using a second half-tone mask 275a, the data line 110, the first electrode 61 of the capacitor 6, the measuring line 150, the source line 22, the source electrode 25, the channel part 27, the drain electrode 26 and the drain line 23 of the switching transistor 2, as well as the gate line 31 and the gate electrode 34 of the driving transistor 3 are formed (Step S3a).
Next, a treatment by using the second half-tone mask 275a is explained with reference to the drawing.

### (Treatment by using a second half-tone mask)

FIG. 21 is a schematic view for explaining a treatment by using the second half-tone mask in the method for producing a TFT substrate to be used in the organic EL display apparatus according to the second embodiment of the invention, in which (a) is a cross-sectional view after the formation of the gate insulating film/after the formation of the α-Si:H(i) film/after the formation of the α-Si:H(n) film/after the formation of the metal layer/after the application of the second resist/after half-tone exposure/after development; (b) is a cross-sectional view after the second etching/after the reformation of the second resist; and (c) is a cross-sectional view after the third etching/after the peeling off the second resist.
In FIG. 21(a), first, the α-Si:H(i) film 271 is stacked on the gate insulating film 20. The α-Si:H(i) film 271 is an insulating layer of amorphous Si (silicon) and has a thickness of about 350 nm. An SiH₄-N₂-based mixed gas is used as a discharge gas at this time.
Subsequently, by using a mixed gas based on SiH₄-H₂-PH₃, the α-Si:H(n) film 272 is stacked. The α-Si:H(n) film 272 is an n-type semiconductor layer of amorphous Si, and has a thickness of about 300 nm. Then, the metal layer 273 composed of an Mo layer/an Al layer/an Mo layer is formed. Specifically, Mo, Al and Mo are stacked in this order by using the high-frequency sputtering method in a thickness of about 50 nm, about 250 nm and about 50 nm, respectively.

Then, a second resist 274 is applied on the metal layer 273. The second resist 274 is formed into a predetermined shape by half-tone exposure by using the second half-tone mask 275a. That is, the second resist 274 is formed into such a shape that it covers the data line 110, the first electrode 61, the measuring line 150, the source line 22, the source electrode 25, the gate electrode 24, the drain electrode 26 and the drain line 23 of the switching transistor 2, and the gate line 31 and the gate electrode 34 of the driving transistor 3. In addition, by using the half-tone mask part 276, the second resist 274 is formed into such a shape that the part thereof covering the channel part 27 is thinner than other parts.

Subsequently, as shown in FIG. 21(b), as the second etching, the metal layer 273 is patterned with an etching method by using the second resist 274 and an acid mixture etching solution. Then, the α-Si:H (n) film 272and the α-Si:H(i) film 271 are patterned with a dry etching method using a CHF gas and a wet etching method using an aqueous hydrazine solution (NH₂NH₂·H₂O), whereby the data line 110, the first electrode 61, the measuring line 150, the source line 22, the drain line 23, the gate line 31 and the gate electrode 34 are formed.

Subsequently, the second resist 274 is removed through an ashing process, whereby the second resist 274 is reformed. When the second resist 274 is reformed, the metal layer 273 above the channel part 27 is exposed, and the data line 110, the first electrode 61, the measuring line 150, the source line 22, the source electrode 25, the drain electrode 26 and the drain line 23 of the switching transistor 2, and the gate line 31 and the gate electrode 34 of the driving transistor 3 are covered by the reformed second resist 274.

Subsequently, as shown in FIG. 21(c), as the third etching, the metal layer 273 is patterned with an etching method by using the reformed second resist 274 and the acid mixture etching solution, whereby the source electrode 25 and the drain electrode 26 are formed. Then, the α-Si:H(n) film 272 is patterned with a dry etching method using a CHF gas and a wet etching method using an aqueous hydrazine solution (NH₂NH₂·H₂O). As a result, the channel part 27 composed of the α-Si:H(i) film 271 is formed, and the source electrode 25 and the drain electrode 26 of the switching transistor 2 are formed (Step S3a).

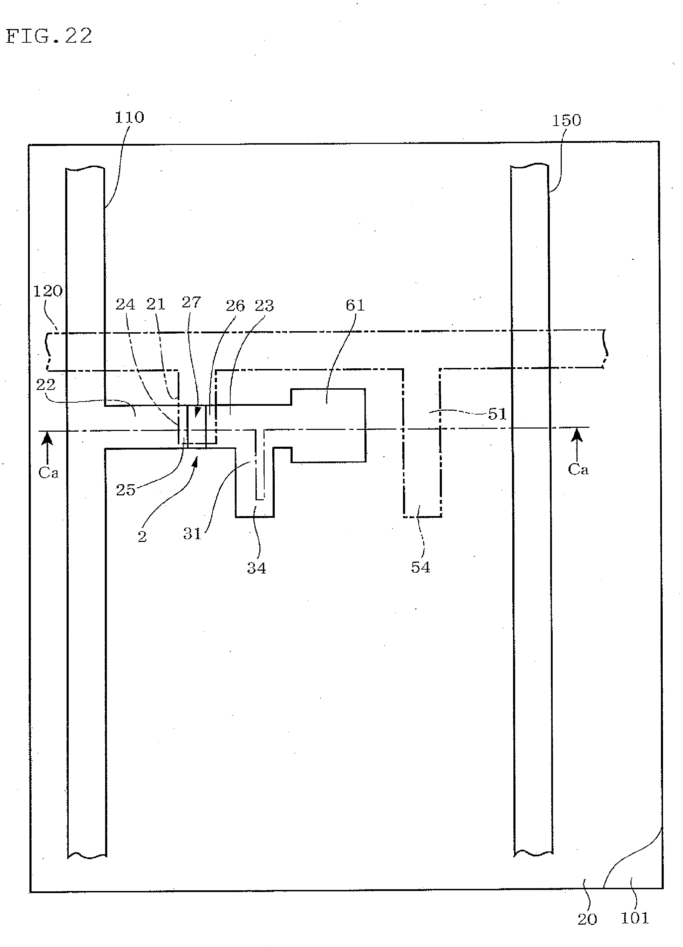

Then, the reformed second resist 274 is removed through an ashing process. As a result, as shown in FIG. 21(c), the data line 110, the first electrode 61, the measuring line 150, the source line 22, the source electrode 25, the channel part 27, the drain electrode 26 and the drain line 23 of the switching transistor 2, and the gate line 31 and the gate electrode 34 of the driving transistor 3 are exposed on the gate insulating film 20. The data line 110, the first electrode 61, the measuring line 150, the source line 22, the source electrode 25, the gate electrode 24, the channel part 27, the drain electrode 26 and the drain line 23 of the switching transistor 2, and the gate line 31 and the gate electrode 34 of the driving transistor 3 in FIG. 21 (c) are cross-sectional view taken along line Ca-Ca in FIG. 22.

Then, as shown in FIG. 19, a gate insulating film 30 is stacked by the glow discharge CVD (Chemical Vapor Deposition) method above the glass substrate 101 (Step S4a). The gate insulating film 30 is a silicon nitride (SiNₓ) film, and has a thickness of about 300 nm. This gate insulating film 30 is formed as a gate insulating film 30 for the driving transistor 3, the measuring transistor 5 and the capacitor 6. In this embodiment, an SiH₄-NH₃-N₂-based mixed gas is used as a discharge gas.

Then, as shown in FIG. 19, on the gate insulating film 30, the n-type oxide semiconductor layer 371 as an oxide semiconductor layer and the third resist 372 are stacked, active layers of the driving transistor 3 and the measuring transistor 5, as well as a contact hole 155 of the measuring line 150 are formed by using a third half-tone mask 373a (Step S5a).
Next, a treatment by using the third half-tone mask 373a is explained with reference to the drawing.

### (Treatment by using a third half-tone mask)

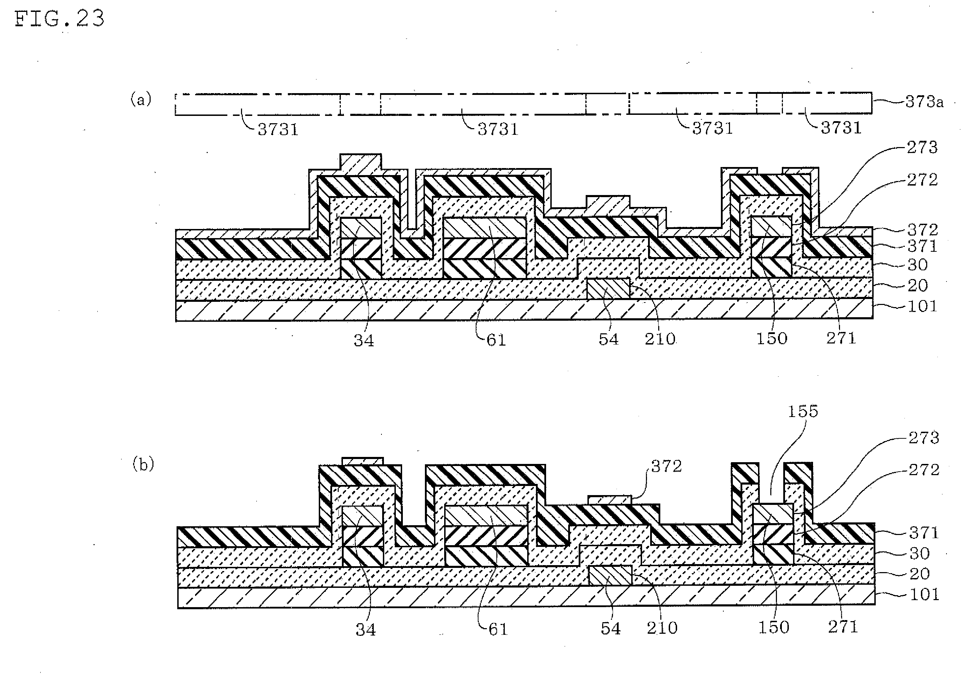

FIG. 23 is a schematic view for explaining a treatment by using the third half-tone mask in the method for producing a TFT substrate to be used in the organic EL display apparatus according to the second embodiment of the invention, in which (a) is a cross-sectional view after the formation of the gate insulating film/after the formation of the n-type oxide semiconductor layer/after the application of the third resist/after half-tone exposure/after development; and (b) is a cross-sectional view after the fourth etching/after the reformation of the third resist.
In FIG. 23, an n-type oxide semiconductor layer 371 with a thickness of about 150 nm is formed on the gate insulating film 30 by using an indium oxide-zinc oxide (In₂O₃:ZnO=about 97:3 wt%) target. This layer formation is conducted under the condition of an oxygen-to-argon ratio of about 10 : 90 (vol%) and a substrate temperature of about less than 100°C. Under this condition, the n-type oxide conductor layer 371 is obtained as an amorphous film.

Then, the third resist 372 is applied on the n-type oxide semiconductor layer 371. The third resist 372 is formed into a predetermined shape by using a third half-tone mask 373a by half-tone exposure technology. That is, the third resist 372 is formed into such a shape that it covers the upper part of the glass substrate 101 entirely, except for the part above the contact hole 155. In addition, by using a half-tone mask part 3731, the third resist 372 is formed into such a shape that the part thereof covering the gate electrode 34 and the drain line 53 is thicker than other parts.

Subsequently, as shown in FIG. 23(b), as the fourth etching, the n-type oxide semiconductor layer 371 is patterned with an etching method by using the third resist 372 and an aqueous oxalic acid solution. Then, the gate insulating film 30 is patterned with a dry etching method using the third resist 372 and a CHF gas (CF4, CHF₃ gas, or the like), whereby the contact hall 155 is formed.
Subsequently, the third resist 372 is removed through an ashing process, and the third resist 372 is reformed into such a shape that it covers the gate electrode 34 and the drain line 53.

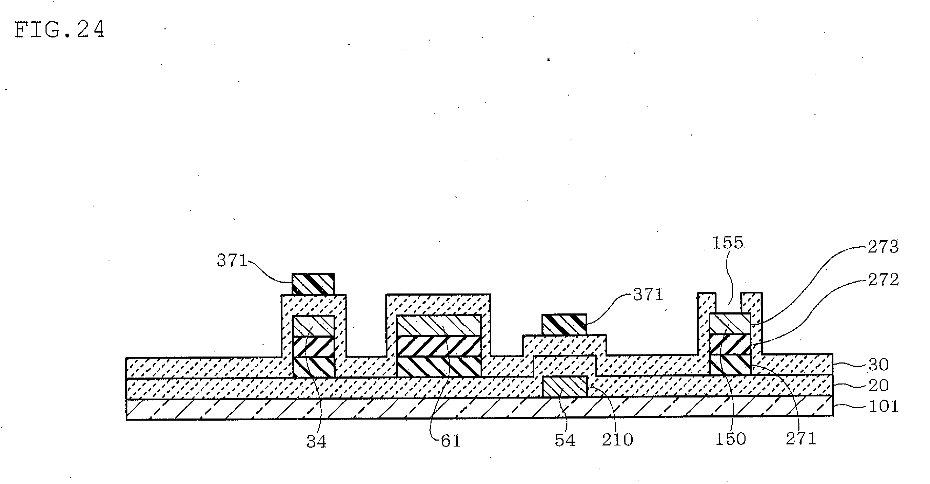

FIG. 24 is a schematic view for explaining a treatment by using the third half-tone mask in the method for producing a TFT substrate to be used in the organic EL display apparatus according to the second embodiment of the invention, showing a cross-sectional view after the fifth etching/after the peeling off the third resist.

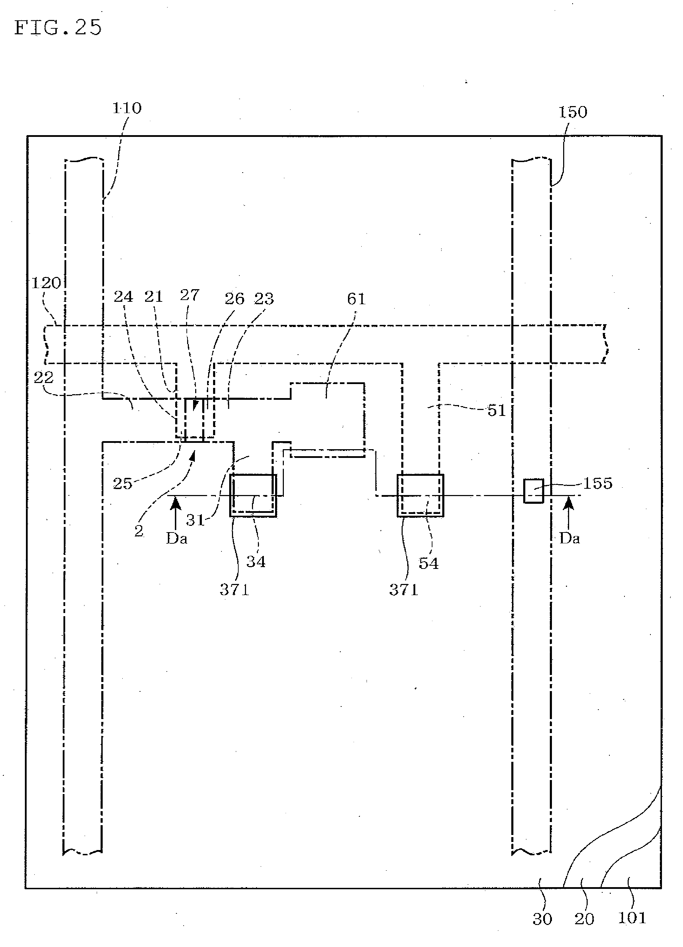

In FIG. 24, as the fifth etching, the n-type oxide semiconductor layer 371 is patterned with an etching method by using the reformed third resist 372 and an aqueous oxalic acid solution. As a result, active layers of the driving transistor 3 and the measuring transistor 5, which are composed of the n-type oxide semiconductor layer 371, are formed. Subsequently, the third resist 372 is removed through an ashing process to expose the n-type oxide semiconductor layer 371. The gate electrode 34, the first electrode 61, the gate electrode 54, the n-type oxide semiconductor layer 371 and the contact hole 155 shown in FIG. 24 are cross-sectional views taken along line Da-Da in FIG. 25.
In addition, after the n-type oxide semiconductor layer 371 is formed, the TFT substrate 100a is heat-treated at a temperature of about 180°C or higher. By doing this, the active layer of the n-type oxide semiconductor layer 371 is crystallized.

Subsequently, as shown in FIG. 19, the oxide transparent conductor layer 374 as an oxide conductor layer, the metal layer 375 as an auxiliary conductor layer (auxiliary metal layer) and the fourth resist 376 are stacked. Subsequently, by using the fourth half-tone mask 377, the EL-driving line 130, the second electrode 62 of the capacitor 6, the pixel electrode 38, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 are formed (Step S6a).
Next, a treatment by using the fourth half-tone mask 377 is explained with reference to the drawing.

### (Treatment by using a fourth half-tone mask)

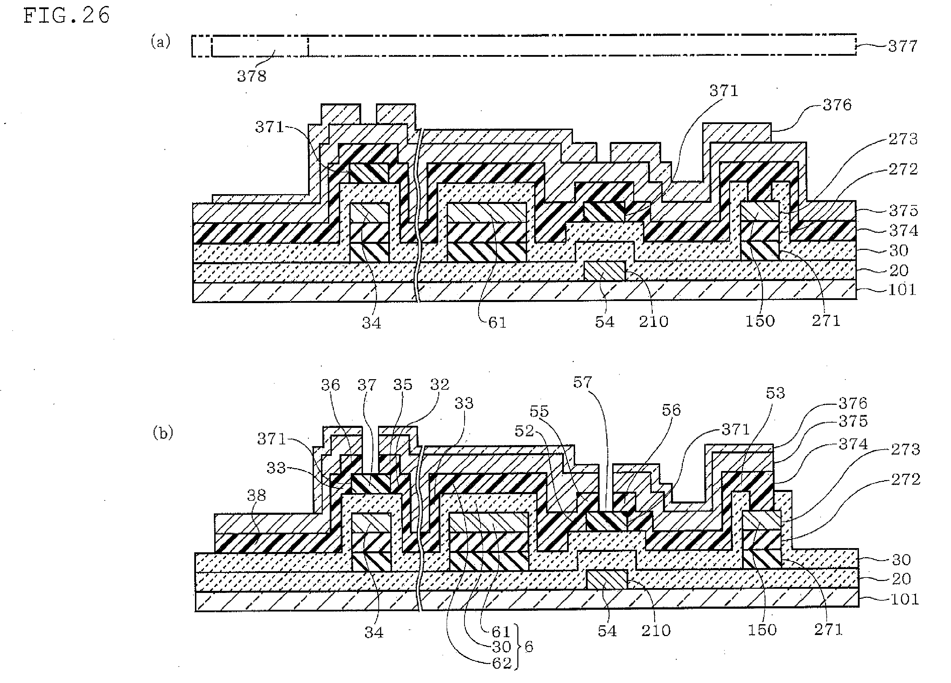

FIG. 26 is a schematic view for explaining a treatment by using the fourth half-tone mask in the method for producing a TFT substrate to be used in the organic EL display apparatus according to the second embodiment of the invention, in which (a) is a cross-sectional view after the formation of the oxide transparent conductor layer/after the formation of the metal layer/after the application of the fourth resist/after half-tone exposure/after development; and (b) is a cross-sectional view after the sixth etching/after the reformation of the fourth resist. In this figure, for convenience of understanding, the EL-driving line 130 is omitted.
In FIG. 26(a), on the gate insulating film 30 and the n-type oxide semiconductor layer 371, which are exposed, an oxide transparent conductor layer 374 is formed into a film thickness of about 120 nm by using an indium oxide-tin oxide-zinc oxide (In₂O₃:SnO₂:ZnO=about 60:20:20 wt%) target by the high-frequency sputtering method. This layer formation is conducted under the condition of an oxygen-to-argon ratio of about 1:99 (vol%) and a substrate temperature which does not cause the oxide transparent conductor layer 374 to be crystallized.

Then, the metal layer 375 is formed. This metal layer 375 is an auxiliary conductor layer and is composed of an Mo layer/an Al layer/an Mo layer. Specifically, Mo, Al and Mo are stacked in this order by using the high-frequency sputtering method in a thickness of about 50 nm, about 250 nm and about 50 nm, respectively. That is, the fourth resist 376 is formed into such a shape that it covers the EL-driving line 130, the second electrode 62 of the capacitor 6, the pixel electrode 38, the source line 32, the source electrode 35, the drain electrode 36 and the drain line 33 of the driving transistor 3, as well as the source line 52, the source electrode 55, the drain electrode 56 and the drain line 53 of the measuring transistor 5. In addition, by using a half-tone mask part 378, the fourth resist 376 is formed into such a shape that the part thereof covering the pixel electrode 38 is thinner than other parts.

Then, as shown in FIG. 26(b), as the sixth etching, the metal layer 375 is patterned with an etching method by using the fourth resist 376 and an acid mixture etching solution. Subsequently, the oxide transparent conductor layer 374 is patterned with an etching method by using the fourth resist 376 and an aqueous oxalic acid solution. As a result, the EL-driving line 130, the second electrode 62 of the capacitor 6, the pixel electrode 38, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 are formed (Step S6a).

Subsequently, the above-mentioned fourth resist 376 is removed through an ashing process, whereby the fourth resist 376 is reformed. When the fourth resist 376 is reformed, the metal layer 375 above the pixel electrode 38 is exposed, and the EL-driving line 130, the second electrode 62 of the capacitor 6, the source line 32, the source electrode 35, the drain electrode 36 and the drain line 33 of the driving transistor 3, as well as the source line 52, the source electrode 55, the drain electrode 56 and the drain line 53 of the measuring transistor 5 are covered by the reformed fourth resist 376.

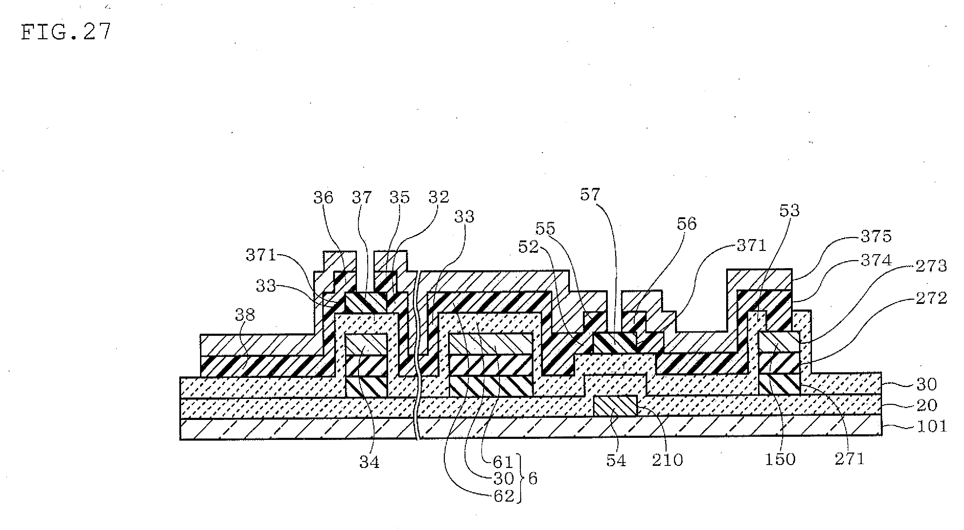

FIG. 27 is a schematic view for explaining a treatment by using the fourth half-tone mask in the method for producing a TFT substrate to be used in the organic EL display apparatus according to the second embodiment of the invention, showing a cross-sectional view after the seventh etching/after the peeling off the fourth resist.
In FIG. 27, as the seventh etching, the metal layer 375 is patterned,with an etching method by using the reformed fourth resist 376 and an acid mixture etching solution to expose the pixel electrode 38.

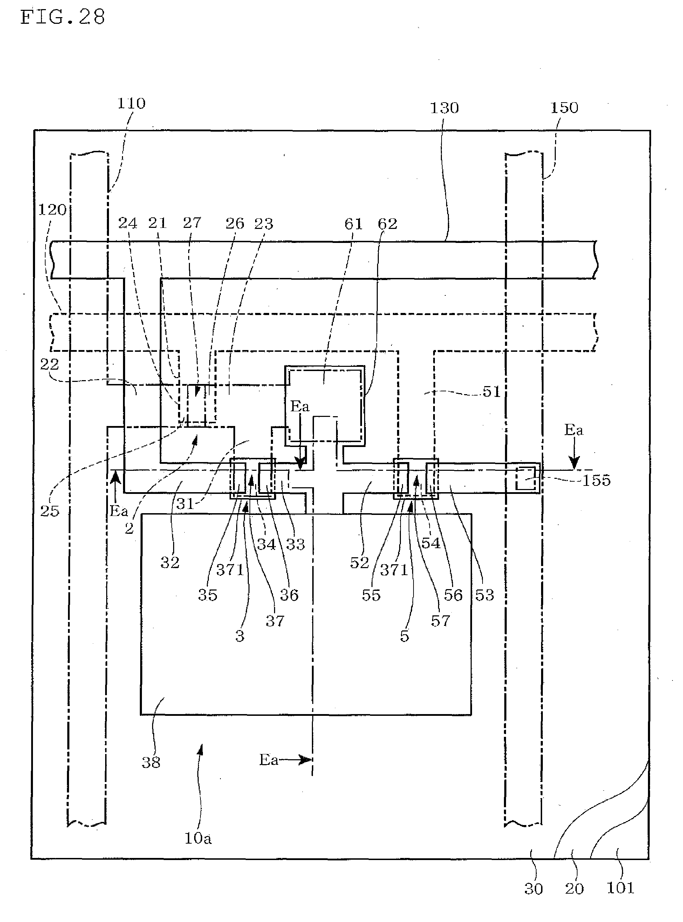

Then, the reformed fourth resist 376 is removed through an ashing process. As a result, as shown in FIG. 27, the EL-driving line 130, the second electrode 62 of the capacitor 6, the pixel electrode 38, the source line 32, the source electrode 35, the channel part 37, the drain electrode 36 and the drain line 33 of the driving transistor 3, as well as the source line 52 of the measuring transistor 5, the source electrode 55, the channel part 57, the drain electrode 56 and the drain line 53 of the measuring transistor 5 are exposed on the gate insulating film 30. The EL-driving line 130, the second electrode 62 of the capacitor 6, the pixel electrode 38, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 shown in FIG. 27 are cross-sectional views taken along line Ea-Ea in FIG. 28.
The drain line 53 of the measuring transistor 5 is connected with the measuring line 150 through the contact hole 155.

Subsequently, as shown in FIG. 19, the protective insulating film 40 and the fifth resist 41 are stacked, and by using a fifth mask, the pad for a scanning line 124, the pad for a data line 114, the pad for an EL-driving line 134, the pad for a measuring line 154 and the pixel electrode 38 are exposed (Step S7a).
Next, a treatment by using the fifth mask 42 is explained with reference to the drawing.

### (Treatment by using a fifth mask)

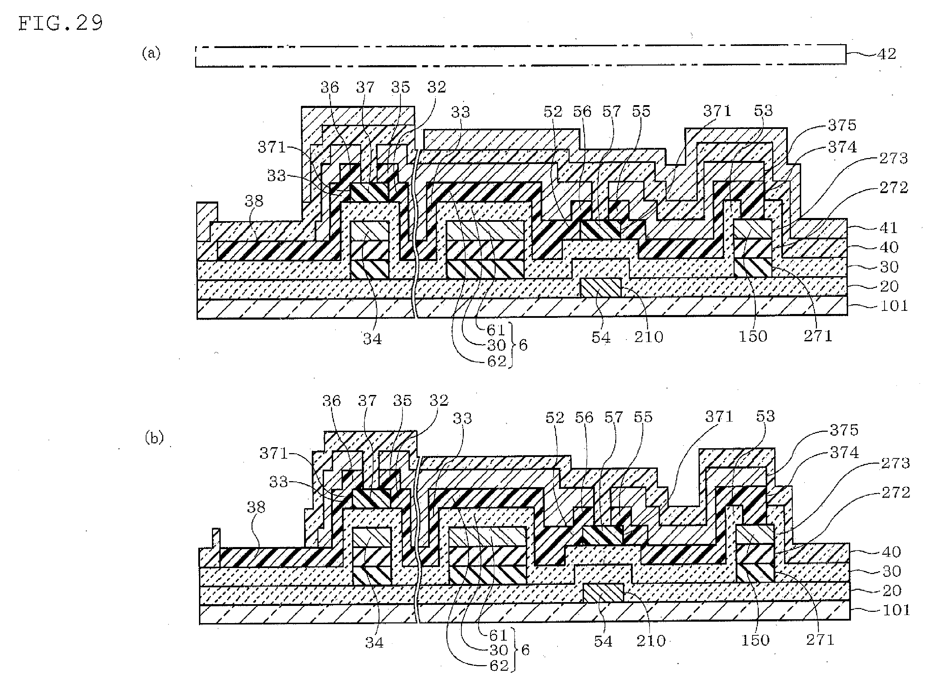

FIG. 29 is a schematic view for explaining a treatment by using the fifth mask in the method for producing a TFT substrate to be used in the organic EL display apparatus according to the second embodiment of the invention, in which (a) is a cross-sectional view after the formation of the protective insulating film/after the application of the fifth resist/after exposure/after development; and (b) is a cross-sectional view after the eighth etching/after the peeling off the fifth resist.
In FIG. 29(a), the protective insulating film 40 is stacked by the glow discharge CVD (Chemical Vapor Deposition) method above the glass substrate 101. This fourth resist 376 is a silicon nitride (SiNₓ) film and has a thickness of about 250 nm. In this embodiment, an SiH₄-NH₃-N₂-based mixed gas is used as a discharge gas.

Then, a fifth resist 41 is applied on the protective insulating film 40. The fifth risist 41 is formed by using the fifth mask 42 and by exposure technology. The fifth risist 41 has openings above the pixel electrode 38, a pad for a data line 114, a pad for a scanning line 124, a pad for a measuring line 154 and a pad for an EL-driving line 134. In FIG. 29, the pad for a data line 114, the pad for a scanning line 124, the pad for an EL-driving line 134 and the pad for a measuring line 154 are omitted (see FIG. 12 for the pad for a data line 114, the pad for a scanning line 124 and the pad for an FL-driving line 134. The pad for a measuring pad 154 is almost the same as the pad for a data line 114).
Subsequently, as the eighth etching, the protective insulating film 40, the gate insulating film 30 and the gate insulating film 20 are patterned with a dry etching method by using an etching gas (CHF (CF₄, CHF₃ gas, or the like)) to expose the pixel electrode 38, the pad for a data line 114, the pad for a scanning line 124, the pad for a measuring line 154 and the pad for an EL-driving line 134 (Step S7a).

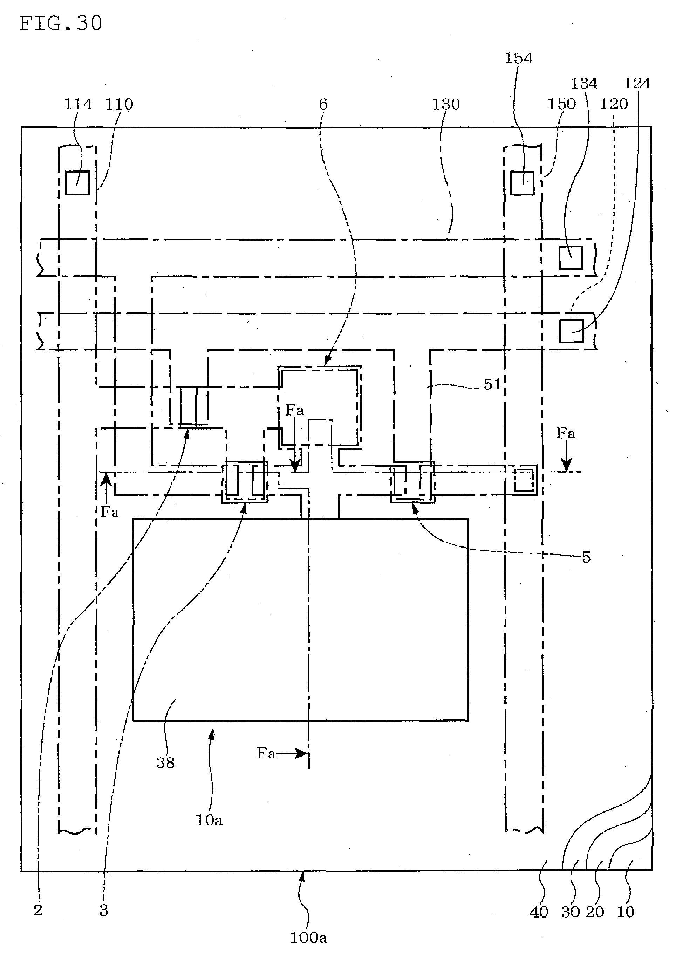

Subsequently, the reformed fifth resist 41 is removed through an ashing process. As a result, as shown in FIG. 29, the protective insulating film 40 is exposed. The EL-driving line 130, the second electrode 62 of the capacitor 6, the pixel electrode 38, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 shown in FIG. 29(b) are cross-sectional views taken along line Fa-Fa in FIG. 30.
In the meantime, in this embodiment, the positions or the shapes of the switching transistor 2, the driving transistor 3, the capacitor 6, the measuring transistor 5 and the pixel electrode 38 are the positions or the shapes which are easy to understand. The positions or the shapes are, however, not limited thereto.

As mentioned above, according to the method for producing the TFT substrate for current control 100a of this embodiment, it is possible to supply driving current which is almost similar to the prescribed value measured by the current-measuring circuit 15 to the organic EL device 4 which is driven by direct current. Accordingly, it is possible to provide an image of improved quality. In this embodiment, active layers of the driving transistor 3 and the measuring transistor 5 are composed of the n-type oxide semiconductor layer 371. By doing this, the driving transistor 3 and the measuring transistor 5 suffer only a small degree of deterioration even though a large amount of current is flown or a large amount of power is input to the driving transistor 3 and the measuring transistor 5. Therefore, the TFT substrate 100a is improved in stability. Furthermore, the durability of the TFT substrate 100a can be improved. Furthermore, the EL-driving line 130, the second electrode 62 of the capacitor 6, the pixel electrode 38, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 can be produced by using the fourth half-tone mask 377. As a result, the number of masks used can be reduced and production steps are decreased. Accordingly, production efficiency is increased and manufacturing cost can be reduced. Furthermore, the protective insulating film 40 is formed. Therefore, the organic EL display apparatus 1a can be obtained easily by providing organic EL materials, electrodes and protective films on the TFT substrate 100a.
Next, the structure of the above-mentioned TFT substrate 100a is explained with reference to the drawing.

### [Second embodiment of a TFT substrate for current control]

As shown in FIG. 17, in the TFT substrate 100 of this embodiment, m (row; m is a natural number) × n (line; n is a natural number) pixels 10a are arranged in a matrix.
Furthermore, in the direction of line (horizontal direction), n pieces of the scanning lines 121, 122,...123 are formed. For example, the nth scanning line 123 is connected in parallel with m pieces of the pixel 10a arranged in the nth line.
In addition, in the direction of line (horizontal direction), n pieces of the EL-driving lines 131a, 132a,...133a are formed. For example, the nth EL-driving line 133a is connected in parallel with m pieces of pixel 10a arranged in the nth line.
In addition, in the direction of row (vertical direction), m pieces of the data lines 111, 112,...113 are formed. For example, the mth data line 133 is connected in parallel with n pieces of pixel 10a arranged in the mth row.
Furthermore, in the direction of row (vertical direction), m pieces of the measuring lines 151, 152,...153 are formed. For example, the mth measuring line 153 is connected in parallel with n pieces of pixel 10a arranged in the mth row.

As shown in FIG. 30, each pixel 10a has the driving transistor 3, the switching transistor 2, the capacitor 6 and the measuring transistor 5.
The driving transistor 3 supplies electric current to the organic EL device 4 as an electro-optic device (see FIG. 18). The switching transistor 2 controls the driving transistor 3. The capacitor 6 can keep the driving transistor 3 in the ON-state. By the measuring transistor 5, electric current supplied to the organic EL device 4 (see FIG. 18) can be measured.

As shown in FIGs. 21 and 22, the switching transistor 2 has the gate electrode 24, the gate insulating film 20, the α-Si:H(i) film 271, the α-Si:H(n) film 272, the source electrode 25 and the drain electrode 26.
The gate electrode 24 is connected with the scanning line 120 through the gate line 21. The gate insulating film 20 is formed on the gate electrode 24. The α-Si:H(i) film 271 and the α-Si:H(n) film 272, which are active layers, are formed on the gate insulating film 20. The source electrode 25 is connected with the data line 110 through the source line 22. The drain electrode 26 is connected with the gate electrode 34 of the driving transistor 3 through the drain line 23 and the gate line 31, and is connected with the first electrode 61 of the capacitor 6 through the drain line 23.

As shown in FIGs. 27 and 28, the driving transistor 3 has the gate electrode 34, the gate insulating film 30, the n-type oxide semiconductor layer 371, the source electrode 35 and the drain electrode 36.
The gate insulating film 30 is formed on the gate electrode 34. The n-type oxide semiconductor layer 371 as an active layer is formed on the gate insulating film 30. The source electrode 35 is connected with the EL-driving line 130 through the source line 32. The drain electrode 36 is connected with the pixel electrode 38 and the second electrode 62 of the capacitor 6 through the drain line 33, and connected with the source electrode 55 of the measuring transistor 5 through the drain line 33 and the source line 52.

Furthermore, the source line 32, the source electrode 35, the drain electrode 36 and the drain line 33 of the driving transistor 3 is composed of the oxide transparent conductor layer 374. Furthermore, this oxide transparent conductor layer 374 functions as the pixel electrode 38 and the second electrode 62 of the capacitor 6 of the organic EL device 4. By doing this, the number of masks used in the production can be reduced and production steps can be decreased. As a result, production efficiency can be improved and manufacturing cost can be decreased.

As shown in FIGs. 27 and 28, the measuring transistor 5 has the gate electrode 54, the gate insulating film 20, the gate insulating film 30, the n-type oxide semiconductor layer 371, the source electrode 55 and the drain electrode 56.
The gate electrode 54 is connected with the scanning line 120 through the gate line 51. The gate insulating film 20 and the gate insulating film 30 are formed on the gate electrode 54. The n-type oxide semiconductor layer 371 as an active layer is formed on the gate insulating film 30. The drain electrode 56 is connected with the measuring line 150 through the drain line 53, part of which is formed within the contact hole 155.

Furthermore, it is preferred that the metal layer 375 as an auxiliary conductor layer be formed above the EL-driving line 130, the second electrode 62 of the capacitor 6, the source line 32, the source electrode 35, the drain electrode 36 and the drain line 33 of the driving transistor 3, as well as the source line 52, the source electrode 55, the drain electrode 56 and the drain line 53 of the measuring transistor 5. By doing this, the electric resistance of each line and each electrode can be decreased. As a result, reliability can be improved and a decrease in energy efficiency can be suppressed.

In the capacitor 6, the gate insulating film 30 is formed between the first electrode 61 and the second electrode 62. In the capacitor 6, direct voltage is applied from the data line 110 to the first electrode 61 through the switching transistor 2 which is in the ON-state. Furthermore, direct voltage is applied from the EL-driving line 130 to the second electrode 62 through the driving transistor 3 which is in the ON-state. Therefore, carriers corresponding to the direct voltage applied from the data line 110 are stored in the first electrode 61. As a result, due to the carriers stored in the first electrode 61, if the switching transistor 2 turns to the OFF-state, the ON-state of the switching transistor 2 is maintained in the same manner as that when the direct voltage is applied from the EL-driving line 130.

As mentioned above, the TFT substrate 100a of the invention can be used as a DC-driven electro-optic device like the organic EL device 4. Furthermore, the TFT substrate 100a can supply a driving current which is almost similar to the prescribed value measured by the current-measuring circuit 15 to the organic EL device 4 which is driven by direct current. Therefore, an image of improved quality can be provided. Furthermore, active layers of the driving transistor 3 and the measuring transistor 5 are composed of the n-type oxide semiconductor layer 371. Therefore, the driving transistor 3 suffers from only a small degree of deterioration even though a large amount of current is flown or a large amount of power is input to the driving transistor 3 and the measuring transistor 5. As a result, the TFT substrate 100a is improved in stability. Furthermore, the durability of the TFT substrate 100a can be improved.

The second embodiment of the organic EL display apparatus, the second embodiment of the method for producing the TFT substrate for current control and the second embodiment of the TFT substrate for current control have various application examples.
For example, in the second embodiment of the method for producing the TFT substrate for current control, the pad for a data line 114, the pad for a scanning line 124, the pad for an EL-driving line 134 and the pad for a measuring line 154 are formed below the gate insulating film 30, but the position is not limited thereto. For example, a pad for a data line 114b, a pad for a scanning line 124b, a pad for an EL-driving line 134 and a pad for a measuring line 154b may be formed below the protective insulating film 40 and above the gate insulating film 30 (that is, nearer to the protective insulating film 40).
Next, an application example of the method for producing the TFT substrate for current control according to the second embodiment is explained with reference to the drawing.

### [Application example of the method for producing a TFT substrate for current control]

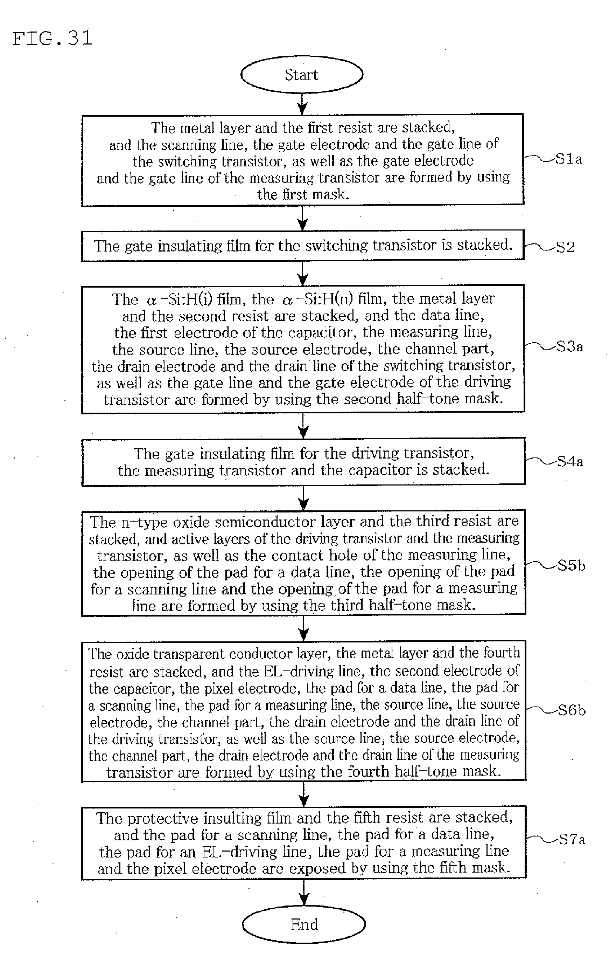

FIG. 31 is a schematic flow chart for explaining the method for producing a TFT substrate to be used in an organic EL display apparatus according to an application example of the second embodiment of the invention. In the meantime, the production method according to this application example corresponds to claim 18.
In FIG. 31, the method for producing the TFT substrate according to this application example differs from the above-mentioned method according to the second embodiment in the following points. Specifically, in addition to the above-mentioned step S5a (see FIG. 19), an opening 114b' of the pad for a data line 114b, an opening 124b' of the pad for a scanning line 124b and an opening 154b' of the pad for a measuring line 154b are formed in the step S5b. Furthermore, in addition to the above-mentioned step S6a, the pad for a data line 114b, the pad for a scanning line 124b and the pad for a measuring line 154b are formed in the step S6b. That is, the method shown in FIG. 31 differs from the above-mentioned second embodiment in these points. Other steps are almost the same as those in the second embodiment.
Therefore, in FIG. 31, the same steps are indicated by the same numerals as used in FIG. 19, and detailed explanation is omitted.

In the step S5b, as shown in FIG. 31, the n-type oxide semiconductor layer 371 as an oxide semiconductor layer and the third resist 372 are stacked on the gate insulating film 30. Subsequently, by using a third half-tone mask 373a, the active layers of the driving transistor 3 and the measuring transistor 5, as well as the contact hole 155 of the measuring line 150, the opening 114b' of the pad for a data line 114b, the opening 124b' of the pad for a scanning line 124b and an opening 154b' of the pad for a measuring line 154b are formed.
Next, a treatment by using the third half-tone mask 373a in the step S5b is explained with reference to the drawing.

### (Treatment by using a third half-tone mask)

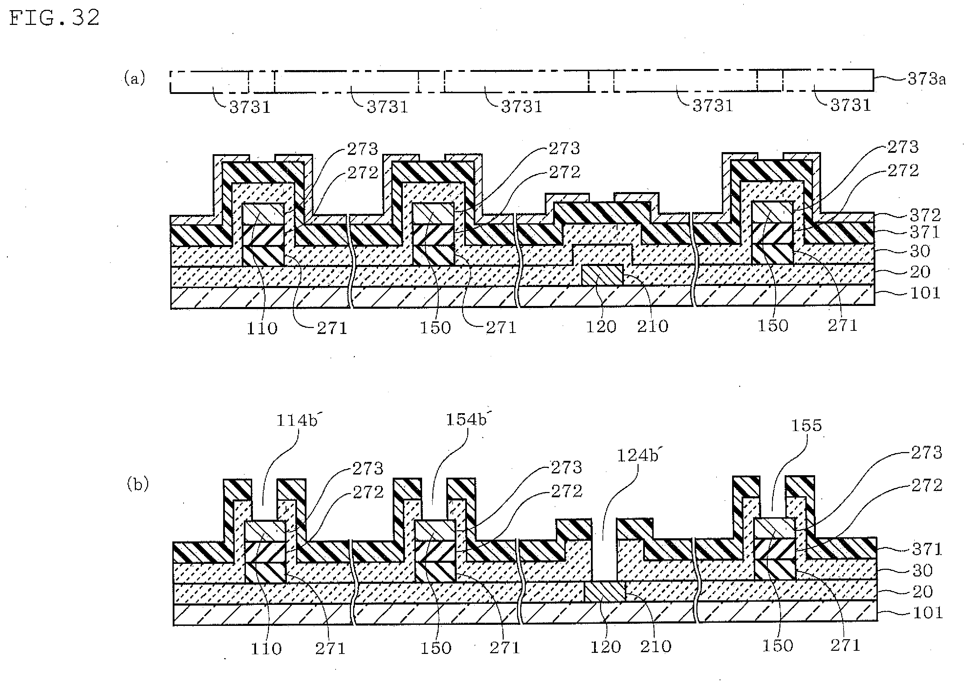

FIG. 32 is a schematic view for explaining a treatment by using the third half-tone mask in the method for producing a TFT substrate to be used in the organic EL display apparatus according to the application example of the second embodiment of the invention, in which (a) is a cross-sectional view after the formation of the gate insulating film/after the formation of the n-type oxide semiconductor layer/after the application of the third resist/after half-tone exposure/after development; and (b) is a cross-sectional view after the fourth etching/after the reformation of the third resist.
The method for forming the active layers of the driving transistor 3 and the measuring transistor 5 in the step S5b is almost similar to the step S5a in the second embodiment (see FIGs. 23 and 24). Therefore, in FIG. 32, the contact hole 155 of the measuring line 150, the opening 114b' of the pad for a data line 114b, the opening 124b' of the pad for a scanning line 124b and the opening 154b' of the pad for a measuring line 154b are shown.
In FIG. 32, the n-type oxide semiconductor layer 371 is formed on the gate insulating film 30. Then, the third resist 372 is applied on the n-type oxide semiconductor layer 371. Subsequently, the third resist 372 is formed into a predetermined shape by half-tone exposure technology by using the third half-tone mask 373a. That is, the third resist 372 is formed into such a shape that it covers the upper part of the glass substrate 101, except for the part above the contact hole 155, the opening 114b' of the pad for a data line 114b, the opening 124b' of the pad for a scanning line 124b and the opening 154b' of the pad for a measuring line 154b. Then, by using a half-tone mask part 3731, the third resist 372 is formed into such a shape that the part thereof covering the gate electrode 34 and the gate electrode 54 is thicker than other parts.

Subsequently, as shown in FIG. 32(b), as fourth etching, the n-type oxide semiconductor layer 371 is patterned with an etching method by using the third resist 372 and an aqueous oxalic acid solution. Subsequently, the gate insulating film 30 is patterned with a dry etching method by using the third resist 372 and an etching gas (CHF (CF₄, CHF₃ gas, or the like)), whereby the contact hole 155, the opening 114b' of the pad for a data line 114b, the opening 124b' of the pad for a scanning line 124b and the opening 154b' of the pad a the measuring line 154b are formed.
Subsequently, the third resist 372 is removed through an ashing process, and the third resist 372 is reformed into such a shape that the gate electrode 34 and the gate electrode 54 are covered.

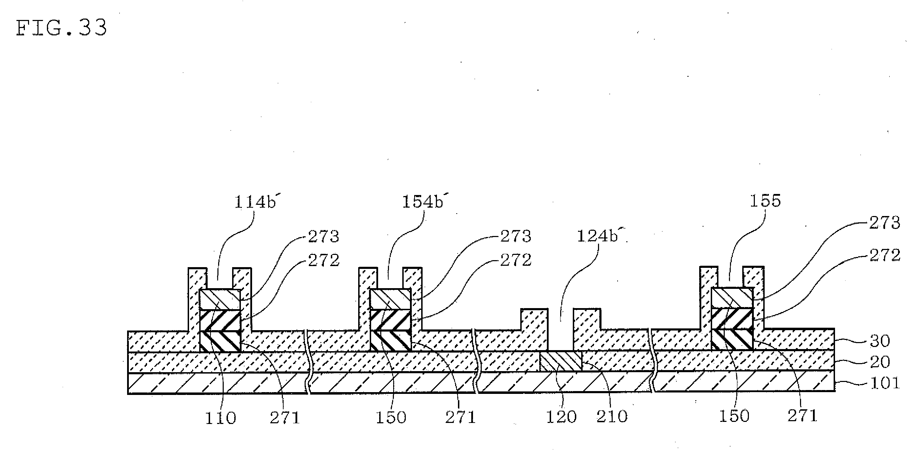

FIG. 33 is a schematic view for explaining a treatment by using the third half-tone mask in the method for producing a TFT substrate to be used in the organic EL display apparatus according to the application example of the second embodiment of the invention, showing a cross-sectional view after the fifth etching/after the peeling off the third resist.

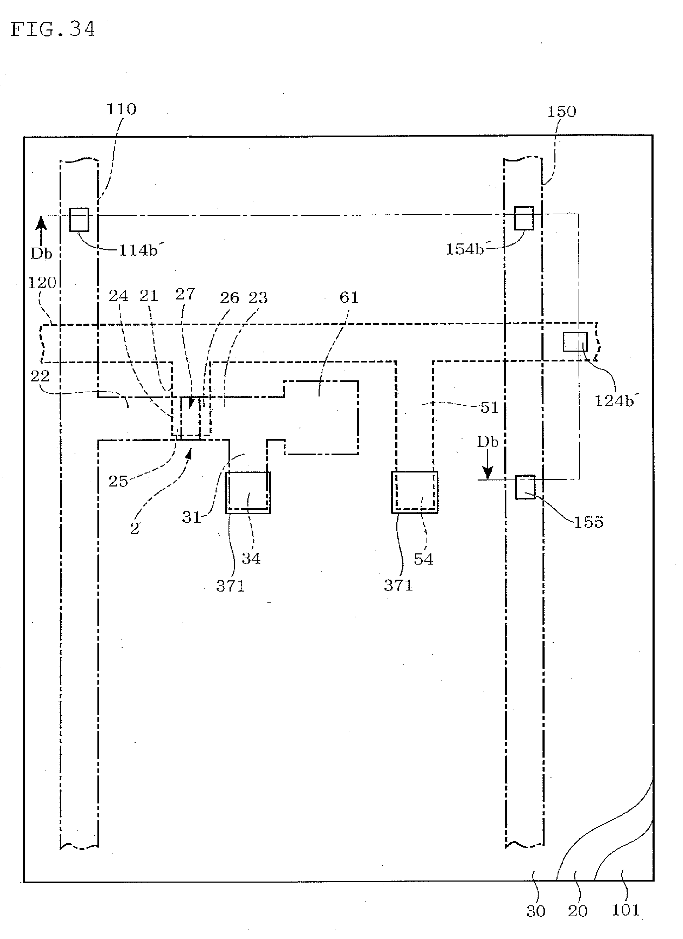

In FIG. 33, as the fifth etching, the n-type oxide semiconductor layer 371 is patterned with an etching method by using the reformed third resist 372 and an aqueous oxalic acid solution. As a result, active layers of the driving transistor 3 and the measuring transistor 5 which are composed of the n-type oxide semiconductor layer 371 are formed, and the gate insulating film 30 is exposed. Subsequently, the third resist 372 is removed through an ashing process to expose the n-type oxide semiconductor layer 371. The opening 114b' of the pad for a data line 114b, the opening 154b' of the pad for a measuring line 154b, the opening 124b' of the pad for a scanning line 124b and the contact hole 155 of the measuring line 150 in FIG. 33 are cross-sectional views taken along line Db-Db in FIG. 34.

Subsequently, as shown in FIG. 31, the oxide transparent conductor layer 374, the metal layer 375 and a fourth resist 376 are stacked. Subsequently, by using the fourth half-tone mask 377, the EL-driving line 130, the second electrode 62 of the capacitor 6, the pixel electrode 38, the pad for a data line 114b, the pad for a scanning line 124b, the pad for a measuring line 154b, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 are formed (Step S6b).
Next, a treatment by using the fourth half-tone mask 377 is explained with reference to the drawing.

### (Treatment by using a fourth half-tone mask)

FIG. 35 is a schematic view for explaining a treatment by using the fourth half-tone mask in the method for producing a TFT substrate to be used in an organic EL display apparatus according to the application example of the second embodiment of the invention, in which (a) is a cross-sectional view after the formation of the oxide transparent conductor layer/after the formation of the metal layer/after the application of the fourth resist/after half-tone exposure/after development; and (b) is a cross-sectional view after the sixth etching/after the reformation of the fourth resist/after the seventh etching/after the peeling off the fourth resist.
In the meantime, the methods for producing the driving transistor 3 and the measuring transistor 5 in the step S6b are almost similar to those in the step S6a in the second embodiment (see FIGs. 26 and 27). Therefore, in FIG. 35, the pad for a data line 114b, the pad for a scanning line 124b, the pad for a measuring line 154b and the drain line 53 of the measuring transistor 5 are shown.
In FIG. 35 (a), on the gate insulating film 30 and the n-type oxide semiconductor layer 371, which are exposed, an oxide transparent conductor layer 374 is formed in a thickness of about 120 nm by using an indium oxide-tin oxide-zinc oxide (In₂O₃:SnO₂:ZnO=about 60:20:20 wt%) target by the high-frequency sputtering method. This layer formation is conducted under the condition of an oxygen-to-argon ratio of about 1:99 (vol%) and a substrate temperature which does not cause the oxide transparent conductor layer 374 to be crystallized.

Then, the metal layer 375 is formed. This metal layer 375 is an auxiliary conductor layer and is composed of an Mo layer/an Al layer/an Mo layer. Specifically, Mo, Al and Mo are stacked in this order by using the high-frequency sputtering method in a thickness of about 50 nm, about 250 nm and about 50 nm, respectively.
Then, the fourth resist 376 is applied on the metal layer 375. The fourth resist 376 is formed into a predetermined shape by half-tone exposure by using the fourth half-tone mask 377. That is, the fourth resist 376 is formed into such a shape that it covers the EL-driving line 130, the second electrode 62 of the capacitor 6, the pixel electrode 38, the pad for a data line 114b, the pad for a scanning line 124b, the pad for a measuring line 154b, the source line 32, the source electrode 35, the drain electrode 36 and the drain line 33 of the driving transistor 3, as well as the source line 52, the source electrode 55, the drain electrode 56 and the drain line 53 of the measuring transistor 5. In addition, by using a half-tone mask part 378, the fourth resist 376 is formed into such a shape that the part thereof covering the pixel electrode 38 is thinner than other parts.

Then, as shown in FIG. 35(b), as the sixth etching, the metal layer 375 is patterned with an etching method by using the fourth resist 376 and an acid mixture etching solution. Subsequently, the oxide transparent conductor layer 374 is patterned with an etching method by using the fourth resist 376 and an aqueous oxalic acid solution. As a result, the EL-driving line 130, the second electrode 62 of the capacitor 6, the pixel electrode 38, the pad for a data line 114b, the pad for a scanning line 124b, the pad for a measuring line 154b, the source line 32, the source electrode 35, the channel part, 37, the drain electrode 36 and the drain line 33 of the driving transistor 3, as well as the source line 52, the source electrode 55, the channel part 57, the drain electrode 56 and the drain line 53 of the measuring transistor 5 are formed (Step S6b).

In the meantime, as mentioned above, in the step S6b, the fourth resist 376 is removed through an ashing process, whereby the fourth resist 376 is reformed. When the fourth resist 376 is reformed, the metal layer 375 above the pixel electrode 38 is exposed, and the EL-driving line 130, the second electrode 62 of the capacitor 6, the pad for a data line 114b, the pad for a scanning line 124b, the pad for a measuring line 154b, the source line 32, the source electrode 35, the drain electrode 36 and the drain line 33 of the driving transistor 3, as well as the source line 52, the source electrode 55, the drain electrode 56 and the drain line 53 of the measuring transistor 5 are covered by the reformed fourth resist 376.
Then, as the seventh etching, the metal layer 375 is patterned with an etching method by using the reformed fourth resist 376 and an acid mixture etching solution to expose the pixel electrode 38.

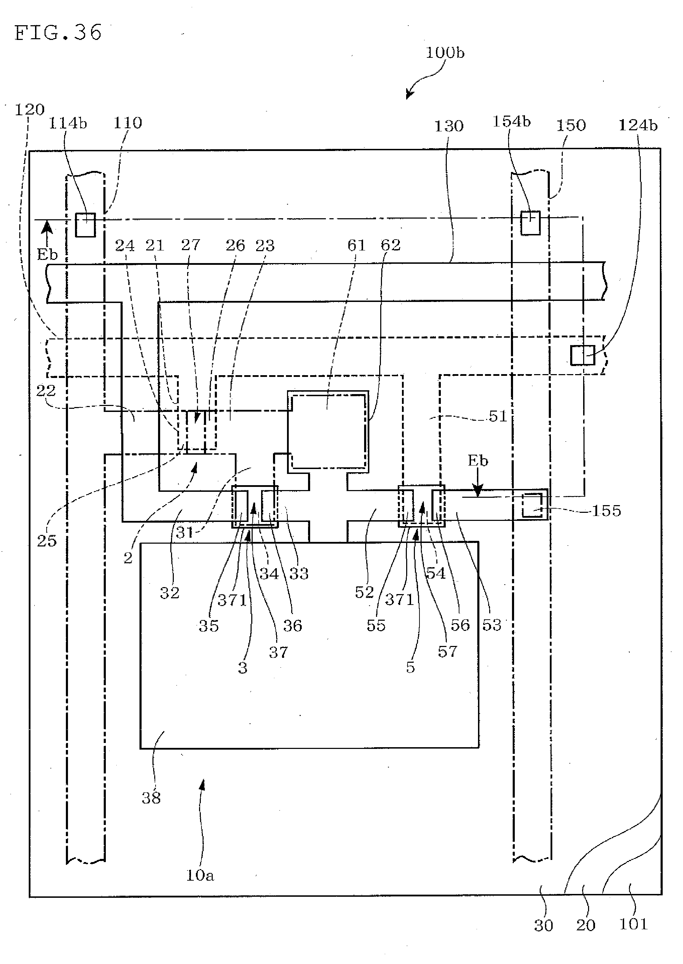

Then, the reformed fourth resist 376 is removed through an ashing process. As a result, as shown in FIG. 35, the EL-driving line 130, the second electrode 62 of the capacitor 6, the pad for a data line 114b, the pad for a scanning line 124b, the pad for a measuring line 154b, the pixel electrode 38, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 are exposed on the gate insulating film 30. The EL-driving line 130, the second electrode 62 of the capacitor 6, the pad for a data line 114b, the pad for a scanning line 124b, the pad for a measuring line 154b, he pixel electrode 38, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 shown in FIG. 35 are cross-sectional views taken along line Eb-Eb in FIG. 36.

### (Treatment by using a fifth mask)

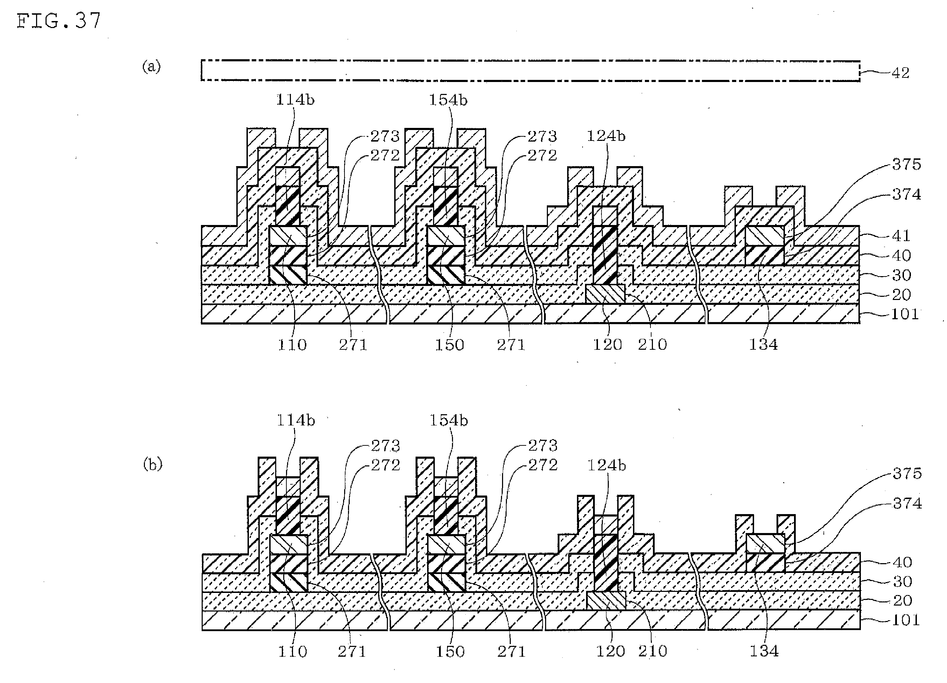

FIG. 37 is a schematic view for explaining a treatment by using the fifth mask in the method for producing a TFT substrate to be used in an organic EL display apparatus according to the application example of the second embodiment of the invention, in which (a) is a cross-sectional view after the formation of the protective insulating film/after the application of the fifth resist/after exposure/after development; and (b) is a cross-sectional view after the eighth etching/after the peeling off the fifth resist.
In FIG. 37(a), the protective insulating film 40 is stacked by the glow discharge CVD (Chemical Vapor Deposition) method above the glass substrate 101. This protective insulting film 40 is a silicon nitride (SiNₓ) film and has a thickness of about 250 nm. In this embodiment, an SiH₄-NH₃-N₂-based mixed gas is used as a discharge gas.

Then, the fifth resist 41 is applied on the protective insulating film 40. The fifth resist 41 having openings above the pixel electrode 38, the pad for a data line 114b, the pad for a scanning line 124b, the pad for a measuring pad 154b and the pad for an EL-driving line 134 is formed by using the fifth mask 42 and by exposure technology. In the meantime, in FIG. 37, the pad for a data line 114b, the pad for a scanning line 124b, the pad for an EL-driving line 134 and the pad for a measuring line 154b are shown (for other structure, see FIG. 29).
Subsequently, as the eighth etching, the protective insulating film 40 is patterned with a dry etching method by using an etching gas (CHF (CF₄, CHF₃ gas, or the like)) to expose the pixel electrode 38, the pad for a data line 114b, the pad for a scanning line 124b, the pad for a measuring line 154b and the pad for an EL-driving line 134 (Step S7a).

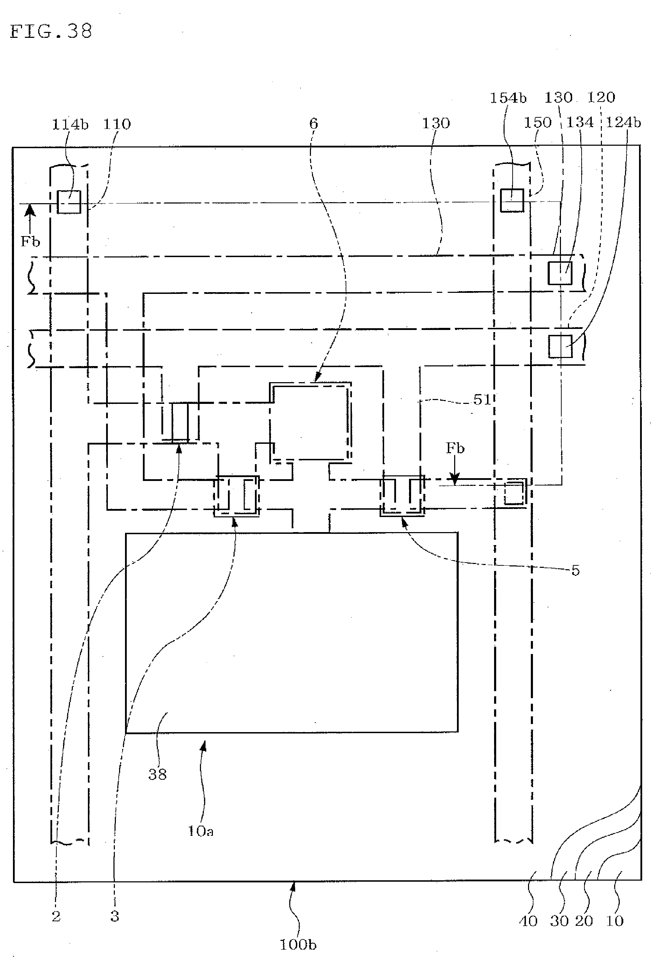

Subsequently, the reformed fifth resist 41 is removed through an ashing process. As a result, as shown in FIG. 37, the protective insulating film 40 is exposed. The pad for a data line 114b, the pad for a scanning line 124b, the pad for a measuring line 154b and a pad for an EL-driving line 134 in FIG. 37 (b) are cross-sectional views taken along line Fb-Fb in FIG. 38.

As mentioned above, according to the method for producing the TFT substrate for current control 100b of this application example, the advantageous effects almost similar to those attained by the production method in the second embodiment can be attained. In addition, the pad for a data line 114b, the pad for a scanning line 124b, the pad for a measuring line 154b and the pad for an EL-driving line 134 are formed immediately below the protective insulating film 40. As a result, connectability to the pad for a data line 114b, the pad for a scanning line 124b, the pad for a measuring line 154b and the pad for an EL-driving line 134 can be improved.

### [Third embodiment of a dispersion-type inorganic EL display apparatus]

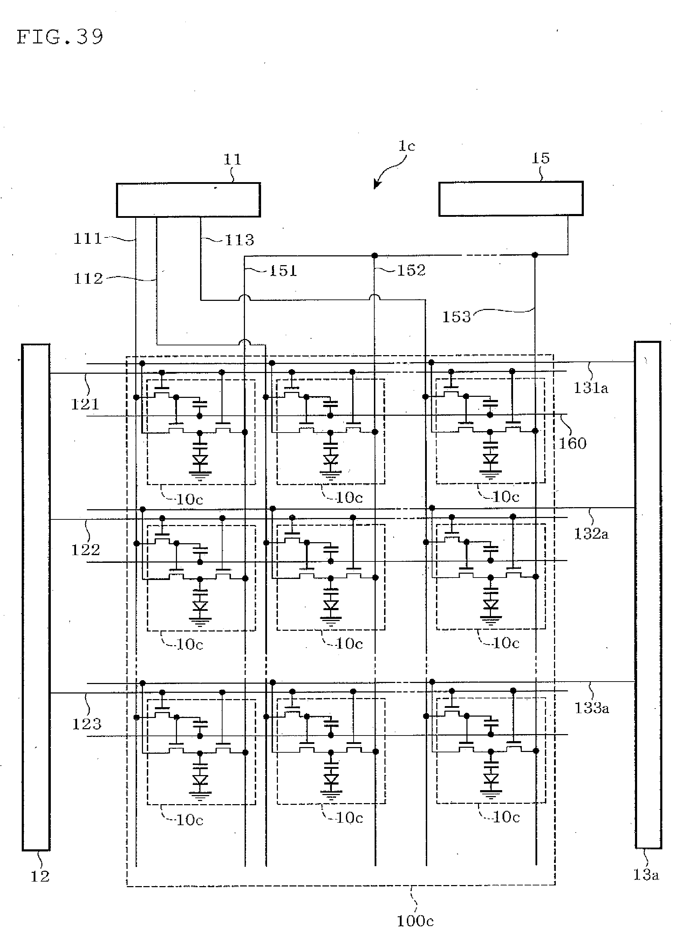

FIG. 39 is a schematic block diagram of a dispersion-type inorganic EL display apparatus according to a third embodiment of the invention.
In FIG. 39, a dispersion-type inorganic EL display apparatus 1c as an electro-optic apparatus comprises a data line-driving circuit 11, a scanning line-driving circuit 12, a power supply line-controlling circuit 13a, a current-measuring circuit 15 and a TFT substrate for current control 100c (hereinafter occasionally abbreviated as "TFT substrate 100c"). On the TFT substrate 100c, m (row; m is a natural number) × n (line; n is a natural number) pixels 10c are arranged in a matrix.

The data line-driving circuit 11 is connected with each pixel 10c through a first data line 111, a second data line 112,... and the mth data line 113. For example, the data line-driving circuit 11 is connected in parallel with n pieces of pixel 10c arranged in the mth row through the mth data line 113. This data line-driving circuit 11 outputs a data signal to each pixel 10c.

The scanning line-driving circuit 12 is connected with each pixel 10c through a first scanning line 121, a second scanning line 122,... and the nth scanning line 123. For example, the scanning line-driving circuit 12 is connected in parallel with m pieces of pixel 10c arranged in the nth line through the nth scanning line 123. This scanning line-driving circuit 12 outputs a data signal to each pixel 10c.

Furthermore, the power supply line-controlling circuit 13a is connected with each pixel 10c through a first EL-driving line 131a, a second EL driving line 132a,...and the nth EL driving line 133a. For example, the power supply line-controlling circuit 13a is connected in parallel with m pieces of pixel 10c arranged in the nth line through the nth EL-driving line 133a. This power supply line-controlling circuit 13a supplies an alternating driving current to each pixel 10c.

Furthermore, the current-measuring circuit 15 is connected with each pixel 10c through a first scanning line 151, a second scanning line 152,... and the mth scanning line 153. For example, the current-measuring circuit 15 is connected in parallel with n pieces of pixel 10c arranged in the mth row through the mth measuring line 153. This current-measuring circuit 15 measures alternating current supplied to the dispersion-type inorganic EL device 4c in each pixel 10c.

In addition, it is preferred that the current-measuring circuit 15 measure alternating current supplied to the dispersion-type inorganic EL device 4c. The control part (not shown) may control at least one of the data line-driving circuit 11, the scanning line-driving circuit 12 and the power supply line-controlling circuit 13a based on this measured alternating current value. By doing this, alternating current supplied to the dispersion-type inorganic EL device 4c can be measured, and at least one of the data line-driving circuit 11, the scanning line-driving circuit 12 and the power supply line-controlling circuit 13a can be controlled based on this measured value. As a result, it is possible to supply preferable driving current to the dispersion-type inorganic EL device 4c.

The structure of the pixel 10c is explained with reference to the drawing.

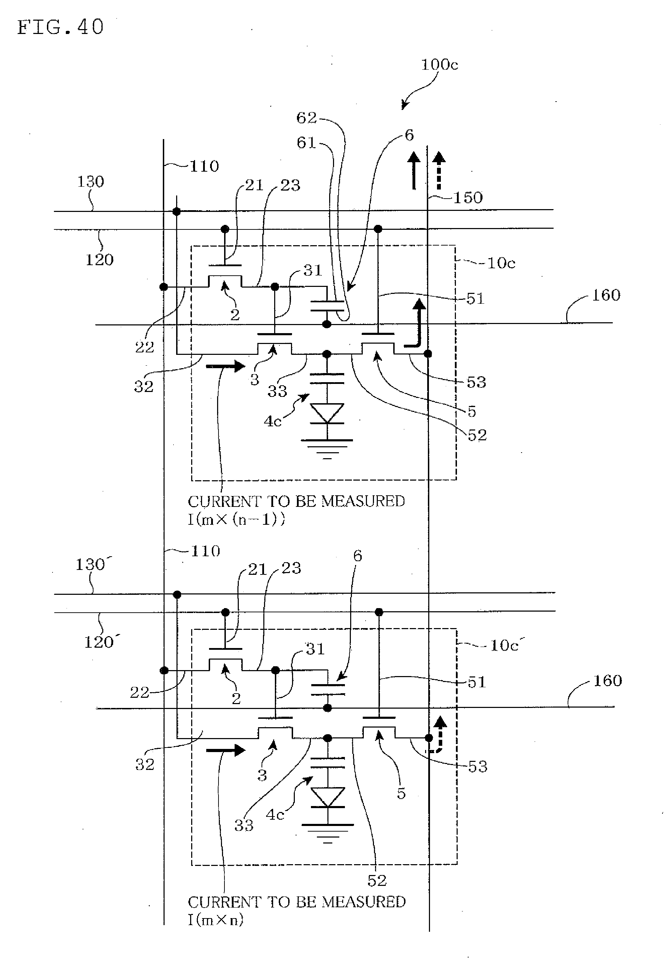

FIG. 40 is a schematic block diagram for explaining the structure of a pixel of the dispersion-type inorganic EL display apparatus according to the third embodiment of the invention.
In FIG. 40, the pixel 10c has the driving transistor 3, the switching transistor 2, the capacitor 6, the capacitor line 160, the measuring transistor 5 and the dispersion-type inorganic EL device 4c.
The driving transistor 3 supplies alternating current to the dispersion-type inorganic EL device 4c. The switching transistor 2 controls the driving transistor 3. By the capacitor 6, a capacitor voltage is applied to the gate electrode 34 of the driving transistor 3. By the measuring transistor 5, alternating current to be supplied to the dispersion-type inorganic EL device 4c can be measured. The dispersion-type inorganic EL device 4c as an electro-optic device can be driven by alternating current.
The switching transistor 2, the driving transistor 3 and the measuring transistor 5 are formed on the TFT substrate 100c as thin film transistors. In addition, the capacitor 6 and the pixel electrode 38 of the dispersion-type inorganic EL device 4c are formed on the TFT substrate 100c.

The switching transistor 2 is connected with the scanning line 120 through the gate line 21. The switching transistor 2 is connected with the data line 110 through the source line 22. The drain line 23 of the switching transistor 2 is connected in parallel with the gate line 31 of the driving transistor 3 and the first electrode 61 of the capacitor 6. The second electrode 62 of the capacitor 6 is connected with the capacitor line 160. It is preferred that the capacitor line 160 be grounded or connected in a manner corresponding to grounding.
The driving transistor 3 is connected with the EL-driving line 130 through the source line 32. The driving transistor 3 is connected in parallel with the dispersion-type inorganic EL device 4c and the source line 52 of the measuring transistor 5 through the drain line 33.
Furthermore, the gate line 51 of the measuring transistor 5 is connected with the scanning line 120. The drain line 53 of the measuring transistor 5 is connected with the measuring line 150.

The operation of the TFT substrate 100c is explained with reference to FIG. 40.
First, in the TFT substrate 100c having the above-mentioned structure, a scanning signal is input to the scanning line 120. By doing this, a gate signal (scanning signal) is input to the gate electrode 24 of the switching transistor 2, and the switching transistor 2 turns to the ON-state. Furthermore, a gate signal (scanning signal) is input from the scanning line 120 to the gate electrode 54 of the measuring transistor 5, and the measuring transistor 5 turns to the ON-state.

Subsequently, a data signal (gate voltage (direct voltage) of the driving transistor 3) is applied from the data line 110 to the gate electrode 34 of the driving transistor 3, and the driving transistor 3 turns to the ON-state. Furthermore, the capacitor 6 stores carriers corresponding to the data signal from the data line 110. At this time, the source-drain resistance value of the driving transistor 3 is determined according to the gate voltage applied to the gate electrode 34 of the driving transistor 3. Driving current corresponding to the source-drain resistance value is supplied from the EL-driving line 130 to the drain line 33. Here, the measuring transistor 5 is in the ON-state. Therefore, the above-mentioned driving current (current to be measured I (m × (n-1)) flows to the measuring line 150 through the source line 52 and the drain line 53 of the measuring transistor 5 almost without flowing to the organic EL device 4c.

Subsequently, the current-measuring circuit 15 measures the above-mentioned current to be measured I (m × (n-1)), and the control part controls the data line-driving circuit 11 based on the measured value of the current to be measured I (m × (n-1)). That is, if the measured value is smaller than the prescribed value, the control part increases the voltage of the data signal to be sent to the data line 110. By doing this, the source-drain resistance value of the driving transistor 3 is decreased, and the driving current is increased. In contrast, if the measured value is larger than the prescribed value, the voltage of the data signal to be sent to the data line 110 is decreased. By doing this, the source-drain resistance value of the driving transistor 3 is increased, and the driving current is decreased. If the control part repeats the above-mentioned control operation, the measured value becomes almost equal to the prescribed value.

When the measured value becomes almost equal to the prescribed value, the scanning line-driving circuit 12 stops the output of a scanning signal to the scanning line 120. This stoppage allows the switching transistor 2 and the measuring transistor 5 turn to the OFF-state. If the switching transistor 2 turns to the OFF-state, a gate voltage cannot be applied from the data line 110 to the driving transistor 3. However, due to the carriers stored in the capacitor 6, the same voltage as a gate voltage applied from the data line 110 is applied to the gate electrode 34 of the driving transistor 3. That is, during which the switching transistor 2 is in the ON-state, direct voltage is applied from the data line 110 to the second electrode 62 of the capacitor 6. At this time, carriers are stored in the capacitor 6, since the first electrode 61 of the capacitor 6 is connected with the capacitor line 160. As a result, a gate voltage is applied to the gate electrode 34 by the capacitor 6. In the meantime, since the second electrode 62 of the capacitor 6 is connected with the capacitor line 160, it is not affected by the driving current (alternating current). Accordingly, the TFT substrate 100c is called as a TFT substrate for AC control. In addition, the TFT substrate 100c can be used also as a DC-driven TFT substrate.

Then, the driving transistor 3 is maintained in the ON-state by the capacitor 6, and the measuring capacitor 5 is in the OFF-state. Therefore, the alternating current from the EL-driving line 130 is supplied to the dispersion-type inorganic EL device 4c through the driving transistor 3.
This alternating current is the same as that of the current to be measured I (m × (n-1)). The driving current, which is almost the same as that of the prescribed value controlled by the control part, is supplied to the dispersion-type inorganic EL device 4c. The dispersion-type inorganic EL device 4c emits light with a luminance corresponding to this driving current.
If the above-mentioned driving current is to be changed, a scanning signal is output to the scanning line 120 and a data signal corresponding to driving current to be changed is output to the data line 110.

Next, in the dispersion-type inorganic EL display apparatus 1c, the pixels 10c' operates in a way almost similar to the pixels 10c. That is, for all the pixels 10c', the dispersion-type inorganic EL display apparatus 1c can supply driving current which is almost the same as that of the prescribed value, even though the properties of the driving transistor 3 are changed (deteriorated). Therefore, the dispersion-type inorganic display apparatus 1c can provide an image of improved quality.
In the dispersion-type inorganic EL display apparatus 1c of this embodiment, the control part is provided with a storing means which stores a prescribed value of each pixel 10c' and a calculating part which calculates a difference between the measured value and the prescribed value. This control part controls in such a manner that the measured value becomes almost equal to the prescribed value. However, the control method is not limited thereto, and various control methods can be used.

As mentioned above, the dispersion-type inorganic EL display apparatus 1c of this embodiment can supply driving current which is almost similar to the prescribed value measured by the current-measuring circuit 15 to the dispersion-type inorganic EL device 4c which is driven by alternating current. Therefore, the dispersion-type inorganic EL display apparatus 1c can provide an image of improved quality. In this embodiment, the dispersion-type inorganic EL device 4c is used as an AC-driven electro-optic device. However, usable electro-optic devices are not limited thereto. For example, DC-driven electro-optic devices and/or AC-driven electro-optic devices can be used widely.
In the dispersion-type inorganic EL display apparatus 1c of this embodiment, the active layer of the driving transistor 3 is composed of the n-type oxide semiconductor layer 371 as an oxide semiconductor layer. By doing this, the driving transistor 3 suffers from only a small degree of deterioration even though a large amount of current is flown or a large amount of power is input to the driving transistor 3 as compared with a TFT substrate in which amorphous Si or a polysilicon semiconductor is used as the active layer of the driving transistor 3. As a result, the dispersion-type inorganic EL display apparatus 1c is improved in stability. Furthermore, the durability of the TFT substrate 100c is improved. Therefore, the life of the dispersion-type inorganic EL display apparatus 1c can be significantly prolonged.

In the meantime, the display apparatus 1c of this embodiment can be applied to each of a DC-driven electro-optic device or an AC-driven electro-optic device even though amorphous Si or a polysilicon semiconductor is used as an active layer of the driving transistor 3. This is very effective. In addition, when alternating current is supplied to an electro-optic device, a high-frequency power can also be supplied. This is also effective. Furthermore, in the conventional technologies, AC driving is conducted by reversing the voltage for each scan or by reversing the voltage for each scanning line. In the display apparatus 1c, such an operation is not required. This is also effective.
Next, the production method and configuration of the above-mentioned TFT substrate 100c are explained with reference to the drawing. First, the method for producing the TFT substrate 100c is explained.

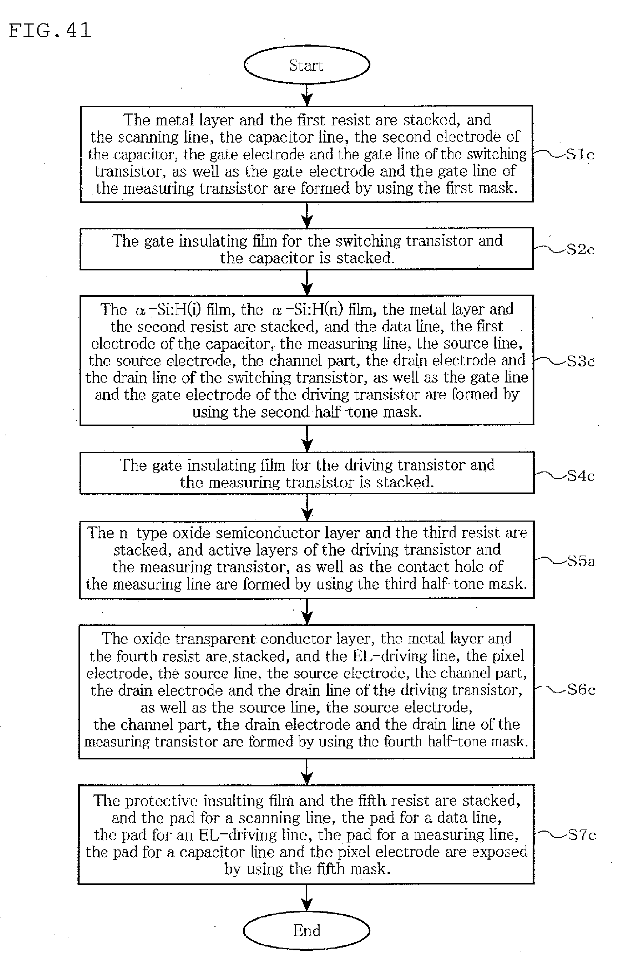

[Third embodiment of a TFT substrate for current control] FIG. 41 is a schematic flow chart for explaining the method for producing a TFT substrate to be used in the dispersion-type inorganic EL display apparatus according to the third embodiment of the invention. In the meantime, the production method in this embodiment corresponds to claim 19.
In FIG. 41, first, on a substrate, a metal layer 210 and a first resist 211 are stacked in this order, and by using the first mask 212, the scanning line 120, the capacitor line 160, the second electrode 62 of the capacitor 6, the gate electrode 24 and the gate line 21 of the switching transistor 2, as well as the gate electrode 54 and the gate line 51 of the measuring transistor 5 are formed (Step S1c).
Next, a treatment by using a first mask 212 is explained with reference to the drawing.

### (Treatment by using a first mask)

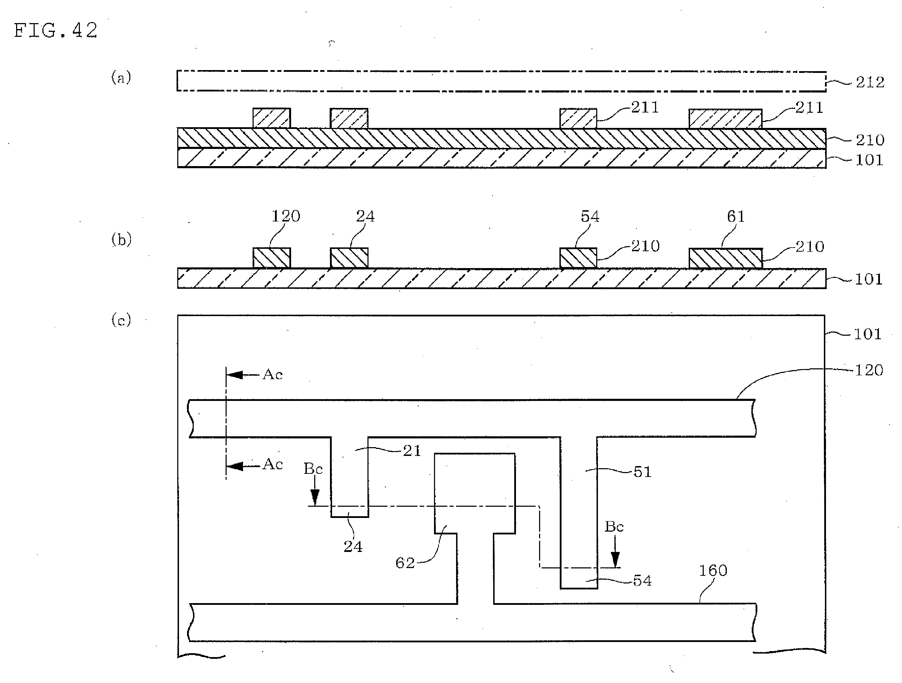

FIG. 42 is a schematic view for explaining a treatment by using the first mask in the method for producing a TFT substrate to be used in the dispersion-type inorganic EL display apparatus according to the third embodiment of the invention, in which (a) is a cross-sectional view after the formation of the metal layer/after the application of the first resist/after exposure/after development; (b) is a cross-sectional view after the first etching/after the peeling off the first resist; and (c) is a plan view of an essential part of the TFT substrate after the peeling off the first resist.
In FIG. 42(a), first, a light-transmissive glass substrate 101 is provided.

On the glass substrate 101, the metal layer 210 as a conductor layer is formed. Specifically, Al (aluminum) and Mo (molybdenum) are stacked in this order by using the high-frequency sputtering method in a thickness of about 250 nm and about 50 nm, respectively. The scanning line 120, the capacitor line 160, the second electrode 62 of the capacitor 6, the gate electrode 24 and the gate line 21 are formed of this metal layer 210.
Subsequently, the first resist 211 is applied on the metal layer 210. Furthermore, by using the first mask 212, the first resist 211 is formed into a predetermined shape by photolithography.

Then, as shown in FIG. 42(b), as the first etching, the metal layer 210 is patterned with an etching method by using an acid mixture etching solution. As a result, the scanning line 120, the capacitor line 160, the second electrode 62 of the capacitor 6, the gate lines 21 and 51 and the gate electrodes 24 and 54 are formed (Step S1c).
Then, the first resist 211 is removed through an ashing process. As a result, as shown in FIG. 42 (c), the scanning line 120, the capacitor line 160, the second electrode 62 of the capacitor 6 connected with this capacitor line 160, as well as the gate lines 21 and 51 and the gate electrodes 24 and 54 connected with the scanning line 120 are exposed on the glass substrate 101. The scanning line 120 shown in FIG. 42(b) is a cross-sectional view taken along line Ac-Ac in FIG. 42(c). The gate electrode 24 of the switching transistor 2 and the gate electrode 54 of the measuring transistor 5 and the first electrode 61 shown in FIG. 42 (b) are cross-sectional views taken along line Bc-Bc in FIG. 42(c).

Then, as shown in FIG. 41, a gate insulating film 20 is stacked by the glow discharge CVD (Chemical Vapor Deposition) method on the glass substrate 101, the scanning line 120, the capacitor line 160, the second electrode 62 of the capacitor 6, the gate lines 21 and 51, the gate electrodes 24 and 54 (Step S2c). The gate insulating film 20 is a silicon nitride (SiNₓ) film, and has a thickness of about 300 nm. This gate insulating film 20 is formed as a gate insulating film 20 for the switching transistor 2, the measuring transistor 5 and the capacitor 6. In this embodiment, an SiH₄-NH₃-N₂-based mixed gas is used as a discharge gas.

Then, as shown in FIG. 41, the α-Si:H(i) film 271, the α-Si:H (n) film 272, the metal layer 273 as a conductor layer and a second resist 274 are stacked, and by using a second half-tone mask 275c, the data line 110, the first electrode 61 of the capacitor 6, the measuring line 150, the source line 22, the source electrode 25, the channel part 27, the drain electrode 26 and the drain line 23 of the switching transistor 2, as well as the gate line 31 and the gate electrode 34 of the driving transistor 3 are formed (Step S3c).
Next, a treatment by using the second half-tone mask 275c is explained with reference to the drawing.

### (Treatment by using a second half-tone mask)

FIG. 43 is a schematic view for explaining a treatment by using the second half-tone mask in the method for producing a TFT substrate to be used in the dispersion-type inorganic EL display apparatus according to the third embodiment of the invention, in which (a) is a cross-sectional view after the formation of the gate insulating film/after the formation of the α-Si:H(i) film/after the formation of the α-Si:H(n) film/after the formation of the metal layer/after the application of the second resist/after half-tone exposure/after development; (b) is a cross-sectional view after the second etching/after the reformation of the second resist; and (c) is a cross-sectional view after the third etching/after the peeling off the second resist.
In FIG. 43(a), first, the α-Si:H(i) film 271 is stacked on the gate insulating film 20. The α-Si:H(i) film 271 is an insulating layer of amorphous Si(silicon), and has a thickness of about 350 nm. At this time, an SiH₄-N₂-based mixed gas is used as a discharge gas.
Subsequently, the α-Si:H(n) film 272 is stacked by using an SiH₄-N₂-PH₃-based mixed gas. The α-Si:H(n) film 272 is a n-type semiconductor layer of amorphous Si and has a thickness of about 300 nm.
Then, the metal layer 273 composed of an Mo layer/an Al layer/an Mo layer is formed. Specifically, Mo, Al and Mo are stacked in this order by using the high-frequency sputtering method in a thickness of about 50 nm, about 250 nm and about 50 nm, respectively.

Then, a second resist 274 is applied on the metal layer 273. The second resist 274 is formed into a predetermined shape by half-tone exposure by using a second half-tone mask 275c. That is, the second resist 274 is formed into such a shape that it covers the data line 110, the first electrode 61 of the capacitor 6, the measuring line 150, the source line 22, the source electrode 25, the gate electrode 24, the drain electrode 26 and the drain line 23 of the switching transistor 2, and the gate line 31 and the gate electrode 34 of the driving transistor 3. In addition, by using a half-tone mask part 276, the second resist 274 is formed into such a shape that the part thereof covering the channel part 27 is thinner than other parts.

Subsequently, as shown in FIG. 43(b), as the second etching, the metal layer 273 is patterned with an etching method by using the second resist 274 and an acid mixture etching solution. Then, the α-Si:H (n) film 272 and the α-Si:H(i) film 271 are patterned with a dry etching method using a CHF gas and a wet etching method using an aqueous hydrazine solution (NH₂NH₂·H₂O), whereby the data line 110, the first electrode 61 of the capacitor 6, the measuring line 150, the source line 22, the drain line 23, the gate line 31 and the gate electrode 34 are formed. Here, the capacitor 6 is insulated by the gate insulating film 20.

Subsequently, the second resist 274 is removed through an ashing process, whereby the second resist 274 is reformed. When the second resist 274 is reformed, the metal layer 273 above the channel part 27 is exposed, and the data line 110, the first electrode 61, the measuring line 150, the source line 22, the source electrode 25, the drain electrode 26 and the drain line 23 of the switching transistor 2, and the gate line 31 and the gate electrode 34 of the driving transistor 3 are covered by the reformed second resist 274.

Subsequently, as shown in FIG. 43(c), as the third etching, the metal layer 273 is patterned with an etching method by using the reformed second resist 274 and the acid mixture etching solution, whereby the source electrode 25 and the drain electrode 26 are formed. Then, the α-Si:H(n) film 272 is patterned with a dry etching method using a CHF gas and a wet etching method using an aqueous hydrazine solution (NH₂NH₂·H₂O). As a result, the channel part 27 composed of the α-Si:H(i) film 271 is formed, and the source electrode 25 and the drain electrode 26 of the switching transistor 2 are formed (Step S3c).

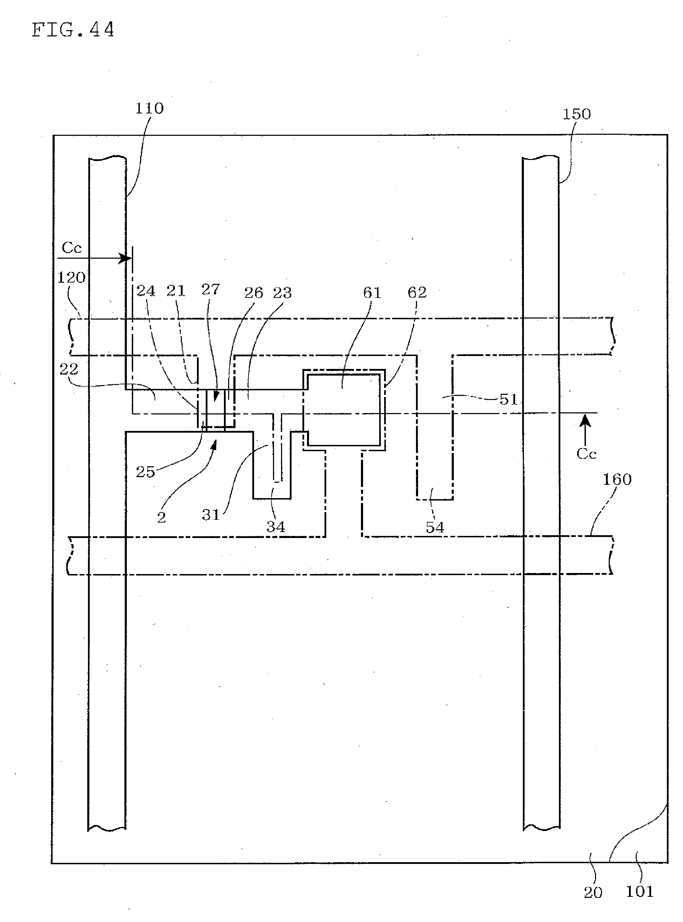

Then, the reformed second resist 274 is removed through an ashing process. As a result, as shown in FIG. 43(c), the data line 110, the first electrode 61, the measuring line 150, the source line 22, the source electrode 25, the channel part 27, the drain electrode 26 and the drain line 23 of the switching transistor 2, and the gate line 31 and the gate electrode 34 of the driving transistor 3 are exposed on the gate insulating film 20. The data line 110, the capacitor line 160, the first electrode 61, the measuring line 150, the source line 22, the source electrode 25, the gate electrode 24, the channel part 27, the drain electrode 26 and the drain line 23 of the switching transistor 2, and the gate line 31 and the gate electrode 34 of the driving transistor 3 in FIG. 43(c) are cross-sectional views taken along line Cc-Cc in FIG. 44.

Then, as shown in FIG. 41, a gate insulating film 30 is stacked by the glow discharge CVD (Chemical Vapor Deposition) method on the glass substrate 101 (Step S4c). The gate insulating film 30 is a silicon nitride (SiNₓ) film, and has a thickness of about 300 nm. This gate insulating film 30 is formed as a gate insulating film 30 for the driving transistor 3 and the measuring transistor 5. In this embodiment, an SiH₄-NH₃-N₂-based mixed gas is used as a discharge gas.

Then, as shown in FIG. 41, on the gate insulating film 30, the n-type oxide semiconductor layer 371 as an oxide semiconductor layer and the third resist 372 are stacked, and active layers of the driving transistor 3 and the measuring transistor 5, as well as the contact hole 155 of the measuring line 150 are formed by using a third half-tone mask 373a (Step S5a).
Next, a treatment by using the third half-tone mask 373a is explained with reference to the drawing.

### (Treatment by using a third half-tone mask)

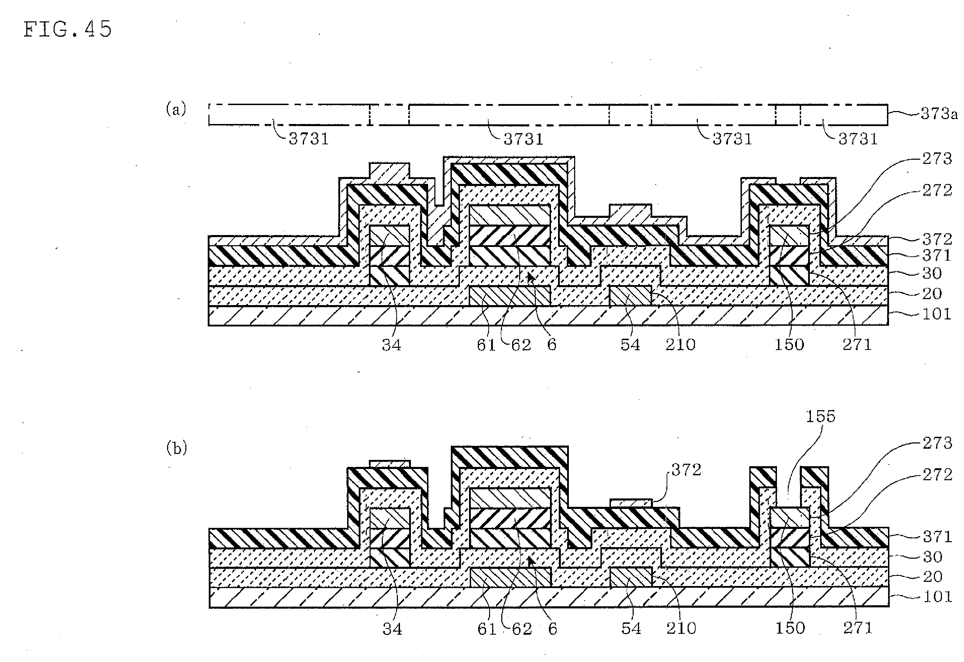

FIG. 45 is a schematic view for explaining a treatment by using the third half-tone mask in the method for producing a TFT substrate to be used in the dispersion-type inorganic EL display apparatus according to the third embodiment of the invention, in which (a) is a cross-sectional view after the formation of the gate insulating film/after the formation of the n-type oxide semiconductor layer/after the application of the third resist/after half-tone exposure/after development; and (b) is a cross-sectional view after the fourth etching/after the reformation of the third resist.
In FIG. 45, the n-type oxide semiconductor layer 371 with a thickness of about 150 nm is formed on the gate insulating film 30 by using an indium oxide-zinc oxide (In₂O₃:ZnO=about 97:3 wt%) target. This layer formation is conducted under the condition of an oxygen-to-argon ratio of about 10:90 (vol%) and a substrate temperature of about less than 100°C. Under this condition, the n-type oxide conductor layer 371 is obtained as an amorphous film.

Then, the third resist 372 is applied on the n-type oxide semiconductor layer 371. The third resist 372 is formed into a predetermined shape by half-tone exposure technology by using a third half-tone mask 373a. That is, the third resist 372 is formed into such a shape that it covers the upper part of the glass substrate 101 entirely, except for the part above the contact hole 155. In addition, by using a half-tone mask part 3731, the third resist 372 is formed into such a shape that the part thereof covering the gate electrode 34 and the drain line 53 is thicker than other parts.

Subsequently, as shown in FIG. 45(b), as the fourth etching, the n-type oxide semiconductor layer 371 is patterned with an etching method by using the third resist 372 and an aqueous oxalic acid solution. Then, the gate insulating film 30 is patterned with a dry etching method using the third resist 372 and a CHF gas (CF₄, CHF₃ gas, or the like), whereby the contact hall 155 is formed.
Subsequently, the third resist 372 is removed through an ashing process, and the third resist 372 is reformed into such a shape that it covers the gate electrode 34 and the drain line 53.

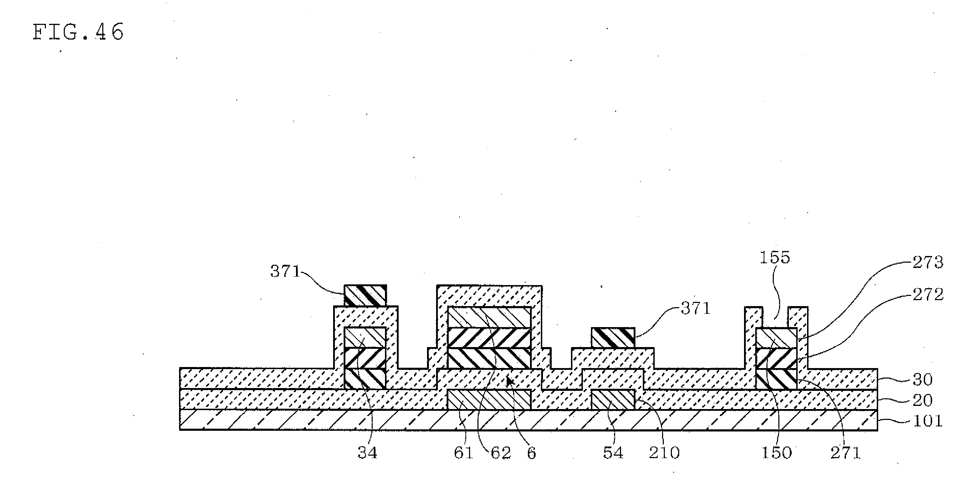

FIG. 46 is a schematic view for explaining a treatment by using the third half-tone mask in the method for producing a TFT substrate to be used in the dispersion-type inorganic EL display apparatus according to the third embodiment of the invention, showing a cross-sectional view after the fifth etching/after the peeling off the third resist.

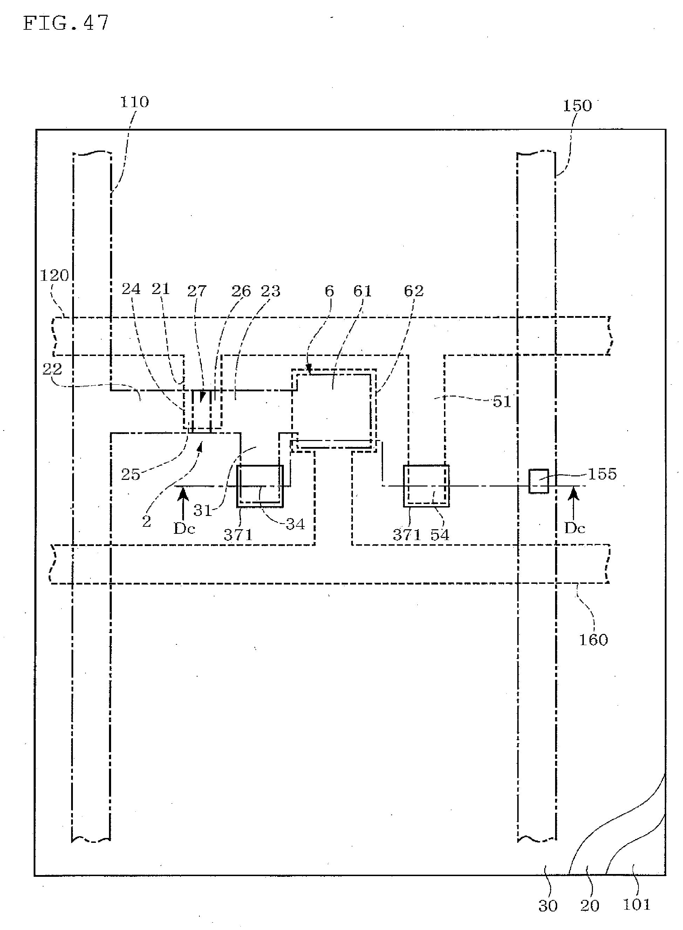

In FIG. 46, as the fifth etching, the n-type oxide semiconductor layer 371 is patterned with an etching method by using the reformed third resist 372 and an aqueous oxalic acid solution. As a result, the active layers of the driving transistor 3 and the measuring transistor 5, which are composed of the n-type oxide semiconductor layer 371, are formed. Subsequently, the third resist 372 is removed through an ashing process to expose the n-type oxide semiconductor layer 371. The gate electrode 34, the capacitor 6, the gate electrode 54, the n-type oxide semiconductor layer 371 and the contact hole 155 shown in FIG. 46 are cross-sectional views taken along line Dc-Dc in FIG. 47.
In addition, after the n-type oxide semiconductor layer 371 is formed, the TFT substrate 100c is heat-treated at a temperature of about 180°C or higher. By doing this, the active layer of the n-type oxide semiconductor layer 371 is crystallized.

Subsequently, as shown in FIG. 41, the oxide transparent conductor layer 374 as an oxide conductor layer, the metal layer 375 as an auxiliary conductor layer (auxiliary metal layer) and the fourth resist 376 are stacked. Subsequently, by using a fourth half-tone mask 377c, the EL-driving line 130, the pixel electrode 38, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 are formed (Step S6c).
Next, a treatment by using the fourth half-tone mask 377 is explained with reference to the drawing.

### (Treatment by using a fourth half-tone mask)

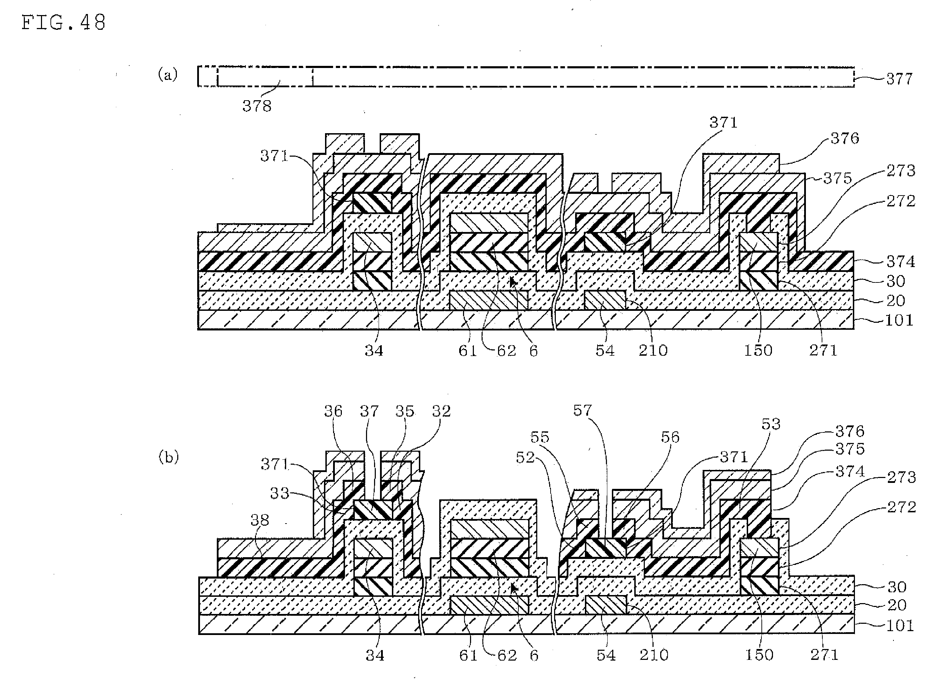

FIG. 48 is a schematic view for explaining a treatment by using the fourth half-tone mask in the method for producing a TFT substrate to be used in the dispersion-type inorganic EL display apparatus according to the third embodiment of the invention, in which (a) is a cross-sectional view after the formation of the oxide transparent conductor layer/after the formation of the metal layer/after the application of the fourth resist/after half-tone exposure/after development; and (b) is a cross-sectional view after the sixth etching/after the reformation of the fourth resist. In FIG. 48, for convenience of understanding, the EL-driving line 130 is omitted.
In FIG. 48(a), on the gate insulating film 30 and the n-type oxide semiconductor layer 371, which are exposed, an oxide transparent conductor layer 374 is formed in a film thickness of about 120 nm by using an indium oxide-tin oxide-zinc oxide (In₂O₃:SnO₂:ZnO=about 60:20:20 wt%) target by the high-frequency sputtering method. This layer formation is conducted under the condition of an oxygen-to-argon ratio of about 1:99 (vol%) and a substrate temperature which does not cause the oxide transparent conductor layer 374 to be crystallized.

Then, the metal layer 375 is formed. This metal layer 375 is an auxiliary conductor layer and is composed of an Mo layer/an Al layer/an Mo layer. Specifically, Mo, Al and Mo are stacked in this order by using the high-frequency sputtering method in a thickness of about 50 nm, about 250 nm and about 50 nm, respectively.
Subsequently, the fourth resist 376 is applied on the metal layer 375, and the fourth resist 376 is formed into a predetermined shape by half-tone exposure by using a fourth half-tone mask 377c. That is, the fourth resist 376 is formed into such a shape that it covers the EL-driving line 130, the pixel electrode 38, the source line 32, the source electrode 35, the drain electrode 36 and the drain line 33 of the driving transistor 3, as well as the source line 52, the source electrode 55, the drain electrode 56 and the drain line 53 of the measuring transistor 5. In addition, by using a half-tone mask part 378, the fourth resist 376 is formed into such a shape that the part thereof covering the pixel electrode 38 is thinner than other parts.

Then, as shown in FIG. 48(b), as the sixth etching, the metal layer 375 is patterned with an etching method by using the fourth resist 376 and an acid mixture etching solution. Subsequently, the oxide transparent conductor layer 374 is patterned with an etching method by using the fourth resist 376 and an aqueous oxalic acid solution. As a result, the EL-driving line 130, the pixel electrode 38, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 are formed (Step S6c).

Subsequently, the fourth resist 376 is removed through an ashing process, whereby the fourth resist 376 is reformed. When the fourth resist 376 is reformed, the metal layer 375 above the pixel electrode 38 is exposed, and the EL-driving line 130, the source line 32, the source electrode 35, the drain electrode 36 and the drain line 33 of the driving transistor 3, as well as the source line 52, the source electrode 55, the drain electrode 56 and the drain line 53 of the measuring transistor 5 are covered by the reformed fourth resist 376.

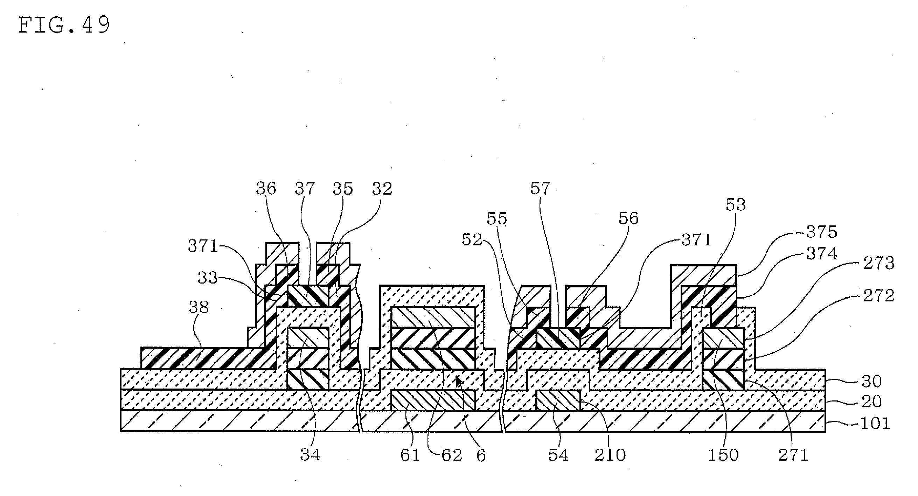

FIG. 49 is a schematic view for explaining a treatment by using the fourth half-tone mask in the method for producing a TFT substrate to be used in the dispersion-type inorganic EL display apparatus according to the third embodiment of the invention, showing a cross-sectional view after the seventh etching/after the peeling off the fourth resist.
In FIG. 49, as the seventh etching, the metal layer 375 is patterned with an etching method by using the reformed fourth resist 376 and an acid mixture etching solution to expose the pixel electrode 38.

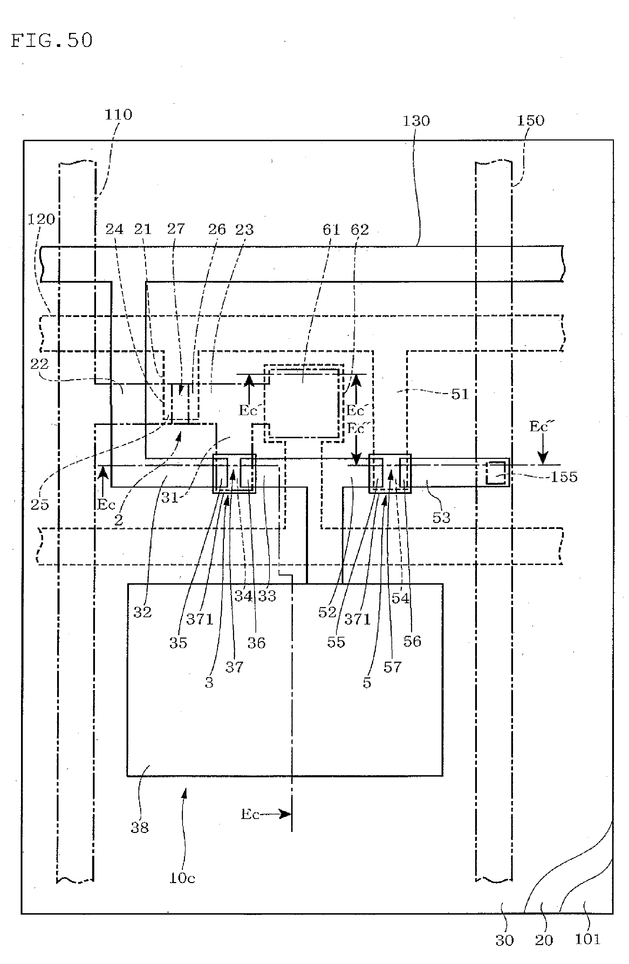

Then, the reformed fourth resist 376 is removed through an ashing process. As shown in FIG. 49, the EL-driving line 130, the pixel electrode 38, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 are exposed on the gate insulating film 30. The EL-driving line 130, the capacitor 6, the pixel electrode 38, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 shown in FIG. 49 are cross-sectional views .taken along lines Ec-Ec, Ec'-Ec' and Ec"-Ec" in FIG. 50.
In the meantime, the drain line 53 of the measuring transistor 5 is connected with the measuring line 150 through the contact hole 155.

Subsequently, as shown in FIG. 41, the protective insulating film 40 and the fifth resist 41 are stacked, and by using a fifth mask 42c, the pad for a scanning line 124, the pad for a data line 114, the pad for an EL-driving line 134, the pad for a measuring line 154, the pad for a capacitor line 164 and the pixel electrode 38 are exposed (Step S7c).
Next, a treatment by using the fifth mask 42c is explained with reference to the drawing.

### (Treatment by using a fifth mask)

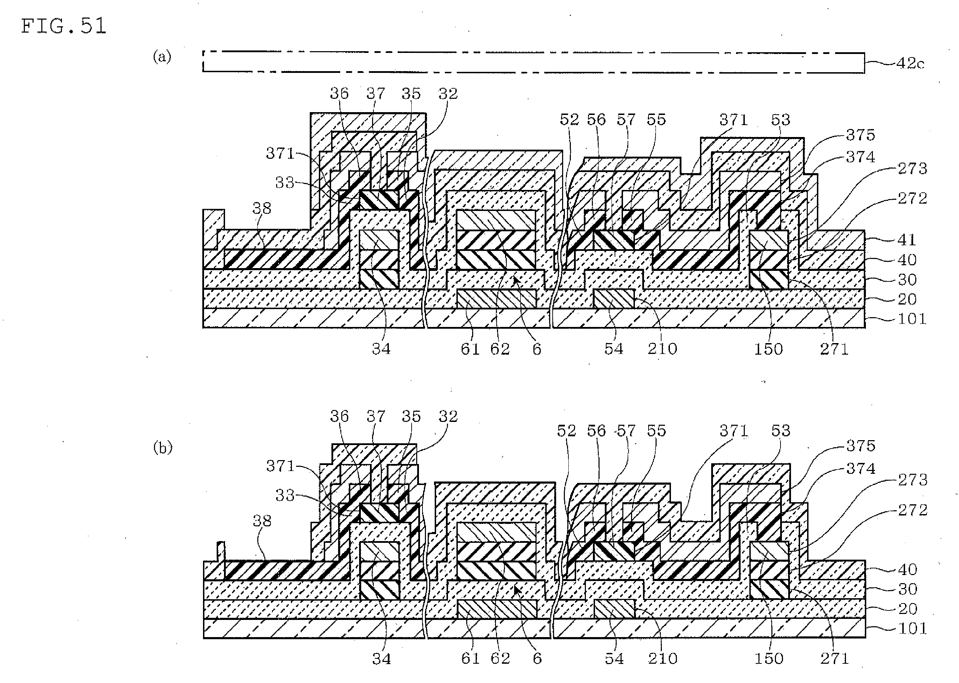

FIG. 51 is a schematic view for explaining a treatment by using the fifth mask in the method for producing a TFT substrate to be used in the dispersion-type inorganic EL display apparatus according to the third embodiment of the invention, in which (a) is a cross-sectional view after the formation of the protective insulating film/after the application of the fifth resist/after exposure/after development; and (b) is a cross-sectional view after the eighth etching/after the peeling off the fifth resist.
In FIG. 51(a), the protective insulating film 40 is stacked in a film thickness of about 250 nm by the glow discharge CVD (Chemical Vapor Deposition) method above the glass substrate 101. This protective insulating film 40 is a silicon nitride (SiNₓ) film and has a thickness of about 250 nm. In this embodiment, an SiH₄-NH₃-N₂-based mixed gas is used as a discharge gas.

Then, the fifth resist 41 is applied on the protective insulating film 40. Subsequently, by using the fifth mask 42c and exposure technology, the fifth resist 41 having openings above the pixel electrode 38, the pad for a data line 114, the pad for a scanning line 124, the pad for a measuring line 154, the pad for a capacitor line 164 and a pad for an EL-driving line 134 is formed. In FIG. 51, the pad for a data line 114, the pad for a scanning line 124, the pad for an EL-driving line 134, the pad for a capacitor line 164 and the pad for a measuring line 154 are omitted (see FIG. 12 for the pad for a data line 114, the pad for a scanning line 124 and the pad for an EL-driving line 134. The pad for a measuring line 154 is almost the same as the pad for a data line 114. Further, the pad for a capacitor line 164 is almost the same as the pad for a scanning line 124).
Subsequently, as the eighth etching, the protective insulating film 40, the gate insulating film 30 and the gate insulating film 20 are patterned with a dry etching method by using an etching gas (CHF (CF₄, CHF₃ gas, or the like)) to expose the pixel electrode 38, the pad for a data line 114, the pad for a scanning line 124, the pad for a measuring line 154, the pad for a capacitor line 164 and the pad for an EL-driving line 134 (Step S7c).

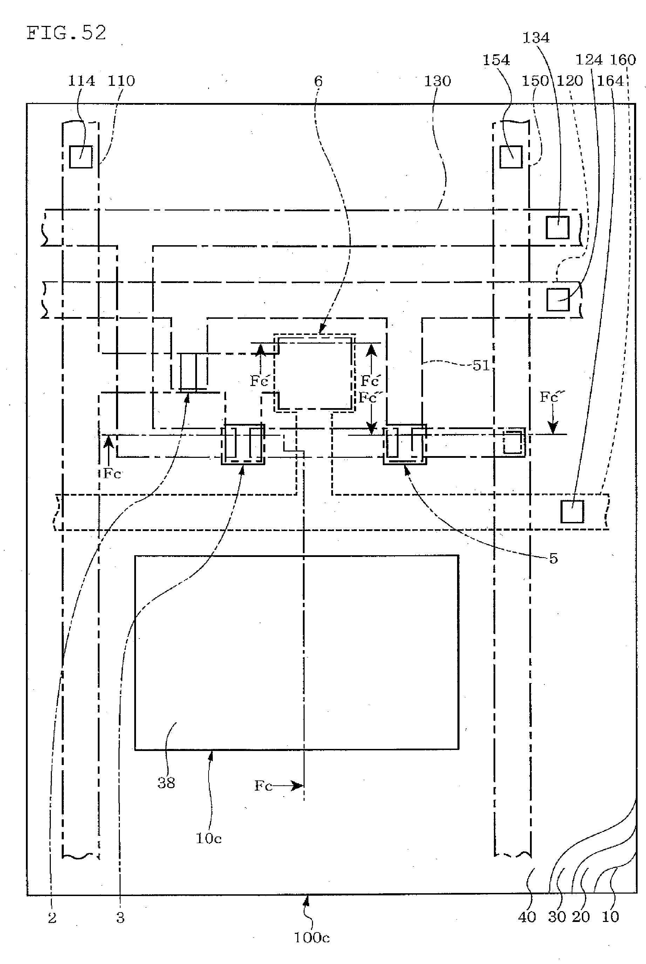

Subsequently, the reformed fifth resist 41 is removed through an ashing process. As a result, as shown in FIG. 51, the protective insulating film 40 is exposed. The EL-driving line 130, the capacitor 6, the pixel electrode 38, and the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 shown in FIG. 51 are cross-sectional views taken along line Fc-Fc, Fc'-Fc' and Fc"-Fc" in FIG. 52.
In the meantime, in this embodiment, the positions or the shapes of the switching transistor 2, the driving transistor 3, the capacitor 6, the measuring transistor 5 and the pixel electrode 38 are the positions or the shapes which are easy to understand. The positions or the shapes are, however, not limited thereto.

As mentioned above, according to the method for producing the TFT substrate for current control 100c of this embodiment, it is possible to supply driving current which is almost similar to the prescribed value measured by the current-measuring circuit 15 to the dispersion-type inorganic EL device 4c which is driven by alternating current. Accordingly, it is possible to provide an image of improved quality. In this embodiment, the active layers of the driving transistor 3 and the measuring transistor 5 are composed of the n-type oxide semiconductor layer 371. By doing this, the driving transistor 3 and the measuring transistor 5 suffer only a small degree of deterioration even though a large amount of current is flown or a large amount of power is input to the driving transistor 3 and the measuring transistor 5. Therefore, the TFT substrate 100c is improved in stability. Furthermore, the durability of the TFT substrate 100c can be improved. In addition, the EL-driving line 130, the pixel electrode 38, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 3 can be produced by using the fourth half-tone mask 377c. As a result, the number of masks used can be reduced. Therefore, production efficiency can be improved and manufacturing cost can be decreased due to the reduced production steps. In addition, the protective insulating film 40 is formed. Therefore, the dispersion-type inorganic EL display apparatus 1c can be obtained easily by providing dispersion-type inorganic EL materials, electrodes and protective films on the TFT substrate 100c.
Subsequently, the structure of the above-mentioned TFT substrate 100c is explained with reference to the drawing.

### [Third embodiment of a TFT substrate for current control]

As shown in FIG. 39, in the TFT substrate 100c of this embodiment, m (row; m is a natural number) × n (line; n is a natural number) pixels 10c are arranged in a matrix on the glass substrate 101.
Furthermore, in the direction of line (horizontal direction), n pieces of the scanning lines 121, 122,...123 are formed. For example, the nth scanning line 123 is connected in parallel with m pieces of the pixel 10c arranged in the nth line.
In addition, in the direction of line (horizontal direction), n pieces of the EL-driving lines 131a, 132a,...133a are formed. For example, the nth EL-driving line 133a is connected in parallel with m pieces of pixel 10c arranged in the nth line.
In addition, in the direction of line (horizontal direction), n pieces of the capacitor lines 160 are formed. For example, the nth capacitor line 160 is connected in parallel with m pieces of pixel 10c arranged in the nth line.
In addition, in the direction of row (vertical direction), m pieces of the data lines 111, 112,...113 are formed. For example, the mth data line 113 is connected in parallel with n pieces of pixel 10c arranged in the mth row.
Furthermore, in the direction of row (vertical direction), m pieces of the measuring lines 151, 152,...153 are formed. For example, the mth measuring line 153 is connected in parallel with n pieces of pixel 10c arranged in the mth row.

As shown in FIG. 52, each pixel 10c has the driving transistor 3, the switching transistor 2, the capacitor 6 and the measuring transistor 5.
The driving transistor 3 supplies electric current to the dispersion-type inorganic EL device 4c as an electro-optic device (see FIG. 40). The switching transistor 2 controls the driving transistor 3. The driving transistor 3 can be kept in the ON-state by the capacitor 6. By the measuring transistor 5, electric current supplied to the dispersion-type inorganic EL device 4c (see FIG. 40) can be measured.

As shown in FIGs. 43 and 44, the switching transistor 2 has the gate electrode 24, the gate insulating film 20, the α-Si:H(i) film 271, the α-Si:H(n) film 272, the source electrode 25 and the drain electrode 26.
The gate electrode 24 is connected with the scanning line 120 through the gate line 21. The gate insulating film 20 is formed on the gate electrode 24. The α-Si:H(i) film 271 and the α-Si:H(n) film 272, which are active layers, are formed on the gate insulating film 20. The source electrode 25 is connected with the data line 110 through the source line 22. The drain electrode 26 is connected with the gate electrode 34 of the driving transistor 3 through the drain line 23 and the gate line 31, and is connected with the first electrode 61 of the capacitor 6 through the drain line 23.

In the capacitor 6, the gate insulating film 20 as an insulating layer is stacked between the first electrode 61 and the second electrode 62. In the capacitor 6, direct voltage is applied from the data line 110 to the first electrode 61 through the switching transistor 2 in the ON-state. In addition, the second electrode 62 is connected with the capacitor line 160. Therefore, carriers corresponding to the direct voltage applied from the data line 110 are stored in the first electrode 61. As a result, if the switching transistor 2 turns to the OFF-state, the ON-state of the switching transistor 2 is maintained by the carriers stored in the first electrode 61. This ON-state is the same state as that when the direct voltage is applied from the data line 110.

As shown in FIGs. 49 and 50, the driving transistor 3 has the gate electrode 34, the gate insulating film 30, the n-type oxide semiconductor layer 371, the source electrode 35 and the drain electrode 36.
The gate insulating film 30 is formed on the gate electrode 34. The n-type oxide semiconductor layer 371 as an active layer is formed on the gate insulating film 30. The source electrode 35 is connected with the EL-driving line 130 through the source line 32. The drain electrode 36 is connected with the pixel electrode 38 through the drain line 33, and connected with the source electrode 55 of the measuring transistor 5 through the drain line 33 and the source line 52.

Furthermore, the source line 32, the source electrode 35, the drain electrode 36 and the drain line 33 of the driving transistor 3 is composed of the oxide transparent conductor layer 374. Furthermore, this oxide transparent conductor layer 374 functions as the pixel electrode 38 of the dispersion-type inorganic EL device 4c. Due to such a configuration, the number of masks used in the production can be reduced and production steps can be decreased. As a result, production efficiency can be improved and manufacturing cost can be decreased.

As shown in FIGs. 49 and 50, the measuring transistor 5 has the gate electrode 54, the gate insulating film 20, the gate insulating film 30, the n-type oxide semiconductor layer 371, the source electrode 55 and the drain electrode 56.

The gate electrode 54 is connected with the scanning line 120 through the gate line 51. The gate insulating film 20 and the gate insulating film 30 are formed on the gate electrode 54. The n-type oxide semiconductor layer 371 as an active layer is formed on the gate insulating film 30. The drain electrode 56 is connected with the measuring line 150 through the drain line 53, part of which is formed within the contact hole 155.

Furthermore, it is preferred that the metal layer 375 as an auxiliary conductor layer be formed above the EL-driving line 130, the source line 32, the source electrode 35, the drain electrode 36 and the drain line 33 of the driving transistor 3, as well as the source line 52, the source electrode 55, the drain electrode 56 and the drain line 53 of the measuring transistor 5. By doing this, the electric resistance of each line and each electrode can be decreased. As a result, reliability can be improved and a decrease in energy efficiency can be suppressed.

As mentioned above, the TFT substrate 100c of the invention can be used as an AC-driven electro-optic device such as the dispersion-type inorganic EL device 4c. Furthermore, the TFT substrate 100c can supply to the dispersion-type inorganic EL device 4c which is driven by alternating current driving current which is almost similar to the prescribed value measured by the current-measuring circuit 15. Therefore, an image of improved quality can be provided. Furthermore, the active layers of the driving transistor 3 and the measuring transistor 5 are composed of the n-type oxide semiconductor layers 371. Therefore, the driving transistor 3 suffers from only a small degree of deterioration even though a large amount of current is flown or a large amount of power is input to the driving transistor 3 and the measuring transistor 5. As a result, the TFT substrate 100c is improved in stability. Furthermore, the durability of the TFT substrate 100c can be improved.

The third embodiment of the dispersion-type inorganic EL display apparatus, the third embodiment of the method for producing the TFT substrate for current control and the third embodiment of the TFT substrate for current control have various application examples.
For example, in the third embodiment of the method for producing the TFT substrate for current control, the pad for a data line 114, the pad for a scanning line 124, the pad for an EL-driving line 134 and the pad for a measuring line 154 are formed below the gate insulating film 30. However, the position is not limited thereto. For example, the pad for a data line 114b, the pad for a scanning line 124b, the pad for an EL-driving line 134 and the pad for a measuring line 154b may be formed below the protective insulating film 40 and above the gate insulating film 30 (that is, nearer to the protective insulating film 40).
Next, an application example of the method for producing the TFT substrate for current control according to the third embodiment is explained with reference to the drawing.

### [Application example of the method for producing a TFT substrate for current control]

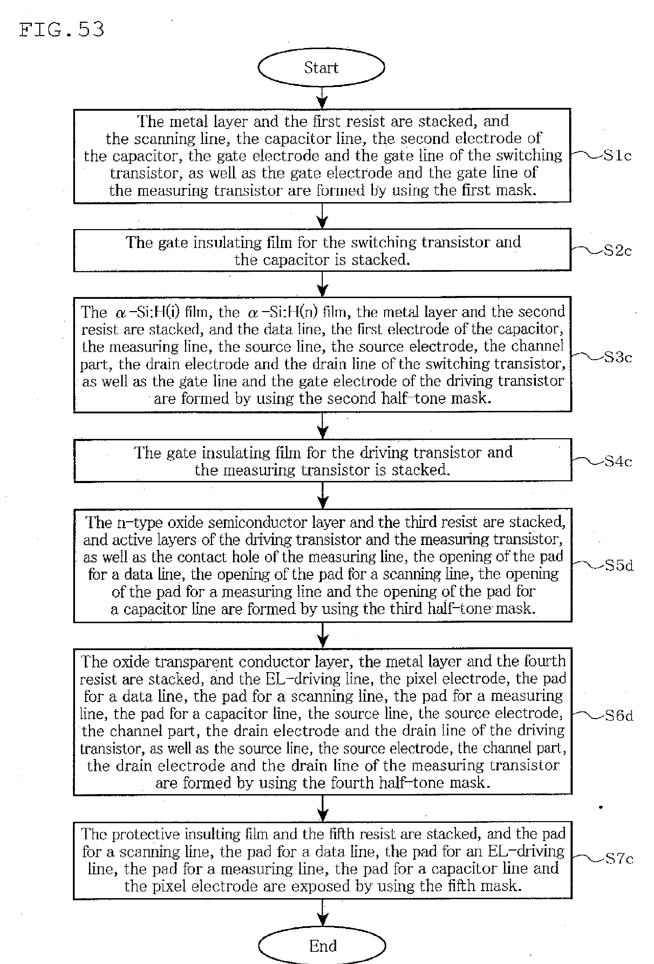

FIG. 53 is a schematic flow chart for explaining the method for producing a TFT substrate to be used in the dispersion-type inorganic EL display apparatus according to an application example of the third embodiment of the invention. In the meantime, the production method according to this application example corresponds to claim 20.
In FIG. 53, the method for producing the TFT substrate according to this application example differs from the above-mentioned method according to the third embodiment in the following points. Specifically, in addition to the above-mentioned step S5a (see FIG. 41), in the step S5d, an opening 114b' of the pad for a data line 114b, an opening 124b' of the pad for a scanning line 124b, an opening 154b' of the pad for a measuring line 154b and an opening 164d' of a pad for a capacitor line 164d are formed. Furthermore, in the step S6d, in addition to the above-mentioned step S6c, the pad for a data line 114b, the pad for a scanning line 124b, the pad for a measuring line 154b and the pad for a capacitor line 164d are formed. The method shown in FIG. 53 differs from the above-mentioned third embodiment in these points. Other steps are almost the same as those in the third embodiment.
Therefore, in FIG. 53, the same steps are indicated by the same numerals as used in FIG. 41, and detailed explanation is omitted.

In the step S5d, as shown in FIG. 53, the n-type oxide semiconductor layer 371 as an oxide semiconductor layer and the third resist 372 are stacked on the gate insulating film 30. Subsequently, by using a third half-tone mask 373d, the active layers of the driving transistor 3 and the measuring transistor 5, as well as the contact hole 155 of the measuring line 150, the opening 114b' of the pad for a data line 114b, the opening 124b' of the pad for a scanning line 124b, the opening 154' of the pad for a measuring line 154b and the opening 164d' of the pad for a capacitor line 164b are formed.
Next, a treatment by using the third half-tone mask 373d in the step S5d is explained with reference to the drawing.

### (Treatment by using a third half-tone mask)

FIG. 54 is a schematic view for explaining a treatment by using the third half-tone mask in the method for producing a TFT substrate to be used in the dispersion-type inorganic EL display apparatus according to the application example of the third embodiment of the invention, in which (a) is a cross-sectional view after the formation of the gate insulating film/after the formation of the n-type oxide semiconductor layer/afterthe application of the third resist/after half-tone exposure/after development; and (b) is a cross-sectional view after the fourth etching/after the reformation of the third resist.
In the meantime, the method for forming the active layers of the driving transistor 3 and the measuring transistor 5 in the step S5d is almost similar to those in the step S5a in the second embodiment (see FIGs. 45 and 46). Therefore, in FIG. 54, the opening 114b' for the pad for a data line 114b, the opening 124b' for the pad for a scanning line 124b, the opening 154b' for the pad for a measuring line 154b and an opening 164d' for a pad for a capacitor line 164d are shown.
In FIG. 54, the n-type oxide semiconductor layer 371 is formed on the gate insulating film 30. Subsequently, the third resist 372 is applied on the n-type oxide semiconductor layer 371. Then, the third resist 372 is formed into a predetermined shape by using the third half-tone mask 373d and by half-tone exposure technology. That is, the third resist 372 is formed into such a shape that it covers the upper part of the glass substrate 101, except for the part above the contact hole 155, the opening 114b' for the pad for a data line 114b, the opening 124b' for the pad for a scanning line 124b, the opening 154b' for the pad for a measuring line 154b and an opening 164d' for the pad for a capacitor line 164d. In addition, by using the half-tone mask part 3731, the third resist 372 is formed into such a shape that the part thereof covering the gate electrode 34 and the gate electrode 54 is thicker than other parts.

Subsequently, as shown in FIG. 54 (b) as the fourth etching, the n-type oxide semiconductor layer 371 is patterned with an etching method by using the third resist 372 and an aqueous oxalic acid solution. Subsequently, the gate insulating film 30 is patterned with a dry etching method by using the third resist 372 an etching gas (CHF (CF₄, CHF₃ gas, or the like)), whereby the contact hole 155, the opening 114b' of the pad for a data line 114b, the opening 124b' of the pad for a scanning line 124b, the opening 154b' of the pad for a measuring line 154b and the opening 164d' of the pad for a capacitor line 164d are formed.
Subsequently, the third resist 372 is removed through an ashing process, and the third resist 372 is reformed into such a shape that the gate electrode 34 and the gate electrode 54 are covered.

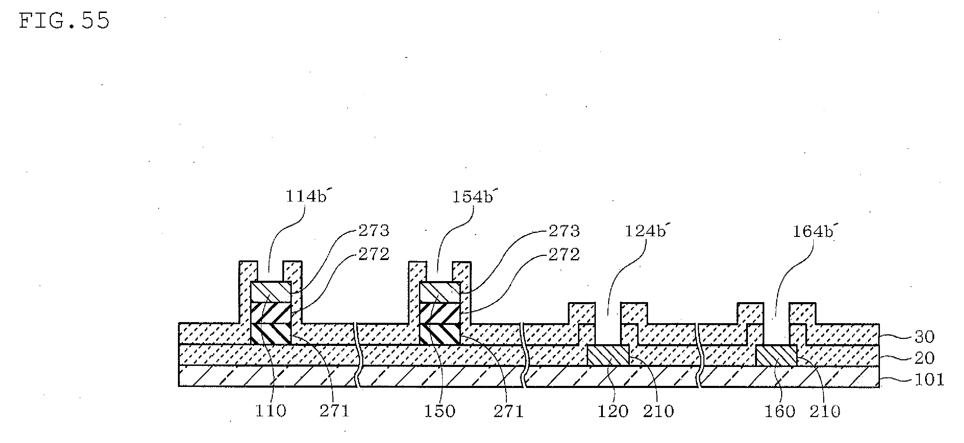

FIG. 55 is a schematic view for explaining a treatment by using the third half-tone mask in the method for producing a TFT substrate to be used in the dispersion-type inorganic EL display apparatus according to the application example of the third embodiment of the invention, showing a cross-sectional view after the fifth etching/after the peeling off the third resist.

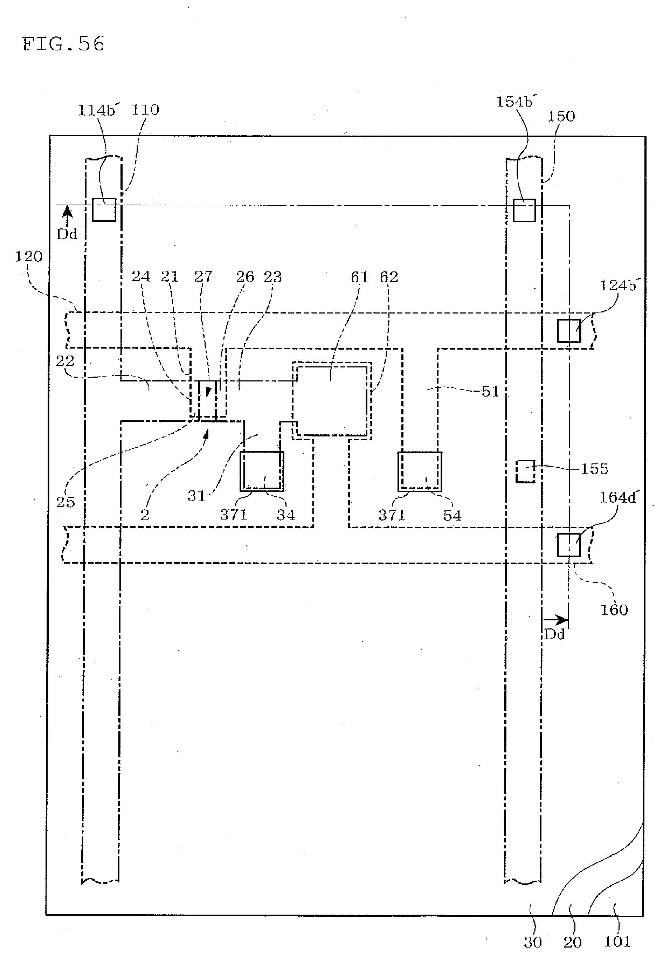

In FIG. 55, as the fifth etching, the n-type oxide semiconductor layer 371 is patterned with an etching method by using the reformed third resist 372 and an aqueous oxalic acid solution. As a result, the active layers of the driving transistor 3 and the measuring transistor 5 which are composed of the n-type oxide semiconductor layer 371 are formed, and the gate insulating film 30 is exposed. Subsequently, the third resist 372 is removed through an ashing process to expose the n-type oxide semiconductor layer 371. The opening 114b' of the pad for a data line 114b, the opening 154b' of the pad for a measuring pad 154b, the opening 124b' of the pad for a scanning line 124b and the opening 164d' for the pad for a capacitor line 164d shown in FIG. 55 are cross-sectional views taken along line Dd-Dd in FIG. 56.

Subsequently, as shown in FIG. 53, the oxide transparent conductor layer 374, the metal layer 375 and the fourth resist 376 are stacked. Subsequently, by using the fourth half-tone mask 377, the EL-driving line 130, the pixel electrode 38, the pad for a data line 114b, the pad for a scanning line 124b, the pad for a measuring line 154b, the pad for a capacitor line 164d, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 are formed (Step S6d).
Next, a treatment by using the fourth half-tone mask 377 is explained with reference to the drawing.

### (Treatment by using a fourth half-tone mask)

FIG. 57 is a schematic view for explaining a treatment by using the fourth half-tone mask in the method for producing a TFT substrate to be used in the dispersion-type inorganic EL display apparatus according to the application example of the third embodiment of the invention, in which (a) is a cross-sectional view after the formation of the oxide transparent conductor layer/after the formation of the metal layer/after the application of the fourth resist/after half-tone exposure/after development; and (b) is a cross-sectional view after the sixth etching/after the reformation of the fourth resist/after the seventh etching/after the peeling off the fourth resist.
In the meantime, the methods for producing the driving transistor 3 and the measuring transistor 5 in the step S6d are almost similar to those in the step S6c in the third embodiment (see FIGs. 48 and 49). Therefore, in FIG. 57, the opening 114b' of the pad for a data line 114b, the opening 124b' of the pad for a scanning line 124b, the opening 154b' of the pad for a measuring line 154b and the opening 164d' of the pad for a capacitor line 164d are shown.
In FIG. 57 (a), on the gate insulating film 30 and the n-type oxide semiconductor layer 371, which are exposed, an oxide transparent conductor layer 374 is formed into a film thickness of about 120 nm by using an indium oxide-tin oxide-zinc oxide (In₂O₃:SnO₂:ZnO=about 60:20:20 wt%) target by the high-frequency sputtering method. This layer formation is conducted under the condition of an oxygen-to-argon ratio of about 1:99 (vol%) and a substrate temperature which does not cause the oxide transparent conductor layer 374 to be crystallized.

Then, the metal layer 375 is formed. This metal layer 375 is an auxiliary conductor layer and is composed of an Mo layer/an Al layer/an Mo layer. Specifically, Mo, Al and Mo are stacked in this order by using the high-frequency sputtering method in a thickness of about 50 nm, about 250 nm and about 50 nm, respectively.
Subsequently, the fourth resist 376 is applied on the metal layer 375, and the fourth resist 376 is formed into a predetermined shape by half-tone exposure by using the fourth half-tone mask 377. That is, the fourth resist 376 is formed into such a shape that it covers the EL-driving line 130, the pixel electrode 38, the pad for a data line 114b, the pad for a scanning line 124b, the pad for a measuring line 154b, the pad for a capacitor line 164d, the source line 32, the source electrode 35, the drain electrode 36 and the drain line 33 of the driving transistor 3, as well as the source line 52, the source electrode 55, the drain electrode 56 and the drain line 53 of the measuring transistor 5. In addition, by using a half-tone mask part 378, the fourth resist 376 is formed into such a shape that the part thereof covering the pixel electrode 38 is thinner than other parts.

Then, as shown in FIG. 57(b), as the sixth etching, the metal layer 375 is patterned with an etching method by using the fourth resist 376 and an acid mixture etching solution. Subsequently, the oxide transparent conductor layer 374 is patterned with an etching method by using the fourth resist 376 and an aqueous oxalic acid solution. As a result, the EL-driving line 130, the pixel electrode 38, the pad for a data line 114b, the pad for a scanning line 124b, the pad for a measuring line 154b, the pad for a capacitor line 164d, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 are formed (Step S6d).

In the meantime, as mentioned above, in the step S6b, the fourth resist 376 is removed through an ashing process, whereby the fourth resist 376 is reformed. When the fourth resist 376 is reformed, the metal layer 375 above the pixel electrode 38 is exposed, and the EL-driving line 130, the pad for a data line 114b, the pad for a scanning line 124b, the pad for a measuring line 154b, the pad for a capacitor line 164d, the source line 32, the source electrode 35, the drain electrode 36 and the drain line 33 of the driving transistor 3, as well as the source line 52, the source electrode 55, the drain electrode 56 and the drain line 53 of the measuring transistor 5 are covered by the reformed fourth resist 376.
Then, as the seventh etching, the metal layer 375 is patterned with an etching method by using the reformed fourth resist 376 and an acid mixture etching solution to expose the pixel electrode 38.

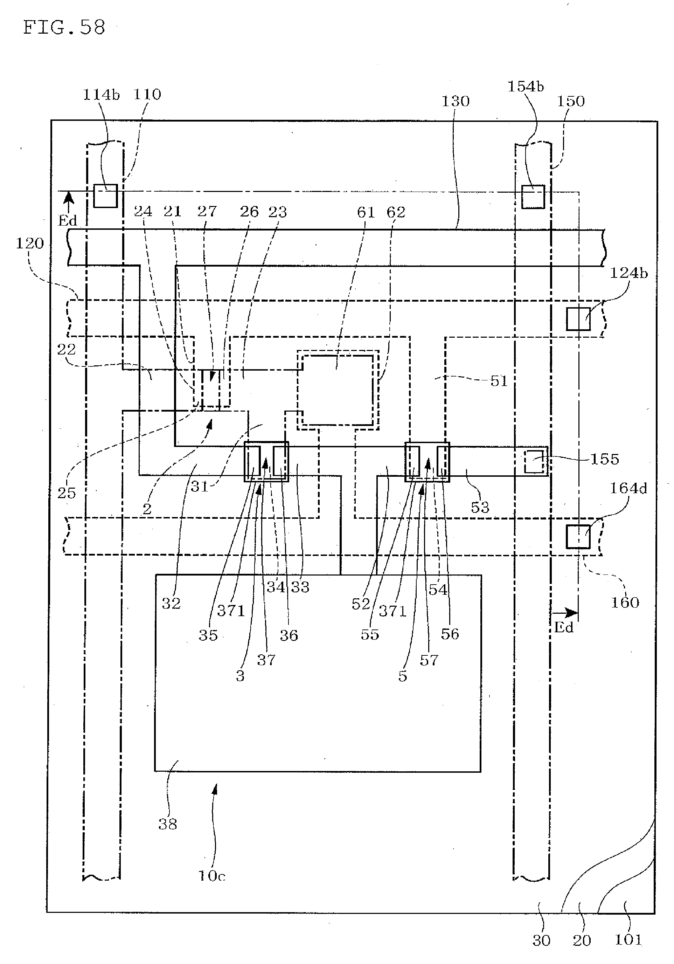

Then, the reformed fourth resist 376 is removed through an ashing process. As shown in FIG. 57, the EL-driving line 130, the pad for a data line 114b, the pad for a scanning line 124b, the pad for a measuring line 154b, the pad for a capacitor line 164d, the pixel electrode 38, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 are exposed on the gate insulating film 30. The EL-driving line 130, the pad for a data line 114b, the pad for a scanning line 124b, the pad for a measuring line 154b, the pad for a capacitor line 164d, the pixel electrode 38, the source line 32, the source electrode 35, the channel part 37, the drain electrode 36 and the drain line 33 of the driving transistor 3, as well as the source line 52, the source electrode 55, the channel part 57, the drain electrode 56 and the drain line 53 of the measuring transistor 5 shown in FIG. 57 are cross-sectional views taken along line Ed-Ed in FIG. 58.

### (Treatment by using a fifth mask)

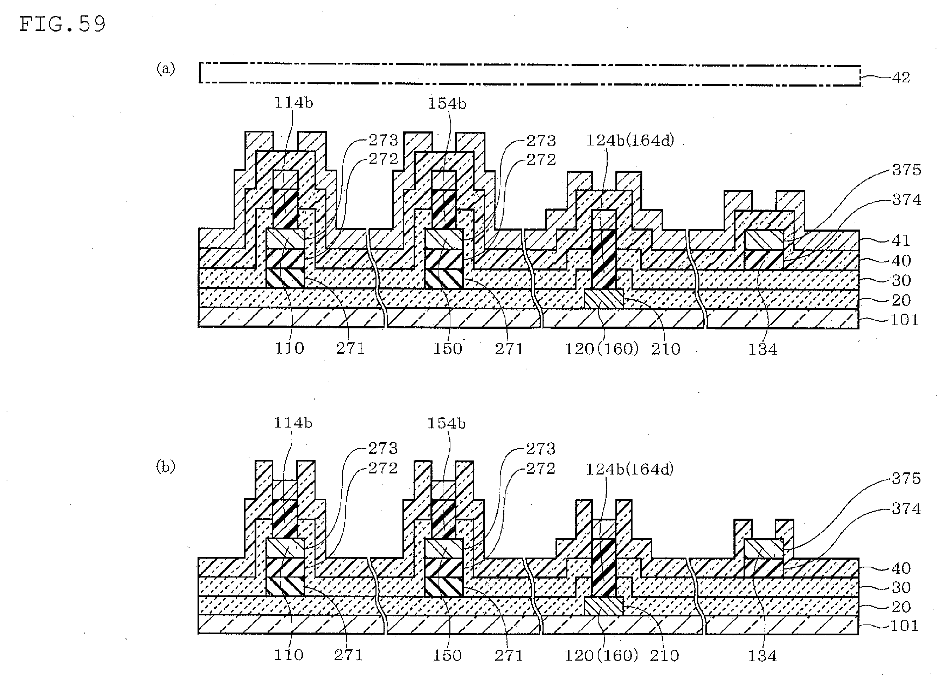

FIG. 59 is a schematic view for explaining a treatment by using the fifth mask in the method for producing a TFT substrate to be used in the dispersion-type inorganic EL display apparatus according to the application example of the third embodiment of the invention, in which (a) is a cross-sectional view after the formation of the protective insulating film/after the application of the fifth resist/after exposure/after development; and'(b) is a cross-sectional view after the eighth etching/after the peeling off the fifth resist.
In FIG. 59(a), the protective insulting film 40 is stacked above the glass substrate 101 by the glow discharge CVD (Chemical Vapor Deposition) method. This protective insulting film 40 is a silicon nitride (SiNₓ) film and has a thickness of about 250 nm. In this embodiment, an SiH₄-NH₃-N₂-based mixed gas is used as a discharge gas.

Then, the fifth resist 41 is applied on the protective insulating film 40. Subsequently, the fifth resist 41 is formed by using the fifth mask 42 and by the half-tone exposure technology. The fifth resist 41 has openings above the pixel electrode 38, the pad for a data line 114b, the pad for a scanning line 124b and the pad for a measuring line 154b, the pad for a capacitor line 164d and the pad for an EL-driving line 134. In the meantime, the pad for a data line 114b, the pad for a scanning line 124b, the pad for an EL-driving line 134, the pad for a capacitor line 164d, and the pad for a measuring line 154b are shown in FIG. 59 (for other structure, see FIG. 51).
Subsequently, as the eighth etching, dry etching is conducted by using an etching gas (CHF (CF₄, CHF₃ gas, or the like)). By doing this, the protective insulating film 40, the gate insulating film 30 and the gate insulating film 20 are patterned with an etching method to expose the pixel electrode 38, the pad for a data line 114b, the pad for a scanning line 124b, the pad for a measuring line 154b, the pad for a capacitor line 164d and the pad for an EL-driving line 134 (Step S7c).

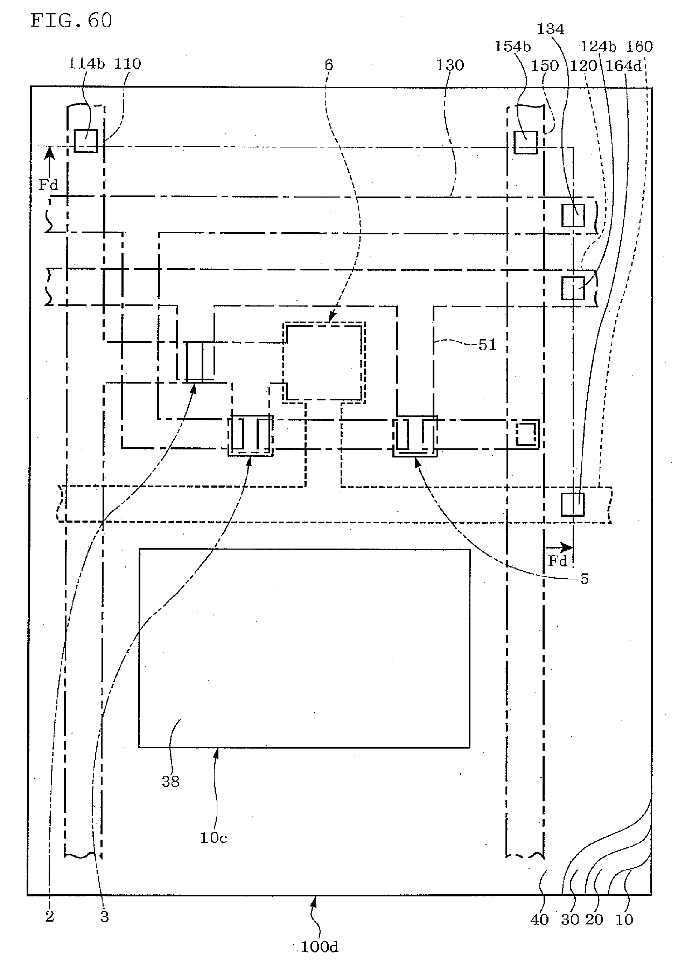

Subsequently, the reformed fifth resist 41 is removed through an ashing process. As a result, as shown in FIG. 59, the protective insulating film 40 is exposed. The pad for a data line 114b, the pad for a scanning line 124b, the pad for a measuring line 154b, the pad for a capacitor line 164d and a pad for an EL-driving line 134 in FIG. 59 (b) are cross-sectional views taken along line Fd-Fd in FIG. 60.

As mentioned above, according to the method for producing the TFT substrate for current control 100d of this application example, the advantageous effects almost similar to those attained by the production method in the third embodiment can be attained. In addition, the pad for a data line 114b, the pad for a scanning line 124b, the pad for a measuring line 154b, the pad for a capacitor line 164d and the pad for an EL-driving line 134 are formed immediately below the protective insulating film 40. As a result, connectability to the pad for a data line 114b, the pad for a scanning line 124b, the pad for a measuring line 154b, the pad for a capacitor line 164d and the pad for an EL-driving line 134 can be improved.

Hereinabove, the electro-optic apparatus, as well as the TFT substrate for current control and the method for producing thereof of the invention are explained with reference to the preferred embodiments. However, the electro-optic apparatus, as well as the TFT substrate for current control and the method for producing thereof of the invention are not limited to the embodiments mentioned above, and it is needless to say that various modifications are possible within the scope of the invention.
For example, as the application example of the method for the TFT substrate 100 according to the first embodiment, an application example is explained in which an n-type oxide semiconductor layer is used as an active layer of the switching transistor 2. This application can be applied to the method for producing the TFT substrate according to the second embodiment and the third embodiment, as well as to the method for a TFT substrate according to the application examples of these embodiments.
In addition, the TFT substrate 100c according to the third embodiment has a configuration corresponding to the dispersion-type inorganic EL device 4c. The configuration of the TFT substrate 100c is not limited thereto. For example, a single TFT substrate can drive DC-driven and At-driven electro-optic devices provided in a mixed form on this TFT substrate, and as a result, diversified variations (application technologies) can be realized.
Furthermore, the circuit configuration of the electro-optic apparatuses according the second embodiment and the third embodiment (the organic EL display apparatus 1, the dispersion-type inorganic EL display apparatus 1c) is not limited to the above-mentioned configuration. For example, a configuration in which an additional circuit (a spare capacitor, a transistor or the like) is provided may be used.

### INDUSTRIAL APPLICABILITY

The electro-optic apparatus, as well as the TFT substrate for current control and the method for producing the same according to the invention are not limited to an electro-optic apparatus and a TFT substrate using a liquid crystal device, an organic EL device, an inorganic EL device or the like and the method for producing the same. For example, the invention can be applied to display apparatus using other substances than liquid crystals or organic EL material, or a TFT substrate and the method for producing a TFT substrate to be used for other applications.

## Claims

1. A TFT substrate for current control comprising a driving transistor which supplies electric current to an electro-optic device and a switching transistor which controls the driving transistor, wherein an active layer of the driving transistor is composed of an oxide semiconductor layer.

2. The TFT substrate for current control according to claim 1, wherein an active layer of the switching transistor is composed of an oxide semiconductor layer.

3. The TFT substrate for current control according to claim 1 or 2, wherein the driving transistor comprises at least one of a source line, a drain line, a source electrode and a drain electrode, at least one of the source line, the drain line, the source electrode and the drain electrode is composed of an oxide conductor layer, and the oxide conductor layer functions as a pixel electrode of the electro-optic device.

4. The TFT substrate for current control according to any one of claims 1 to 3, wherein the switching transistor comprises at least one of a source line, a drain line, a source electrode and a drain electrode, and at least one of the source line, the drain line, the source electrode and the drain electrode is composed of an oxide conductor layer.

5. The TFT substrate for current control according to any one of claims 1 to 4, wherein the TFT substrate for current control comprises at least one of a gate line, a source line, a drain line, a gate electrode, a source electrode, a drain electrode and a pixel electrode, and an auxiliary conductor layer is formed above at least one of the gate line, the source line, the drain line, the gate electrode, the source electrode, the drain electrode and the pixel electrode.

6. An electro-optic apparatus comprising an electro-optic device driven by electric current and a TFT substrate for current control on which at least a driving transistor which supplies electric current to the electro-optic device and a switching transistor which controls the driving transistor are formed, wherein the TFT substrate for current control is the TFT substrate for current control according to any one of claims 1 to 5.

7. An electro-optic apparatus comprising an electro-optic device driven by electric current, a driving transistor for supplying electric current to the electro-optic device, a switching transistor which controls the driving transistor, a capacitor for applying a capacitor voltage to a gate electrode of the driving transistor, and a measuring transistor for measuring electric current supplied to the electro-optical device, wherein
a gate line of the switching transistor is connected with a scanning line for controlling the switching transistor, a source line of the switching transistor is connected with a data line for controlling electric current supplied to the electro-optic device, and a drain line of the switching transistor is connected in parallel with a gate line of the driving transistor and a first electrode of the capacitor,
a source line of the driving transistor is connected with a driving line for supplying electric current to the electro-optic device, a drain line of the driving transistor is connected in parallel with the electro-optic device, a second electrode of the capacitor and a source line of the measuring transistor, and
a gate line of the measuring transistor is connected with the scanning line, and a drain line of the measuring transistor is connected with a measuring line for measuring electric current supplied to the electro-optic device.

8. The electro-optic apparatus according to claim 7, wherein the electro-optic device is a DC-driven electro-optic device.

9. The electro-optic apparatus according to claim 8, wherein the DC-driven electro-optic device is an organic EL device and/or a DC-driven inorganic EL device.

10. An electro-optic apparatus comprising an electro-optic device driven by electric current, a driving transistor which supplies electric current to the electro-optic device, a switching transistor which controls the driving transistor, a capacitor for applying a capacitor voltage to a gate electrode of the driving transistor, and a measuring transistor which measures electric current supplied to the electro-optic device, wherein
a gate line of the switching transistor is connected with a scanning line for controlling the switching transistor, a source line of the switching transistor is connected with a data line for controlling electric current supplied to the electro-optic device, and a drain line of the switching transistor is connected in parallel with a gate line of the driving transistor and a first electrode of the capacitor,
a source line of the driving transistor is connected with a driving line for supplying electric current to the electro-optic device, a drain line of the driving transistor is connected in parallel with the electro-optic device and a source line of the measuring transistor, and
a second electrode of the capacitor is connected with a capacitor line for releasing stored carriers, and
a gate line of the measuring transistor is connected with the scanning line and a drain line of the measuring transistor is connected with a measuring line for measuring electric current supplied to the electro-optic device.

11. The electro-optic apparatus according to claim 10, wherein the electro-optic device is a DC-driven electro-optic device and/or an AC-driven electro-optic device.

12. The electro-optic apparatus according to claim 11, wherein the DC-driven electro-optic device and/or the AC-driven electro-optic device is a DC-driven inorganic EL device, an organic EL device and/or an AC-driven inorganic EL device.

13. The electro-optic apparatus according to any one of claims 7 to 12, wherein a pixel composed of the electro-optic device, the driving transistor, the switching transistor, the capacitor and the measuring transistor is provided on a TFT substrate for current control.

14. The electro-optic apparatus according to claim 13, wherein the TFT substrate for current control is the TFT substrate for current control according to any one of claims 1 to 5.

15. The electro-optic apparatus according to any one of claims 7 to 14, which comprises a scanning line-driving circuit, a data line-driving circuit, a power supply line-controlling circuit and a current measuring circuit for activating a TFT substrate for current control, wherein the current-measuring circuit measures electric current supplied to the electro-optic device, and at least one of the data line-driving circuit, the scanning line-driving circuit and the power supply line-controlling circuit is controlled based on the measured electric value.

16. A method for producing a TFT substrate for current control comprising the steps of:
stacking, above a substrate, a conductor layer and a first resist, and forming a scanning line, a gate electrode and a gate line of a switching transistor by using a first mask;
stacking a gate insulating film for the switching resistor;
stacking an active layer containing amorphous Si (silicon) or polycrystalline Si, or an oxide semiconductor layer, a conductor layer and a second resist, and forming a data line, a source line, a source electrode, a channel part, a drain electrode and a drain line of the switching transistor, as well as a gate line and a gate electrode of a driving transistor by using a second half-tone mask;
stacking a gate insulating film for the driving transistor;
stacking an oxide semiconductor layer and a third resist, and forming an active layer of the driving transistor by using a third mask;
stacking an oxide conductor layer and a fourth resist, and forming an EL-driving line, a source line, a source electrode, a channel part, a drain electrode and a drain line of the driving transistor, as well as a pixel electrode by using a fourth mask or a fourth half-tone mask; and
stacking a protective insulating film and a fifth resist, and exposing a pad for a scanning line, a pad for a data line, a pad for an EL-driving line and the pixel electrode by using a fifth mask.

17. A method for producing a TFT substrate for current control comprising the steps of:
stacking, above a substrate, a conductor layer and a first resist, and forming a scanning line, a gate electrode and a gate line of a switching transistor, as well as a gate electrode and a gate line of a measuring transistor by using a first mask;
stacking a gate insulating film for the switching transistor;
stacking an active layer containing amorphous Si (silicon) or polycrystalline Si, or an oxide semiconductor layer, a conductor layer and a second resist, and forming a data line, a first electrode of a capacitor, a measuring line, a source line, a source electrode, a channel part, a drain electrode and a drain line of the switching transistor, as well as a gate line and a gate electrode of a driving transistor by using a second half-tone mask;
stacking a gate insulating film for the driving transistor, the measuring transistor and the capacitor;
stacking an oxide semiconductor layer and a third resist, and forming active layers of the driving transistor and the measuring transistor, as well as a contact hole of the measuring line by using a third half-tone mask;
stacking an oxide semiconductor layer and a fourth resist, and forming an EL-driving line, a second electrode of the capacitor, a pixel electrode, a source line, a source electrode, a channel part, a drain electrode and a drain line of the driving transistor, as well as a source line, a source electrode, a channel part, a drain electrode and a drain line of the measuring transistor by using a fourth mask or a fourth half-tone mask; and
stacking a protective insulating film and a fifth resist, and exposing a pad for a scanning line, a pad for a data line, a pad for an EL-driving line, a pad for a measuring line and the pixel electrode by using a fifth mask.

18. A method for producing a TFT substrate for current control comprising the steps of:
stacking, above a substrate, a conductor layer and a first resist, and forming a scanning line, a gate electrode and a gate line of a switching transistor, as well as a gate electrode and a gate line of a measuring transistor by using a first mask;
stacking a gate insulating film for the switching transistor;
stacking an active layer containing amorphous Si (silicon) or polycrystalline Si, or an oxide semiconductor layer, a conductor layer and a second resist, and forming a data line, a first electrode of a capacitor, a measuring line, a source line, a source electrode, a channel part, a drain electrode and a drain line of the switching transistor, as well as a gate line and a gate electrode of the driving transistor by using a second half-tone mask;
stacking a gate insulating film for the driving transistor, the measuring transistor and the capacitor;
stacking an oxide semiconductor layer and a third resist, and forming active layers of the driving transistor and the measuring transistor, as well as a contact hole of the measuring line, an opening of a pad for a data line, an opening of a pad for a scanning line and an opening of a pad for a measuring line by using a third half-tone mask;
stacking an oxide conductor layer and a fourth resist, and forming an EL-driving line, a second electrode of the capacitor, a pixel electrode, a pad for a data line , a pad for a scanning line, a pad for a measuring line, a source line, a source electrode, a channel part, a drain electrode and a drain line of the driving transistor, as well as a source line, a source electrode, a channel part, a drain electrode and a drain line of the measuring transistor by using a fourth mask or a fourth half-tone mask; and
stacking a protective insulating film and a fifth resist, and exposing the pad for a scanning line, the pad for a data line, a pad for an EL-driving line, the pad for a measuring line and the pixel electrode by using a fifth mask.

19. A method for producing a TFT substrate for current control comprising the steps of:
stacking, above a substrate, a conductor layer and a first resist, and forming a scanning line, a capacitor line, a second electrode of a capacitor, a gate electrode and a gate line of a switching transistor, as well as a gate electrode and a gate line of a measuring transistor by using a first mask;
stacking a gate insulating film for the switching transistor and the capacitor;
stacking an active layer containing amorphous Si (silicon) or polycrystalline Si, or an oxide semiconductor layer, a conductor layer and a second resist, and forming a data line, a first electrode of the capacitor, a measuring line, a source line, a source electrode, a channel part, a drain electrode and a drain line of the switching transistor, as well as a gate line and a gate electrode of the driving transistor by using a second half-tone mask;
stacking a gate insulating film for the driving transistor and the measuring transistor;
stacking an oxide semiconductor layer and a third resist, and forming active layers of the driving transistor and the measuring transistor, as well as a contact hole of the measuring line by using a third half-tone mask;
stacking an oxide conductor layer and a fourth resist, and forming an EL-driving line, a pixel electrode, a source line, a source electrode, a channel part, a drain electrode and a drain line of the driving transistor, as well as a source line, a source electrode, a channel part and a drain electrode and a drain line of the measuring transistor by using a fourth mask or a fourth half-tone mask; and
stacking a protective insulating film and a fifth resist, and exposing a pad for a scanning line, a pad for a data line, a pad for an EL-driving line, a pad for a measuring line, a pad for a capacitor line and the pixel electrode by using a fifth mask.

20. A method for producing a TFT substrate for current control comprising the steps of:
stacking, above a substrate, a conductor layer and a first resist, and forming a scanning line, a capacitor line, a second electrode of a capacitor, a gate electrode and a gate line of a switching transistor, as well as a gate electrode and a gate line of a measuring transistor by using a first mask;
stacking a gate insulating film for the switching transistor and the capacitor;
stacking an active layer containing amorphous Si (silicon) or polycrystalline Si, or an oxide semiconductor layer, a conductor layer and a second resist, and forming a data line, a first electrode of the capacitor, a measuring line, a source line, a source electrode, a channel part, a drain electrode and a drain line of the switching transistor, as well as a gate line and a gate electrode of a driving transistor by using a second half-tone mask;
stacking a gate insulating film for the driving transistor and the measuring transistor;
stacking an oxide semiconductor layer and a third resist, and forming active layers for the driving transistor and the measuring transistor, as well as a contact hole of the measuring line, an opening of a pad for a data line, an opening of a pad for a scanning line, an opening of a pad for a measuring line and an opening of a pad for a capacitor line by using a third half-tone mask;
stacking an oxide conductor layer and a fourth resist, and forming an EL-driving line, a pixel electrode, the pad for a data line, the pad for a scanning line, the pad for a measuring line, the pad for a capacitor line, a source line, a source electrode, a channel part, a drain electrode and a drain line of the driving transistor, as well as a source line, a source electrode, a channel part, a drain electrode and a drain line of the measuring transistor by using a fourth mask or a fourth half-tone mask; and
stacking a protective insulating film and a fifth resist, and exposing the pad for a scanning line, the pad for a data line, a pad for an EL-driving line, the pad for a measuring line, the pad for a capacitor line and the pixel electrode by using a fifth mask.
